# EUROPEAN PATENT APPLICATION

(11) **EP 4 443 240 A2**
(43) Date of publication of application: **09.10.2024**
(21) Application number: 24165970.5
(22) Date of filing: 25.03.2024
(51) Int. Cl.: G03F 7/004, G03F 7/038

(54) **CHEMICALLY AMPLIFIED NEGATIVE RESIST COMPOSITION AND RESIST PATTERN FORMING PROCESS**

(30) Priority: 31.03.2023 JP 2023056966
(71) Applicant: Shin-Etsu Chemical Co., Ltd., Tokyo (JP)
(72) Inventor: FUKUSHIMA, Masahiro, Joetsu-shi (JP)
(74) Representative: Ter Meer Steinmeister & Partner

(57) **Abstract**

A chemically amplified negative resist composition is provided comprising (A) a quencher in the form of an onium salt having a conjugated acid anion which is decomposed into carbon dioxide and an organic compound having no more than 12 carbon atoms and (B) a base polymer containing a specific polymer which is decomposed under the action of acid to increase its solubility in alkaline developer. The resist composition exhibits a high resolution during pattern formation and forms a pattern with improved LER, fidelity and dose margin.

## Description

### TECHNICAL FIELD

This invention relates to a chemically amplified negative resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, while EB lithography is utilized as the ultra-fine microfabrication technique, it is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Resist compositions for photolithography include positive ones in which exposed areas are dissolved away and negative ones in which exposed areas are left as a pattern. A viable composition is selected among them depending on the desired resist pattern. In general, the chemically amplified negative resist composition comprises a polymer which is normally soluble in an aqueous alkaline developer, an acid generator which is decomposed to generate an acid upon exposure to light, and a crosslinker which causes the polymer to crosslink in the presence of the acid serving as a catalyst, thus rendering the polymer insoluble in the developer (sometimes, the crosslinker is incorporated in the polymer). Most often a quencher is added for controlling the diffusion of the acid generated upon light exposure.

Typical of the alkali-soluble units to constitute polymers which dissolve in aqueous alkaline developer are units derived from phenols. A number of negative resist compositions of such type were developed, especially as adapted for exposure to KrF excimer laser light. These compositions have not been used in the ArF excimer laser lithography because the phenolic units are not transmissive to exposure light having a wavelength of 150 to 220 nm. Recently, these compositions are recognized attractive again as the negative resist composition for the short wavelength (e.g., EB or EUV) lithography capable of forming finer size patterns. Exemplary compositions are described in Patent Documents 1 to 3.

Attempts were made to ameliorate resist sensitivity and pattern profile in a controlled way by properly selecting and combining components used in resist compositions and adjusting processing conditions. One outstanding problem is the diffusion of acid because acid diffusion has a significant impact on the resolution of a chemically amplified resist composition.

The quencher is, in fact, essential for controlling acid diffusion and improving resist performance, especially resolution. Studies have been made on the quencher while amines and weak acid onium salts have been generally used. The weak acid onium salts are exemplified in several patent documents. For example, Patent Document 4 describes that the addition of triphenylsulfonium acetate ensures to form a satisfactory resist pattern without T-top profile, a difference in line width between isolated and grouped patterns, and standing waves. Patent Document 5 describes the addition of ammonium salts of sulfonic acids or carboxylic acids for achieving improvements in sensitivity, resolution and exposure margin. Also, Patent Document 6 describes that a resist composition for KrF or EB lithography comprising a PAG capable of generating a fluorinated carboxylic acid is improved in resolution and process latitudes such as exposure margin and depth of focus. Patent Document 7 describes that a resist composition for F₂ lithography using F₂ laser comprising a PAG capable of generating a fluorinated carboxylic acid is improved in LER and overcomes the footing problem. These compositions are used in the KrF, EB and F₂ lithography processes.

Patent Document 8 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

Patent Document 9 describes to use a sulfonium salt of carboxylic acid containing a nitrogen-bearing heterocycle as a quencher. This sulfonium salt plays the role of a quencher for a fluorinated alkane sulfonic acid of addition type. No precise study has been made on this sulfonium salt as a quencher for use in negative resist compositions comprising polyhydroxystyrene as a base polymer used in the EB lithography process in the processing of mask blanks.

When patterns are formed using resist compositions comprising carboxylic acid onium salts or fluorocarboxylic acid onium salts as mentioned above, the levels of LER and resolution thus achieved are insufficient for the requirement of the recent technology where miniaturization is more advanced. It is desirable to have a quencher capable of reducing LER and improving resolution, pattern fidelity and dose margin.

### Citation List

Patent Document 1: JP-A 2006-201532
Patent Document 2: JP-A 2006-215180
Patent Document 3: JP-A 2008-249762
Patent Document 4: JP 3955384 (USP 6479210)
Patent Document 5: JP-A H11-327143
Patent Document 6: JP 4231622 (USP 6485883)
Patent Document 7: JP 4116340 (USP 7214467)
Patent Document 8: JP 4226803 (USP 6492091)
Patent Document 9: JP 6512049 (US 2017075218)

### DISCLOSURE OF INVENTION

An object of the invention is to provide a chemically amplified negative resist composition which exhibits an improved resolution upon pattern formation and forms a pattern with reduced LER, high fidelity and improved dose margin, and a resist pattern forming process using the same.

The inventors have found that when an onium salt having a conjugated acid anion which is decomposed under the action of acid and heat into carbon dioxide and an organic compound having no more than 12 carbon atoms is added to a resist composition as a quencher, the resist composition exhibits a high resolution during pattern formation and forms a pattern of satisfactory profile with improved LER, fidelity and dose margin.

Accordingly, the invention provides a chemically amplified negative resist composition and resist pattern forming process, as defined below.
1. A chemically amplified negative resist composition comprising (A) a quencher in the form of an onium salt having the formula (A1) and (B) a base polymer containing a polymer comprising repeat units having the formula (B1), 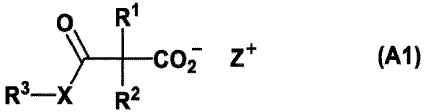 wherein X is a single bond, -O- or -S-,
   R¹ and R² are each independently hydrogen or a C₁-C₁₀ hydrocarbyl group in which some constituent -CH₂- may be replaced by -O- or -C(=O)-, R¹ and R² may bond together to form a ring with the carbon atom to which they are attached,
   R³ is hydrogen or a C₁-C₁₀ hydrocarbyl group when X is a single bond or -S-, and hydrogen, a C₁-C₁₀ hydrocarbyl group other than an acid labile group, or an acid labile group when X is -O-, some or all of the hydrogen atoms in the hydrocarbyl group may be substituted by halogen, some constituent -CH₂- in the hydrocarbyl group may be replaced by -O- or - C(=O)-, R¹ and R³ may bond together to form a ring with the atoms to which they are attached and intervenient atoms, with the proviso that the number of carbon atoms in R¹ to R³ is up to 10 when R³ is other than the acid labile group, and
   Z⁺ is an onium cation, 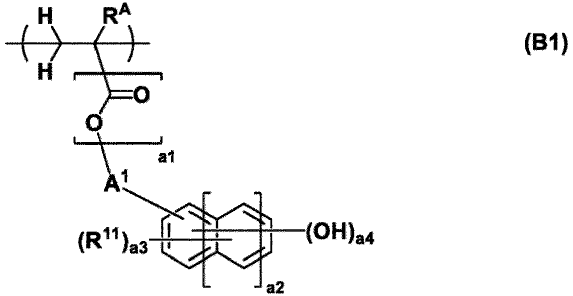
   wherein a1 is 0 or 1, a2 is an integer of 0 to 2, a3 is an integer satisfying 0 ≤ a3 ≤ 5+2(a2)-a4, a4 is an integer of 1 to 3,
   R^{A} is hydrogen, fluorine, methyl or trifluoromethyl,
   R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
   A¹ is a single bond or C₁-C₁₀ saturated hydrocarbylene group in which some constituent - CH₂- may be replaced by -O-.
2. The negative resist composition of 1 wherein X is -O-.
3. The negative resist composition of 2 wherein R³ is an acid labile group.
4. The negative resist composition of any one of 1 to 3 wherein the acid labile group has the formula (AL-1) or (AL-2): 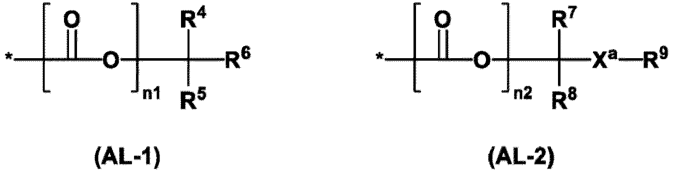 wherein X^{a} is -O- or -S-,
   R⁴, R⁵ and R⁶ are each independently a C₁-C₁₂ hydrocarbyl group in which some constituent -CH₂- may be replaced by -O- or -S-, and when the hydrocarbyl group contains an aromatic ring, some or all of the hydrogen atoms in the aromatic ring may be substituted by halogen, cyano, nitro, optionally halogenated C₁-C₄ alkyl group or optionally halogenated C₁-C₄ alkoxy group, any two of R⁴, R⁵ and R⁶ may bond together to form a ring, some constituent - CH₂- in the ring may be replaced by -O- or -S-,
   R⁷ and R⁸ are each independently hydrogen or a C₁-C₁₀ hydrocarbyl group, R⁹ is a C₁-C₂₀ hydrocarbyl group, some constituent -CH₂- in the hydrocarbyl group may be replaced by -O- or - S-, R⁸ and R⁹ may bond together to form a C₃-C₂₀ heterocyclic group with the carbon atom and X^{a} to which they are attached, some constituent -CH₂- in the heterocyclic group may be replaced by -O- or -S-,
   n1 and n2 are each independently 0 or 1,
   * designates a point of attachment to the adjacent -O-.
5. The negative resist composition of any one of 1 to 4 wherein Z⁺ is an onium cation having the formula (cation-1), (cation-2) or (cation-3): 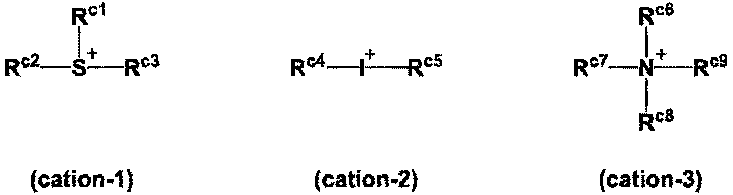 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.
6. The negative resist composition of any one of 1 to 5 wherein the polymer further comprises repeat units having the formula (B2): 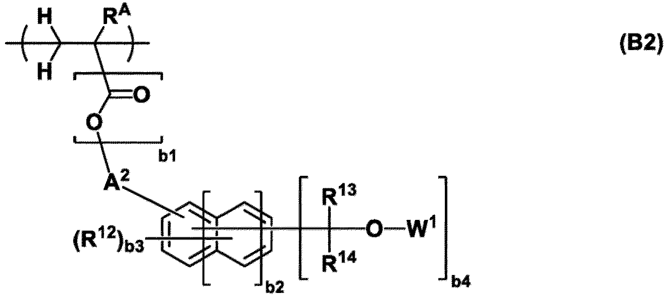 wherein b1 is 0 or 1, b2 is an integer of 0 to 2, b3 is an integer satisfying 0 ≤ b3 ≤ 5+2(b2)-b4, b4 is an integer of 1 to 3,
   R^{A} is hydrogen, fluorine, methyl or trifluoromethyl,
   R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   R¹³ and R¹⁴ are each independently hydrogen, a C₁-C₁₅ saturated hydrocarbyl group which may be substituted with a hydroxy or saturated hydrocarbyloxy moiety, or an optionally substituted aryl group, R¹³ and R¹⁴ are not hydrogen at the same time, R¹³ and R¹⁴ may bond together to form a ring with the carbon atom to which they are attached,
   A² is a single bond or C₁-C₁₀ saturated hydrocarbylene group in which any constituent - CH₂- may be replaced by -O-,
   W¹ is hydrogen, a C₁-C₁₀ aliphatic hydrocarbyl group or an optionally substituted aryl group.
7. The negative resist composition of any one of 1 to 6 wherein the polymer further comprises repeat units of at least one type selected from repeat units having the formula (B3), repeat units having the formula (B4), and repeat units having the formula (B5): 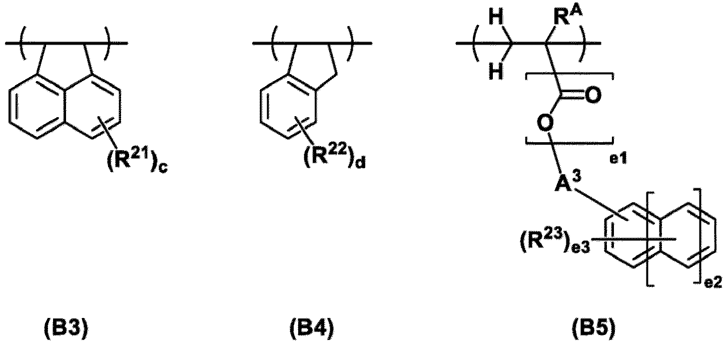 wherein c and d are each independently an integer of 0 to 4, e1 is 0 or 1, e2 is an integer of 0 to 5, and e3 is an integer of 0 to 2,
   R^{A} is hydrogen, fluorine, methyl or trifluoromethyl,
   R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, C₁-C₂₀ saturated hydrocarbylsulfinyl group, or C₁-C₂₀ saturated hydrocarbylsulfonyl group, and
   A⁴ is a single bond or C₁-C₁₀ saturated hydrocarbylene group in which any constituent - CH₂- may be replaced by -O-.
8. The negative resist composition of 6 wherein the polymer further comprises repeat units of at least one type selected from repeat units having the formulae (B6) to (B13): 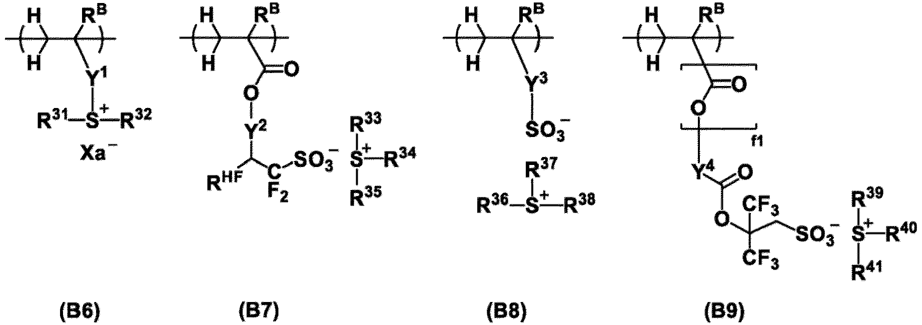 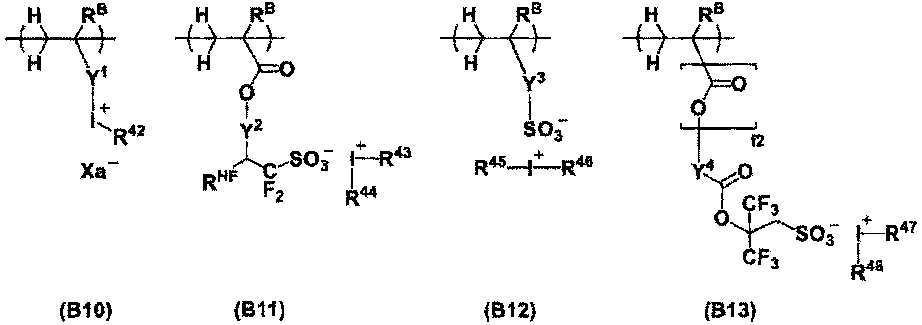 wherein R^{B} is each independently hydrogen or methyl,
   Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or **-Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   * designates a point of attachment to the carbon atom in the backbone, ** designates a point of attachment to the oxygen atom in the formula,
   Y⁴ is a single bond or C₁-C₃₀ hydrocarbylene group which may contain a heteroatom,
   f1 and f2 are each independently 0 or 1, f1 and f2 are 0 when Y⁴ is a single bond,
   R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
9. The negative resist composition of 8 wherein the polymer further comprises repeat units having the formula (B1-1), repeat units having the formula (B2-1) or repeat units having the formula (B2-2), and repeat units having the formula (B7): 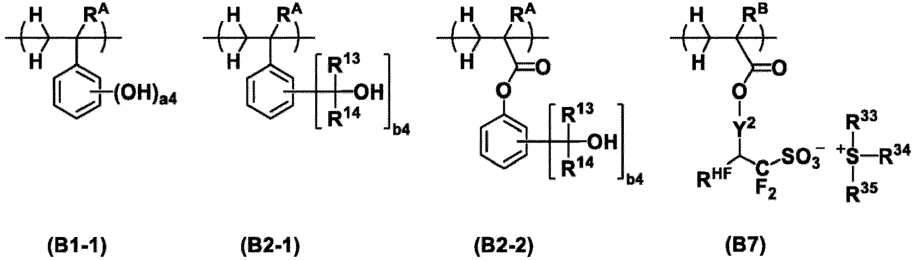 wherein a4, b4, R^{A}, R^{B}, Y², R¹³, R¹⁴, R³³, R³⁴, R³⁵, and R^{HF} are as defined above.
10. The negative resist composition of 8 or 9 wherein the base polymer (B) further contains a polymer comprising repeat units having formula (B1) and repeat units having formula (B2), but not repeat units having formulae (B6) to (B13).
11. The negative resist composition of any one of 1 to 10 wherein repeat units having an aromatic ring structure account for at least 60 mol% of the overall repeat units of the polymer in the base polymer.
12. The negative resist composition of any one of 1 to 11, further comprising (C) a crosslinker.
13. The negative resist composition of claim 6 which is free of a crosslinker.
14. The negative resist composition of any one of 1 to 13, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 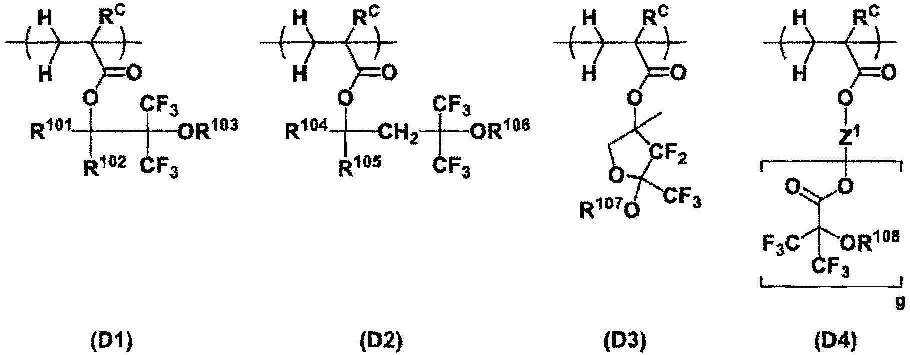 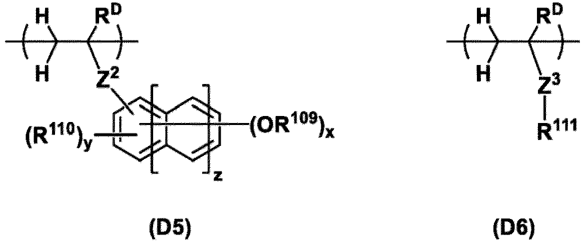 wherein x is an integer of 1 to 3, y is an integer satisfying 0 ≤ y ≤ 5+2z-x, z is 0 or 1, g is an integer of 1 to 3,
   R^{C} is each independently hydrogen, fluorine, methyl or trifluoromethyl,
   R^{D} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some constituent -CH₂- may be replaced by an ester bond or ether bond,
   Z¹ is a C₁-C₂₀ (h+1)-valent hydrocarbon group or C₁-C₂₀ (h+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
15. The negative resist composition of any one of 1 to 14, further comprising (E) an acid generator.
16. The negative resist composition of 15 wherein the acid generator has an anion having an acid strength (pKa) of -3.0 or larger.
17. The negative resist composition of 15 or 16 wherein the acid generator (E) and the quencher (A) are present in a weight ratio of less than 6/1.
18. The negative resist composition of any one of 1 to 17, further comprising (E) an organic solvent.
19. A resist pattern forming process comprising the steps of:
   applying the chemically amplified negative resist composition of any one of claims 1 to 18 onto a substrate to form a resist film thereon,
   exposing the resist film patternwise to high-energy radiation, and
   developing the exposed resist film in an alkaline developer.
20. The process of claim 19 wherein the high-energy radiation is EUV or EB.
21. The process of claim 19 or 20 wherein the substrate has the outermost surface of a material containing at least one element selected from chromium, silicon, tantalum, molybdenum, cobalt, nickel, tungsten, and tin.
22. The process of any one of 19 to 21 wherein the substrate is a mask blank of transmission or reflection type.
23. A mask blank of transmission or reflection type which is coated with the chemically amplified negative resist composition of any one of 1 to 18.

### ADVANTAGEOUS EFFECTS OF INVENTION

The chemically amplified negative resist composition has the advantage that the onium salt having formula (A1) acts to effectively control the acid diffusion upon exposure for pattern formation. When the resist composition is applied to form a resist film which is processed to form a pattern, the resist composition exhibits a very high resolution and a pattern with reduced LER, good fidelity and improved dose margin is available. By virtue of repeat units having formula (B1), when a resist film is formed on a substrate, the film has tight adhesion to the substrate as well as high solubility in alkaline developer.

The resist pattern forming process using the resist composition is successful in forming a pattern with high resolution, reduced LER, good fidelity, and improved dose margin. The process is advantageously applicable to the miniaturization technology, especially EUV and EB lithography.

### DESCRIPTION OF PREFERRED EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, the broken line (---) and asterisk (*) each denote a point of attachment or valence bond. Me stands for methyl, and Ac for acetyl. The terms "group" and "moiety" are interchangeable.

The abbreviations and acronyms have the following meaning.
PAG: photoacid generator
Mw: weight average molecular weight
Mn: number average molecular weight
Mw/Mn: molecular weight distribution or dispersity
GPC: gel permeation chromatography
PEB: post-exposure baking
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Resist composition

One embodiment of the invention is a chemically amplified negative resist composition comprising (A) a quencher in the form of an onium salt having a conjugated acid anion which is decomposed under the action of acid and heat into carbon dioxide and an organic compound having no more than 12 carbon atoms and (B) a base polymer containing a specific polymer.

### (A) Quencher

The quencher as component (A) is an onium salt having the formula (A1).

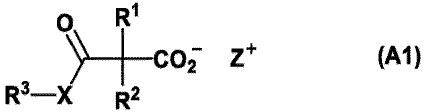

In formula (A1), X is a single bond, -O- or -S-, preferably a single bond or -O-, most preferably -O-.

In formula (A1), R¹ and R² are each independently hydrogen or a C₁-C₁₀ hydrocarbyl group. In the hydrocarbyl group, some constituent -CH₂- may be replaced by -O- or -C(=O)-. The hydrocarbyl group may be saturated or unsaturated and straight, branched or cyclic. Examples thereof include C₁-C₁₀ alkyl groups such as methyl, ethyl, n-propyl, isopropyl, n-butyl, and tert-butyl; C₃-C₁₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₁₀ alkenyl groups such as vinyl, allyl, propenyl, butenyl and hexenyl; C₃-C₁₀ cyclic unsaturated hydrocarbyl groups such as cyclohexenyl; C₆-C₁₀ aryl groups such as phenyl and naphthyl; C₇-C₁₀ aralkyl groups such as benzyl, 1-phenylethyl and 2-phenylethyl; and combinations thereof. In the hydrocarbyl group, some constituent -CH₂- may be replaced by - O- or -C(=O)-.

Also, R¹ and R² may bond together to form a ring with the carbon atom to which they are attached. Rings of 3 to 10 carbon atoms are preferred, and saturated rings of 3 to 10 carbon atoms are more preferred. Preferred examples of the ring include cyclopropane, cyclobutane, cyclopentane, cyclohexane, norbornane, and adamantane rings. In the ring, some constituent - CH₂- may be replaced by -O- or -C(=O)-.

Preferably, R¹ and R² each are hydrogen or a C₁-C₆ saturated hydrocarbyl group, or R¹ and R² bond together to form a C₃-C₈ saturated ring with the carbon atom to which they are attached. More preferably, R¹ and R² each are hydrogen or a C₁-C₄ saturated hydrocarbyl group, or R¹ and R² bond together to form a C₃-C₆ saturated ring with the carbon atom to which they are attached.

In formula (A1), R³ is hydrogen or a C₁-C₁₀ hydrocarbyl group when X is a single bond or -S-, and hydrogen, a C₁-C₁₀ hydrocarbyl group other than an acid labile group, or an acid labile group when X is -O-. The hydrocarbyl group may be saturated or unsaturated and straight, branched or cyclic. Examples thereof include C₁-C₁₀ alkyl groups such as methyl, ethyl, n-propyl, isopropyl, n-butyl, and tert-butyl; C₃-C₁₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₁₀ alkenyl groups such as vinyl, allyl, propenyl, butenyl and hexenyl; C₃-C₁₀ cyclic unsaturated hydrocarbyl groups such as cyclohexenyl; C₆-C₁₀ aryl groups such as phenyl and naphthyl; C₇-C₁₀ aralkyl groups such as benzyl, 1-phenylethyl and 2-phenylethyl; and combinations thereof. In the hydrocarbyl group, some or all of the hydrogen atoms may be substituted by halogen such as fluorine, chlorine, bromine or iodine, and some constituent -CH₂- may be replaced by -O- or -C(=O)-.

Also, R¹ and R³ may bond together to form a ring with the atoms to which they are attached and intervenient atoms. The ring is a cycloalkylketone when X is a single bond, a lactone ring when X is -O-, and a thiolactone ring when X is -S-. The ring is preferably a 3 to 8-membered ring, more preferably a 5 to 7-membered ring. In the ring, some or all of the hydrogen atoms may be substituted by halogen, and some constituent -CH₂- may be replaced by -O- or -C(=O)-.

It is noted that the number of carbon atoms in R¹ to R³ is up to 10 when R³ is other than the acid labile group.

The acid labile group R³ preferably has the formula (AL-1) or (AL-2).

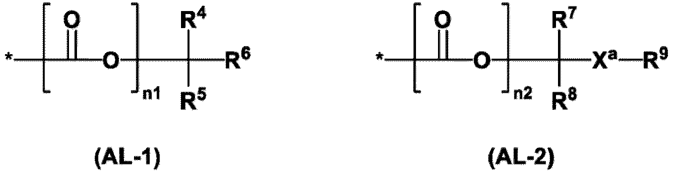

In formula (AL-1), R⁴, R⁵ and R⁶ are each independently a C₁-C₁₂ hydrocarbyl group. Some constituent -CH₂- in the hydrocarbyl group may be replaced by -O- or -S-. When the hydrocarbyl group contains an aromatic ring, some or all of the hydrogen atoms on the aromatic ring may be substituted by halogen, cyano, nitro, optionally halogenated C₁-C₄ alkyl moiety, or optionally halogenated C₁-C₄ alkoxy moiety. The subscript n1 is 0 or 1, and the asterisk (*) designates a point of attachment to the adjacent -O-.

The C₁-C₁₂ hydrocarbyl group represented by R⁴, R⁵ and R⁶ may be saturated or unsaturated and straight, branched or cyclic. Examples thereof include C₁-C₁₂ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl, n-undecyl, and n-dodecyl; C₃-C₁₂ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, norbornylmethyl, adamantyl, adamantylmethyl, tricyclo[5.2.1.0^{2,6}]decyl, and tetracyclo[6.2.1.1^{3,6}.0^{2.7}]dodecyl; C₂-C₁₂ alkenyl groups such as vinyl, allyl, propenyl, butenyl, pentenyl and hexenyl; C₂-C₁₂ alkynyl groups such as ethynyl, propynyl, butynyl, pentynyl and hexynyl; C₃-C₁₂ cyclic unsaturated aliphatic hydrocarbyl groups such as cyclopentenyl and cyclohexenyl; C₆-C₁₂ aryl groups such as phenyl, naphthyl and indanyl; C₇-C₁₂ aralkyl groups such as benzyl, 1-phenylethyl and 2-phenylethyl, and combinations thereof.

Any two of R⁴, R⁵ and R⁶ may bond together to form a ring. Examples of the thus formed ring include cyclopropane, cyclobutane, cyclopentane, cyclohexane, cycloheptane, cyclooctane, norbornane, adamantane, tricyclo[5.2.1.0^{2,6}]decane, and tetracyclo[6.2.1.1^{3,6}.0^{2,7}]dodecane rings. Some constituent -CH₂- in the ring may be replaced by -O- or -S-.

In formula (AL-2), X^{a} is -O- or -S-. R⁷ and R⁸ are each independently hydrogen or a C₁-C₁₀ hydrocarbyl group. The C₁-C₁₀ hydrocarbyl group represented by R⁷ and R⁸ may be saturated or unsaturated and straight, branched or cyclic, and examples thereof are as exemplified above for the C₁-C₁₀ hydrocarbyl group represented by R¹ and R².

In formula (AL-2), R⁹ is a C₁-C₂₀ hydrocarbyl group. Some constituent -CH₂- in the hydrocarbyl group may be replaced by -O- or -S-. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, norbornylmethyl, adamantyl, adamantylmethyl, tricyclo[5.2.1.0^{2,6}]decyl, and tetracyclo[6.2.1.1^{3,6}.0^{2.7}]dodecyl; C₂-C₂₀ alkenyl groups such as vinyl, propenyl, butenyl, pentenyl and hexenyl; C₂-C₂₀ alkynyl groups such as ethynyl, propynyl, butynyl, pentynyl and hexynyl; C₃-C₂₀ cyclic unsaturated aliphatic hydrocarbyl groups such as cyclopentenyl, cyclohexenyl and norbornenyl; C₆-C₂₀ aryl groups such as phenyl, methylphenyl, ethylphenyl, n-propylphenyl, isopropylphenyl, n-butylphenyl, isobutylphenyl, sec-butylphenyl, tert-butylphenyl, naphthyl, methylnaphthyl, ethylnaphthyl, n-propylnaphthyl, isopropylnaphthyl, n-butylnaphthyl, isobutylnaphthyl, sec-butylnaphthyl, and tert-butylnaphthyl; C₇-C₂₀ aralkyl groups such as benzyl and phenethyl, and combinations thereof. Also, R⁸ and R⁹ may bond together to form a C₃-C₂₀ heterocycle with the carbon atom and X^{a} to which they are attached. Some constituent-CH₂- in the heterocycle may be replaced by -O- or -S-. The subscript n2 is 0 or 1 and * designates a point of attachment to the adjacent -O-.

Examples of the acid labile group having formula (AL-1) are shown below, but not limited thereto. Herein, * designates a point of attachment to the adjacent -O-.

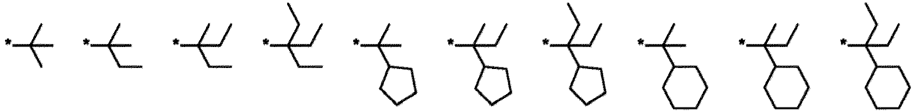

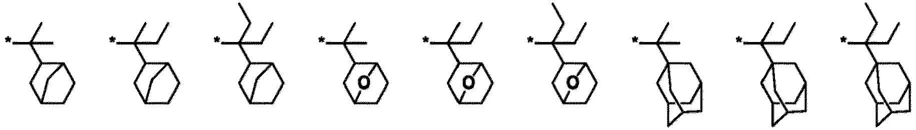

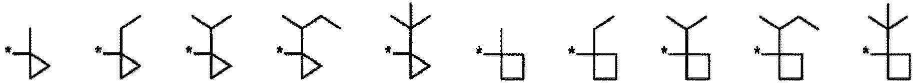

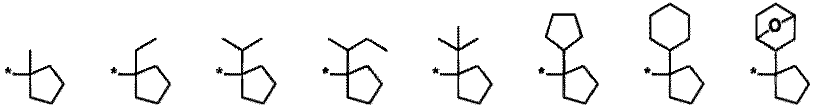

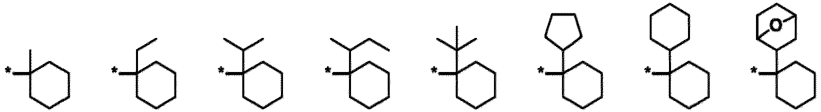

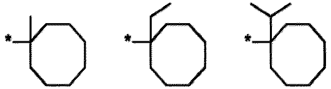

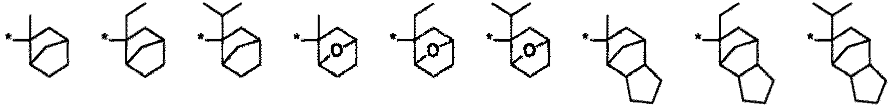

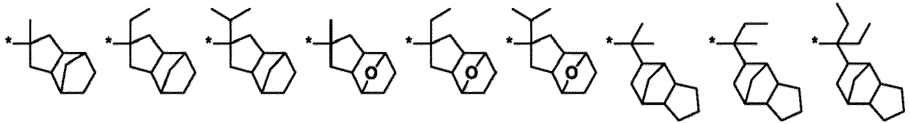

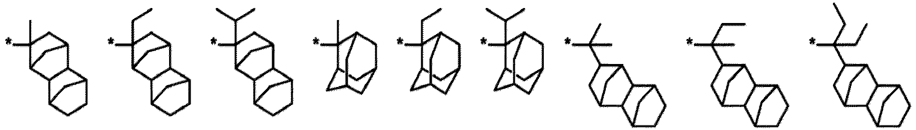

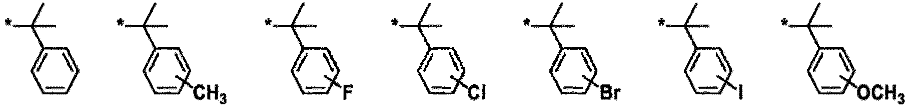

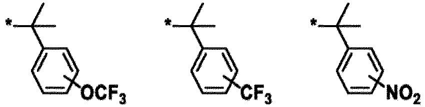

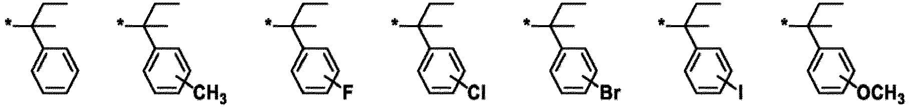

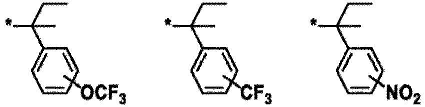

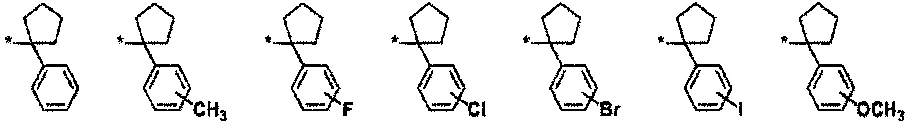

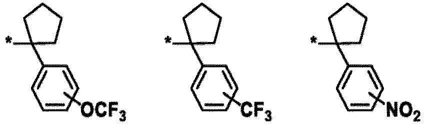

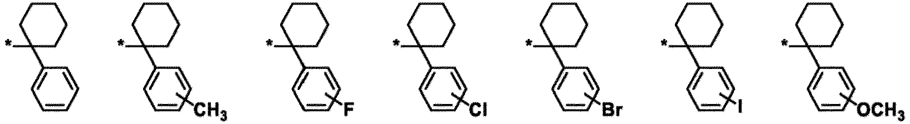

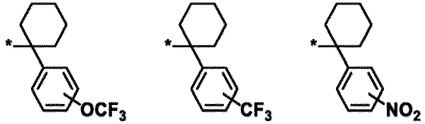

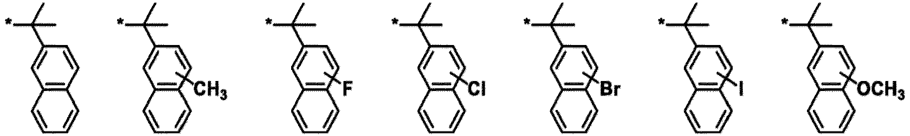

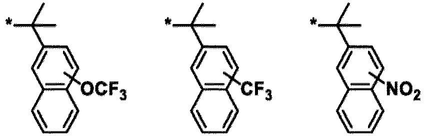

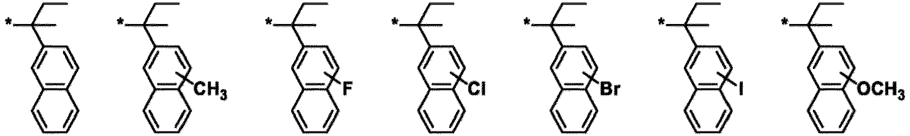

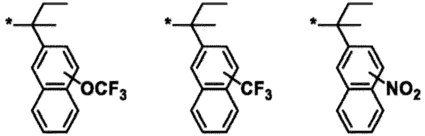

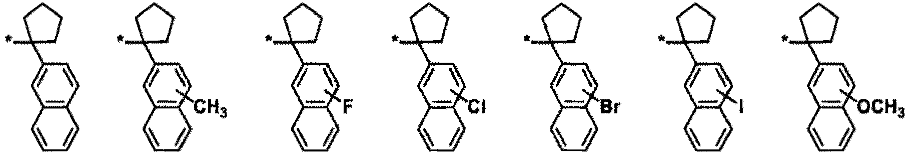

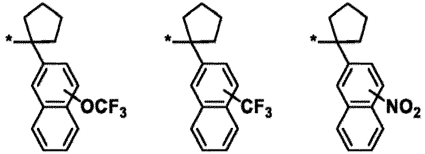

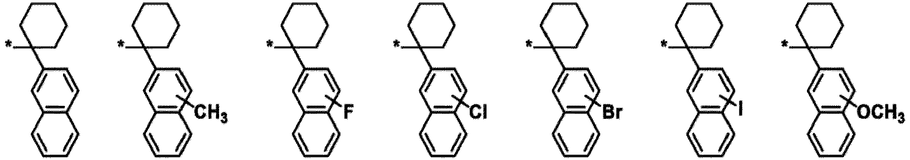

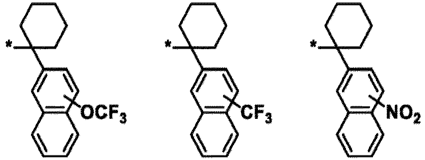

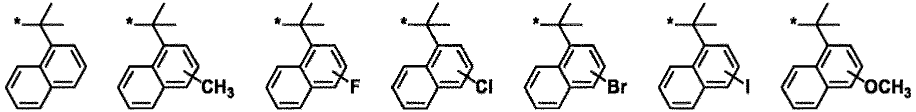

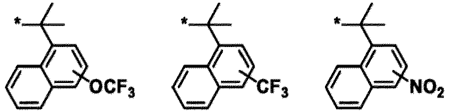

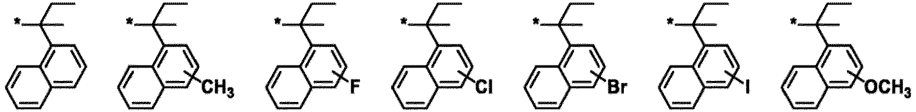

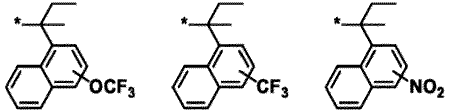

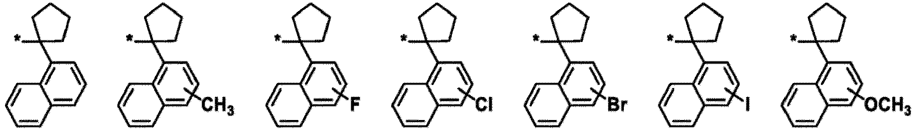

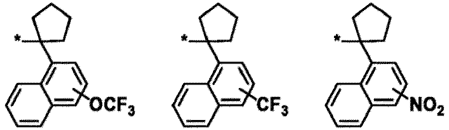

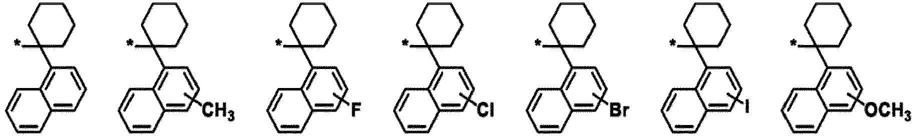

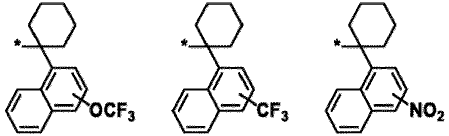

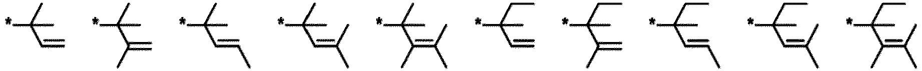

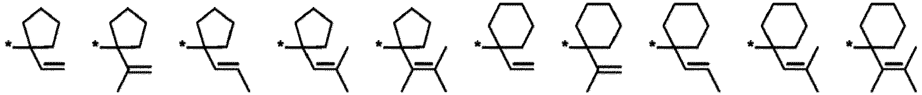

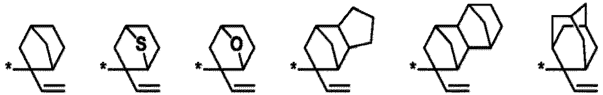

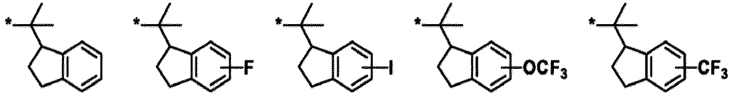

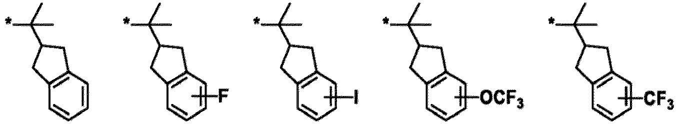

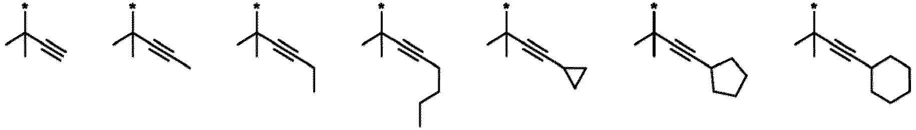

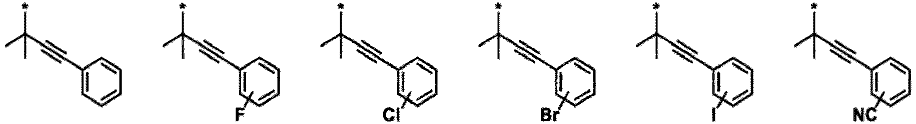

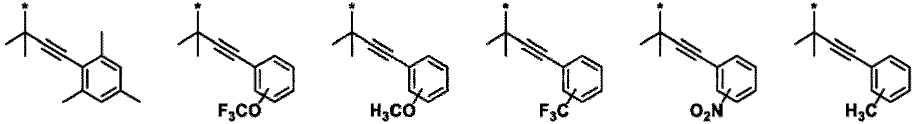

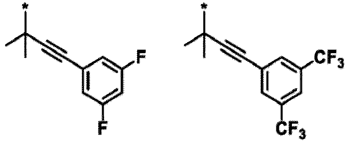

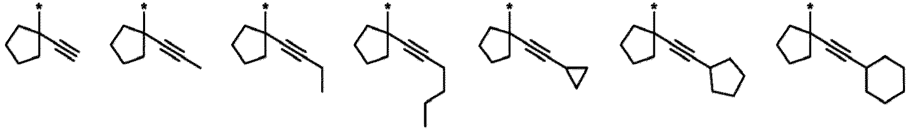

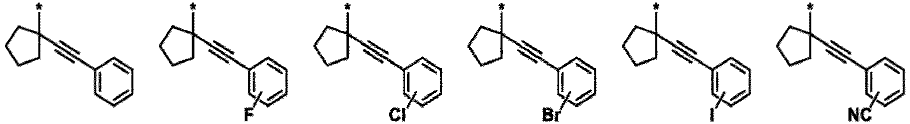

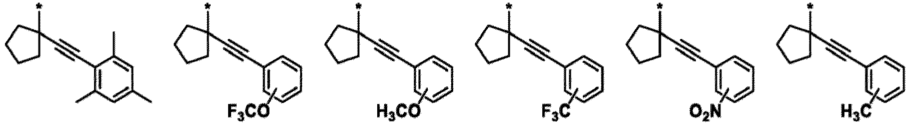

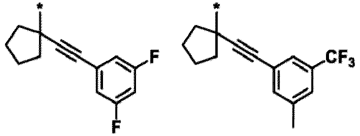

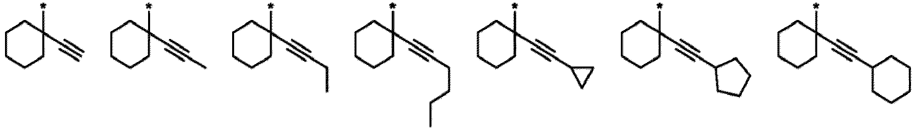

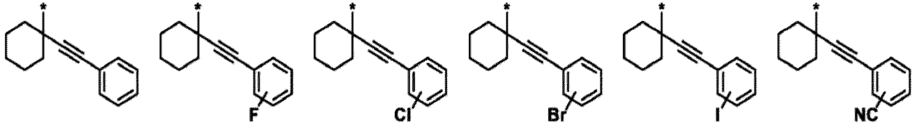

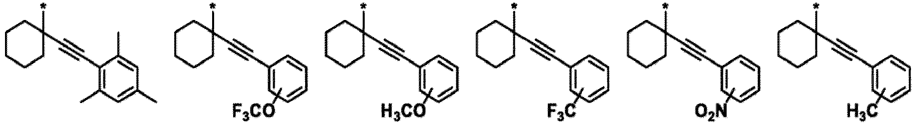

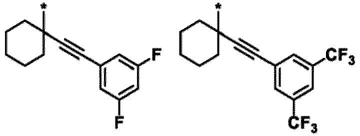

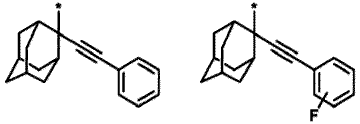

Examples of the acid labile group having formula (AL-2) are shown below, but not limited thereto. Herein, * designates a point of attachment to the adjacent -O-.

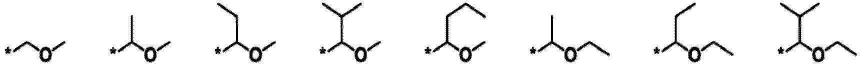

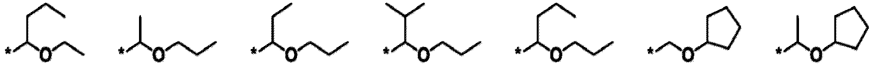

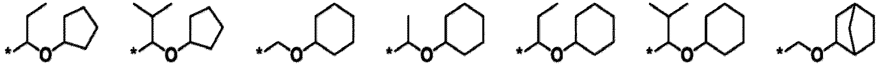

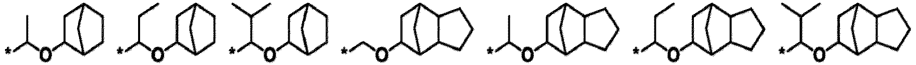

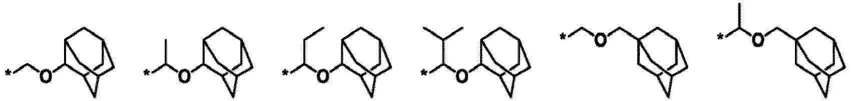

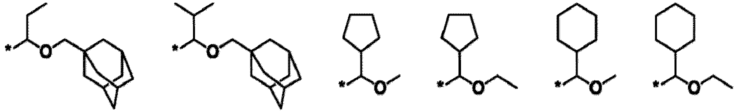

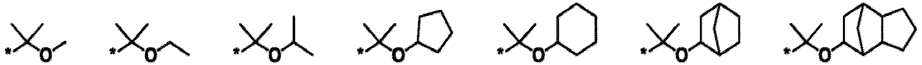

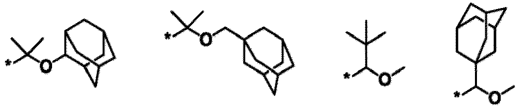

When X is a single bond or -S-, R³ is preferably hydrogen, a C₁-C₄ alkyl group, C₁-C₄ halogenated alkyl group, or C₃-C₆ cyclic saturated hydrocarbyl group, and more preferably hydrogen, a C₁-C₃ alkyl group, C₁-C₃ halogenated alkyl group, or C₃-C₆ cyclic saturated hydrocarbyl group. When X is -O-, R³ is preferably hydrogen, a C₁-C₄ alkyl group other than an acid labile group, a C₁-C₄ halogenated alkyl group other than an acid labile group, or an acid labile group having formula (AL-1) or (AL-2), and more preferably hydrogen, a C₁-C₃ hydrocarbyl group other than an acid labile group, a C₁-C₃ halogenated alkyl group other than an acid labile group, or an acid labile group having formula (AL-1) or (AL-2).

Preferred examples of the anion in the onium salt having formula (A1) are shown below, but not limited thereto.

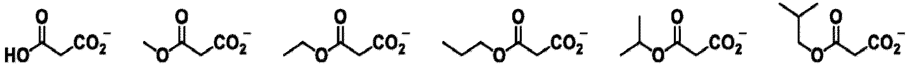

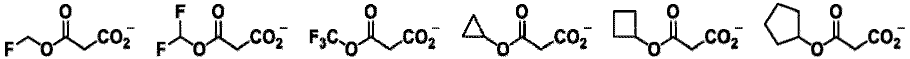

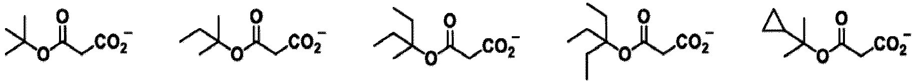

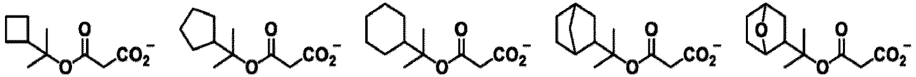

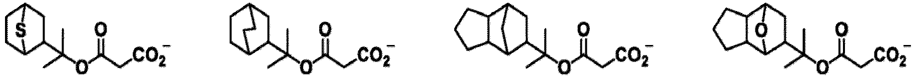

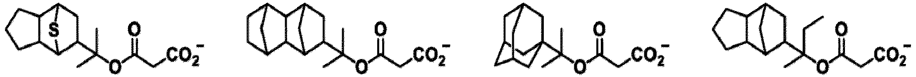

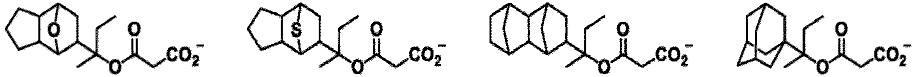

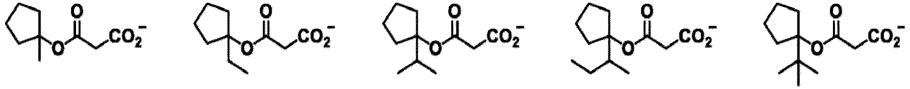

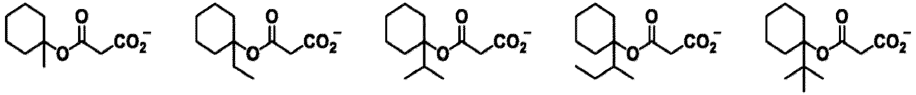

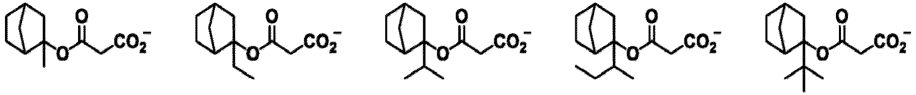

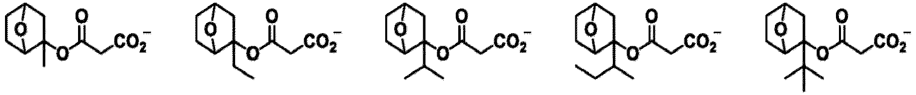

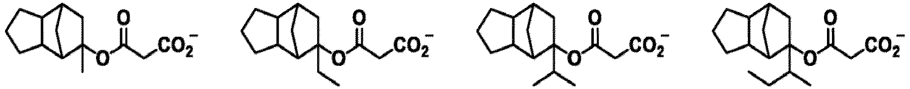

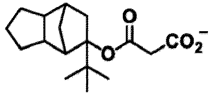

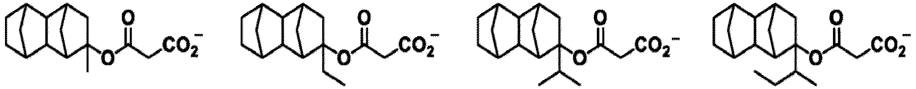

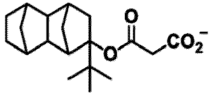

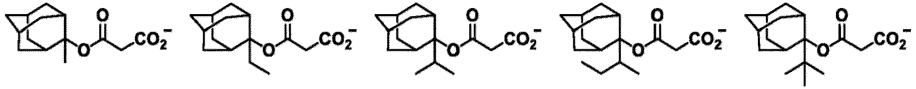

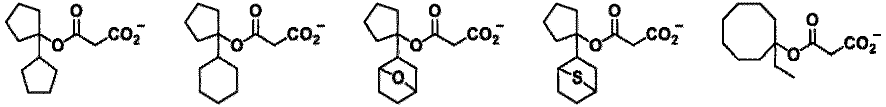

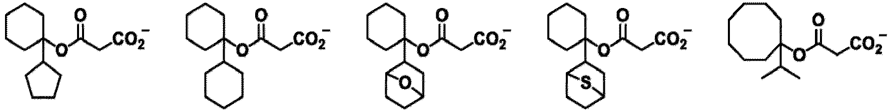

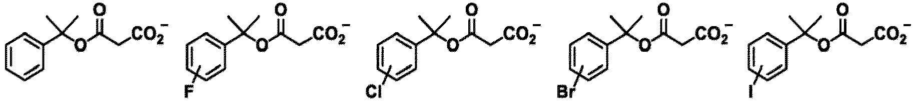

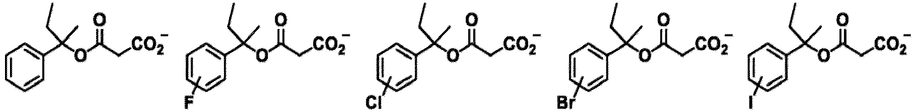

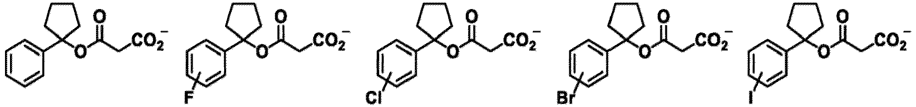

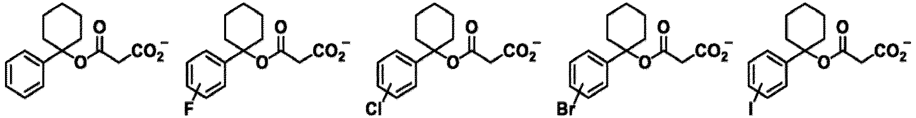

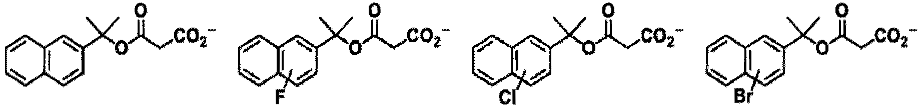

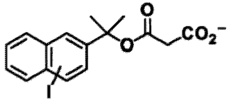

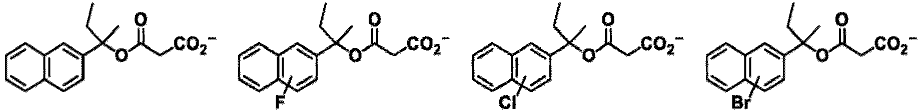

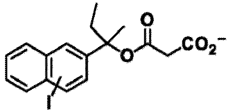

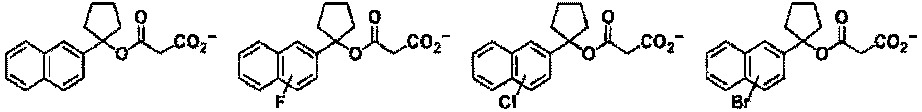

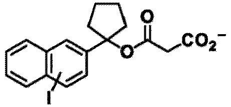

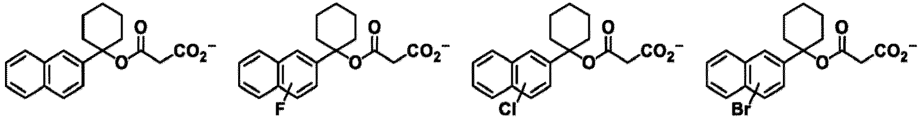

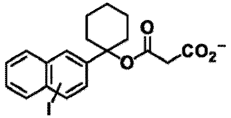

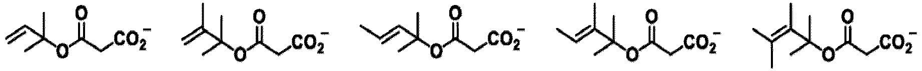

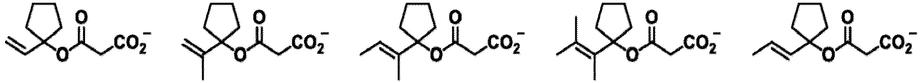

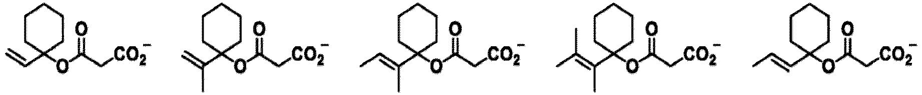

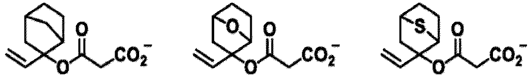

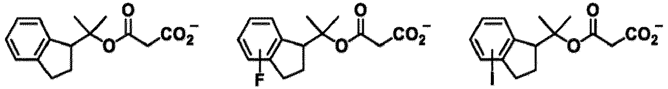

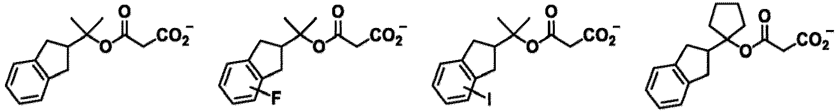

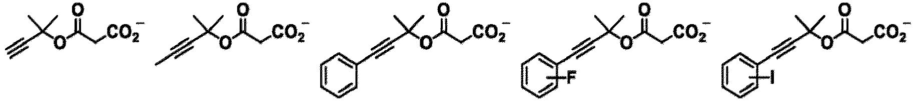

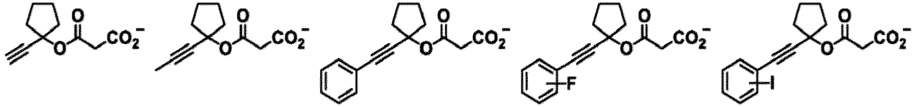

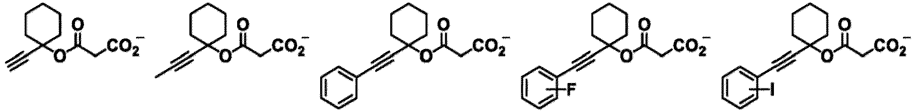

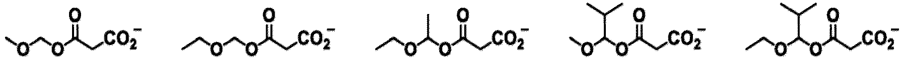

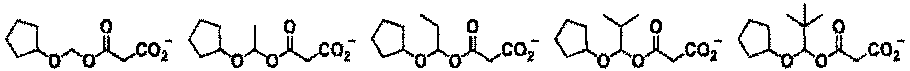

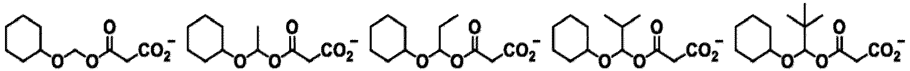

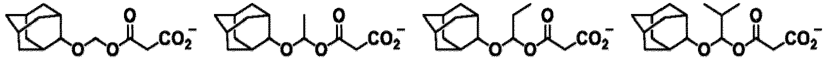

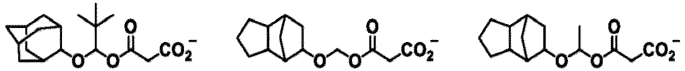

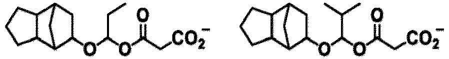

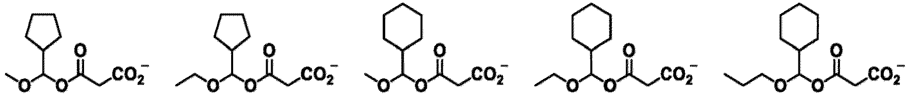

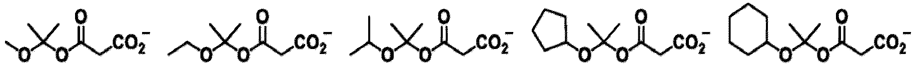

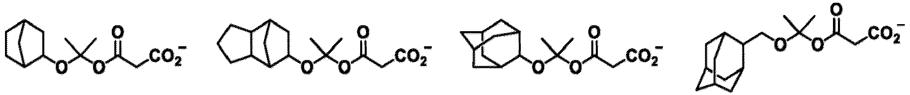

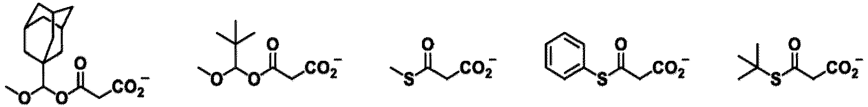

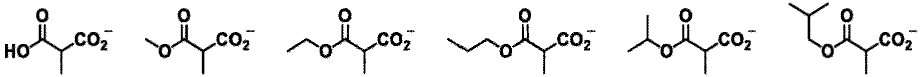

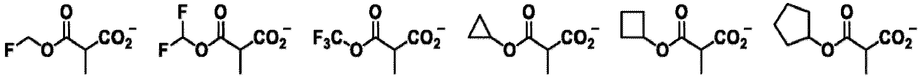

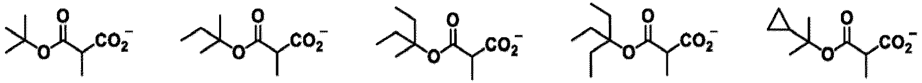

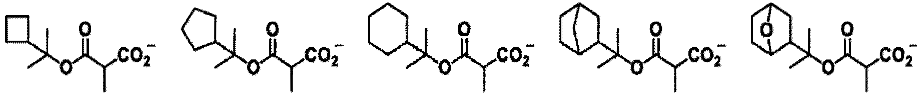

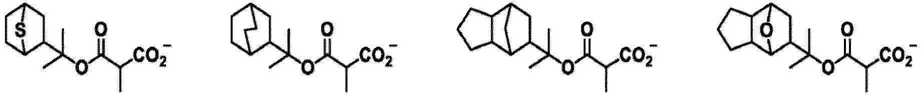

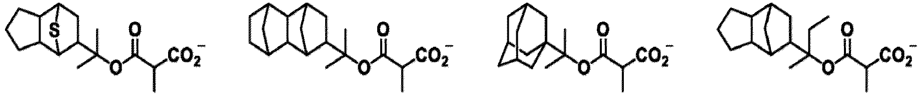

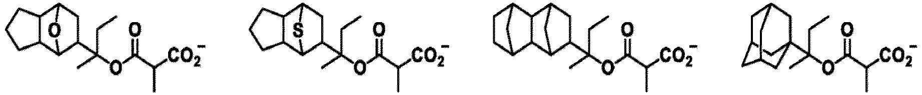

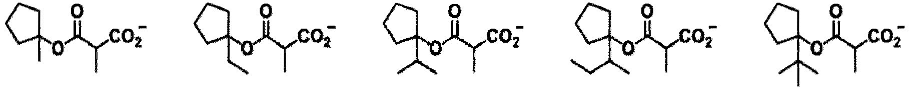

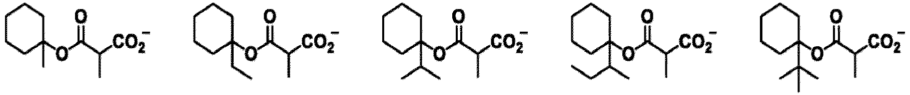

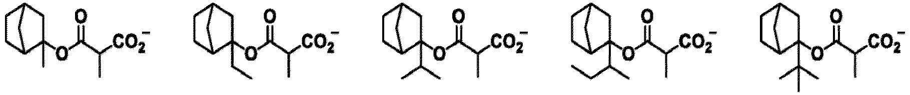

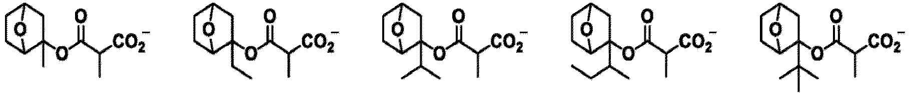

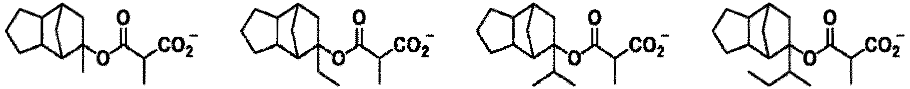

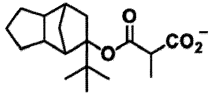

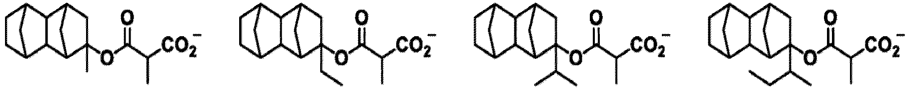

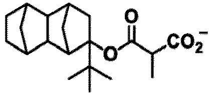

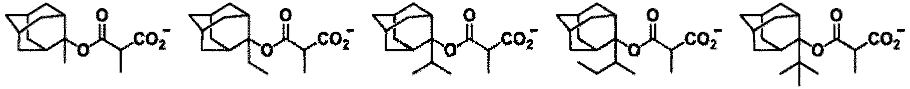

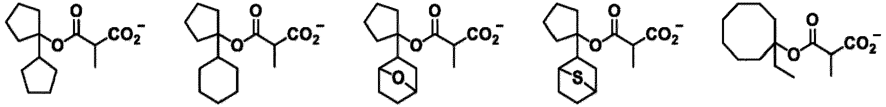

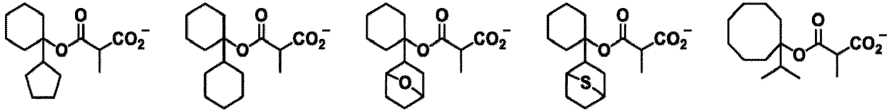

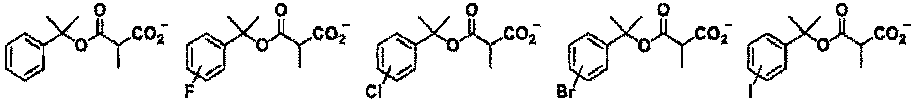

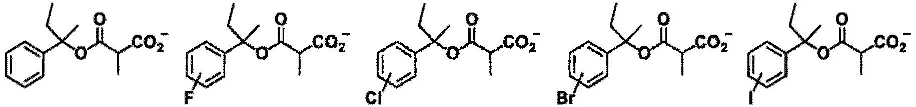

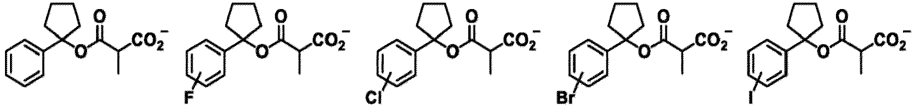

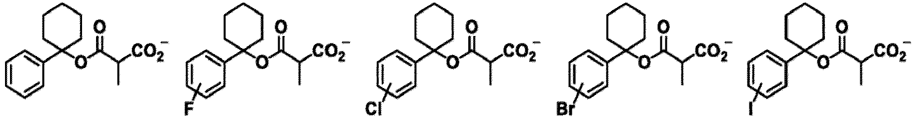

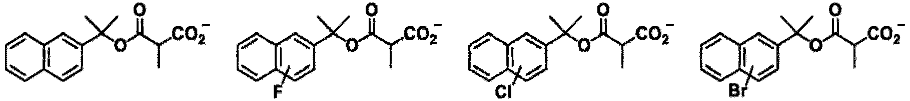

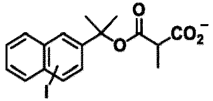

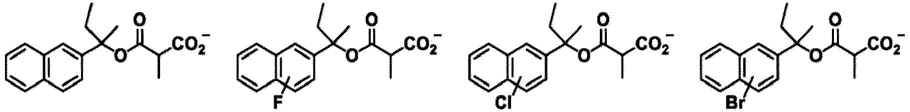

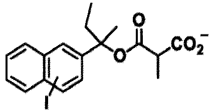

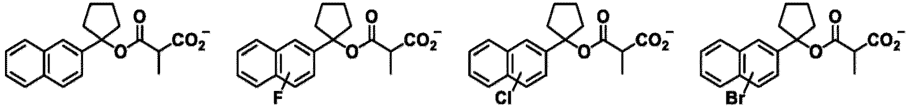

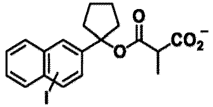

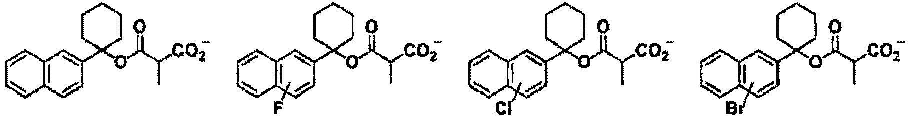

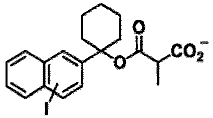

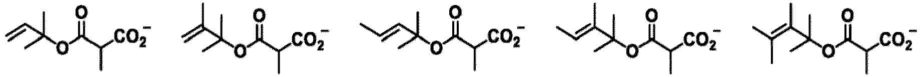

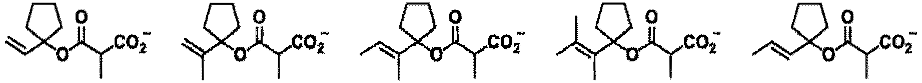

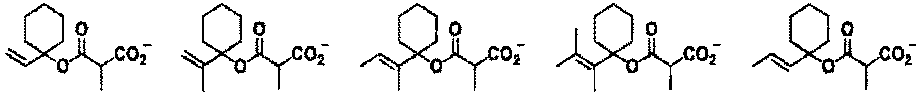

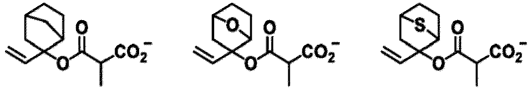

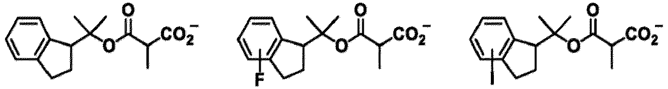

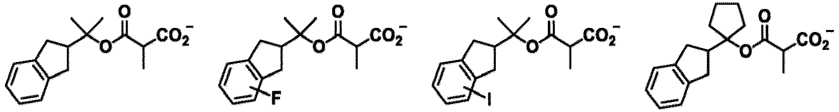

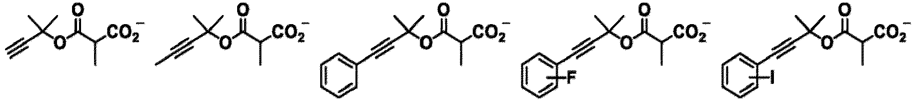

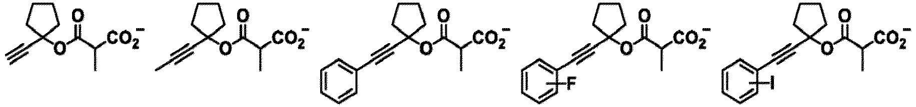

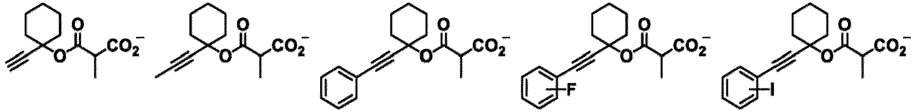

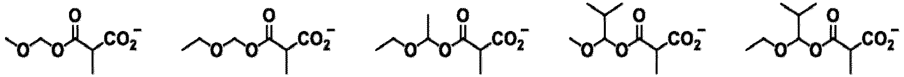

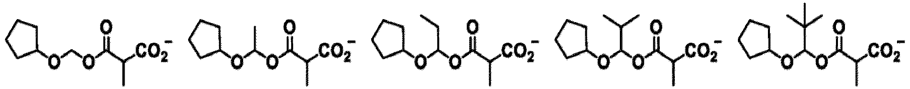

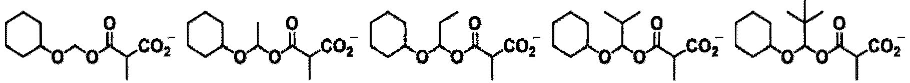

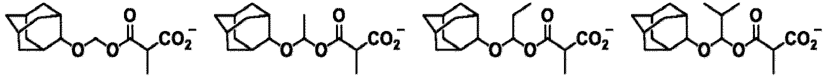

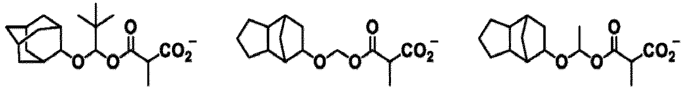

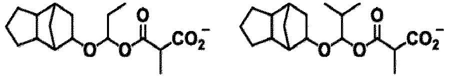

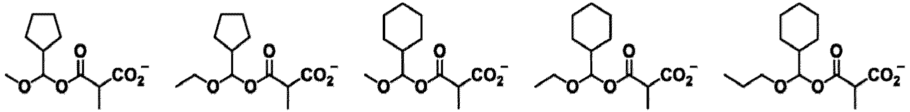

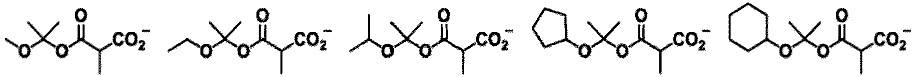

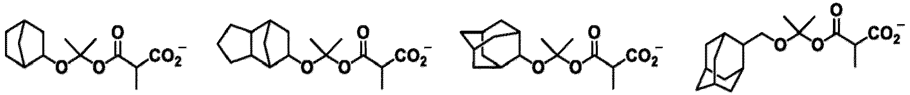

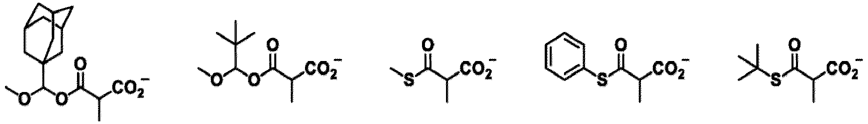

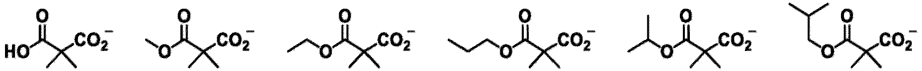

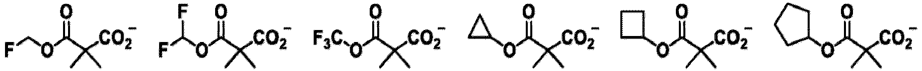

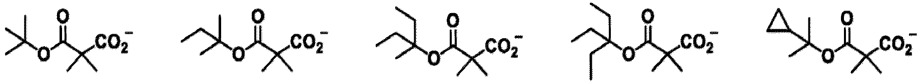

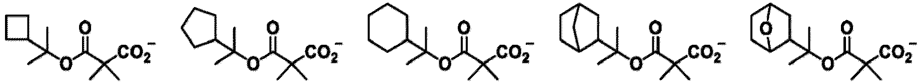

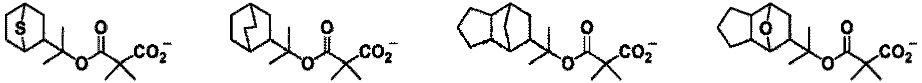

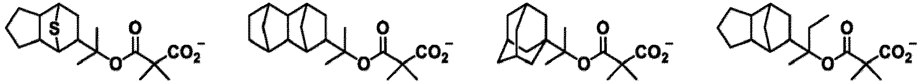

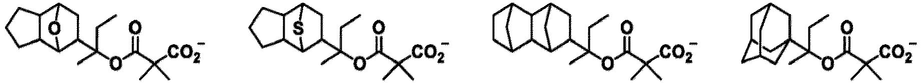

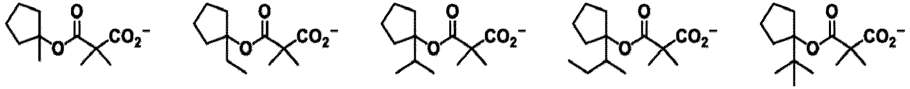

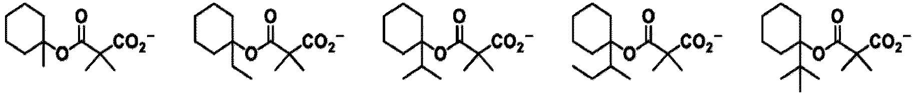

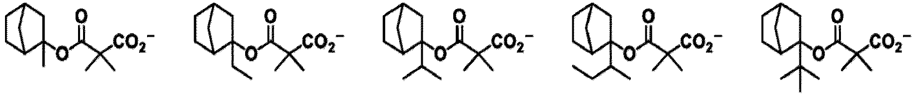

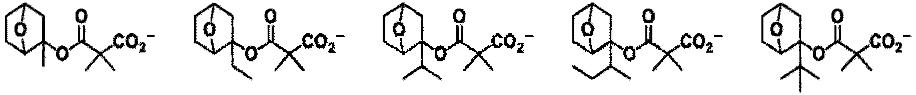

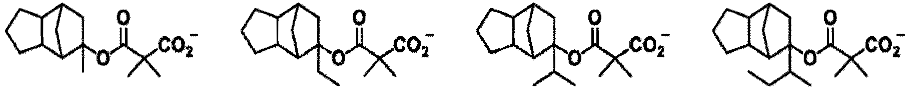

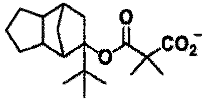

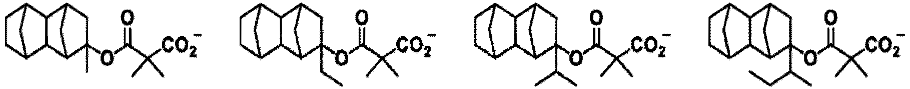

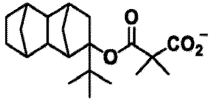

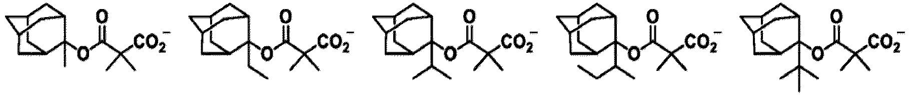

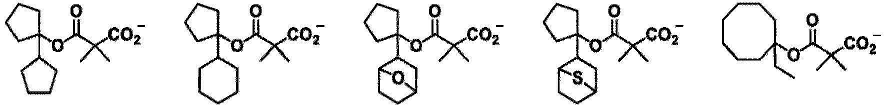

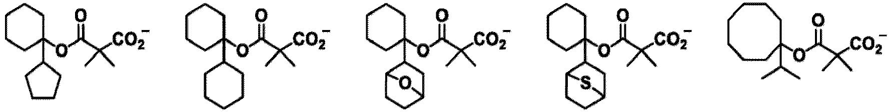

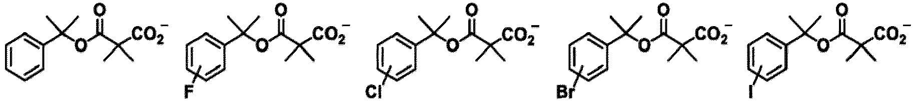

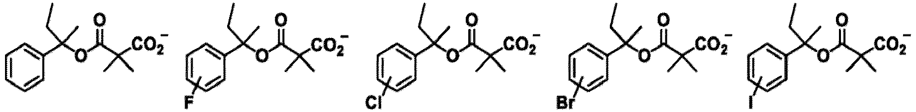

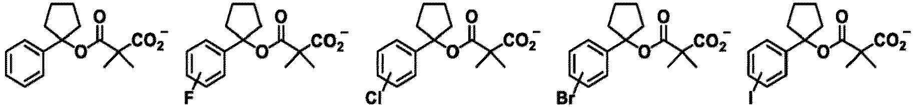

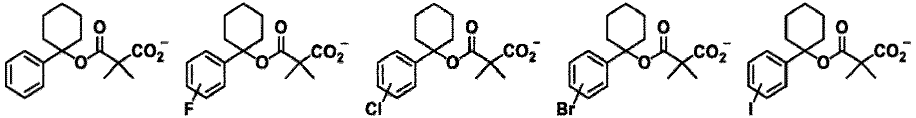

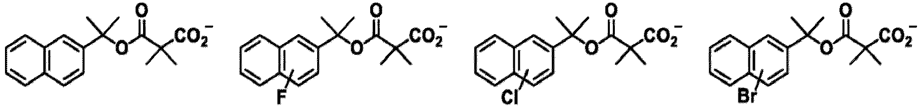

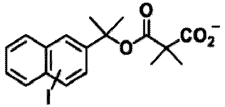

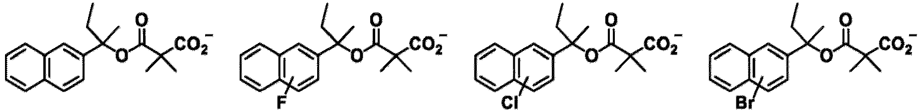

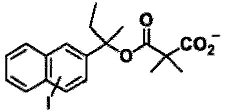

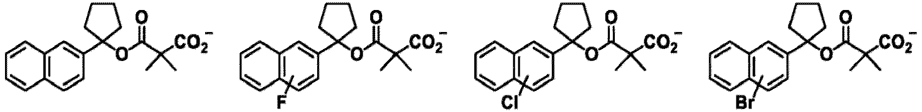

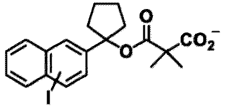

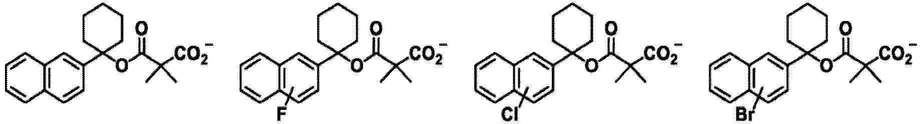

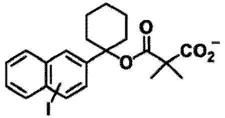

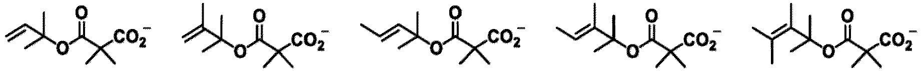

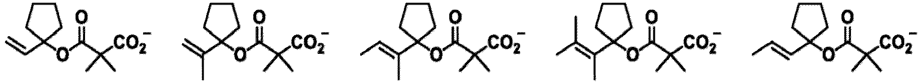

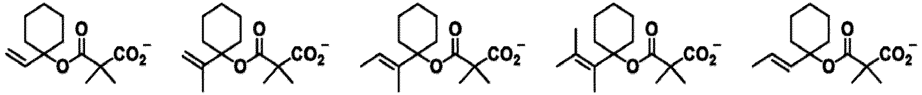

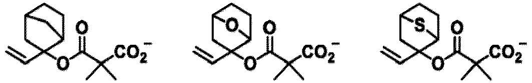

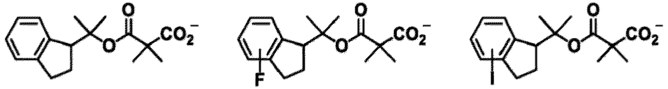

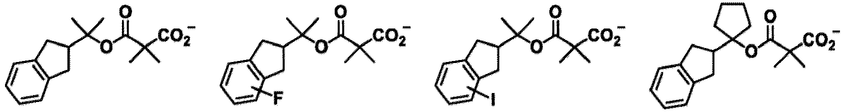

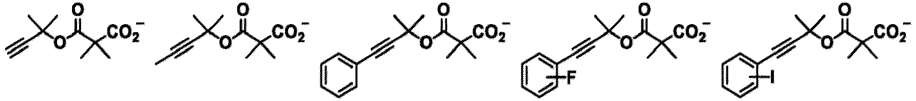

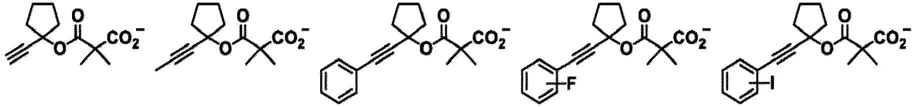

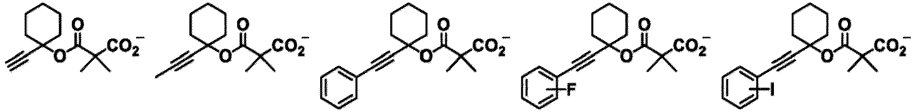

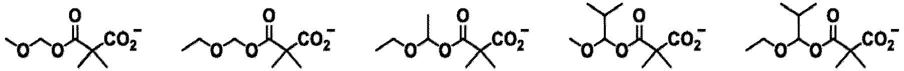

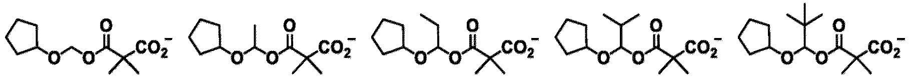

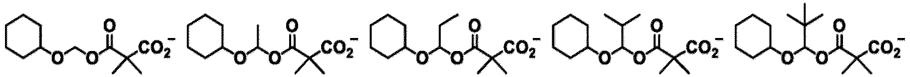

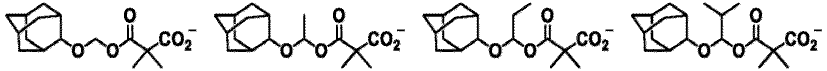

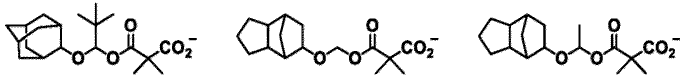

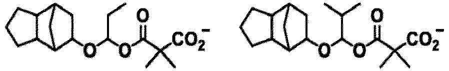

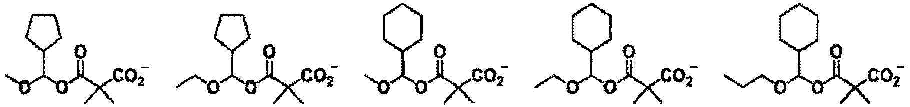

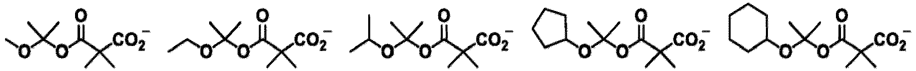

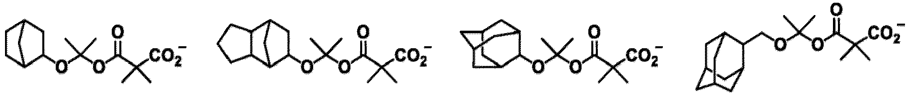

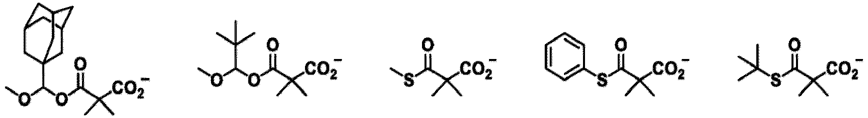

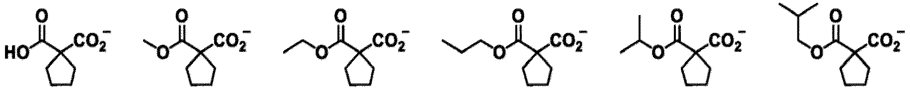

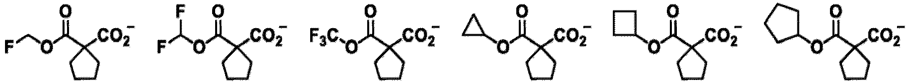

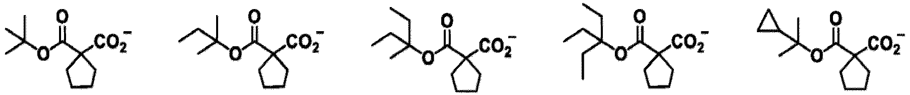

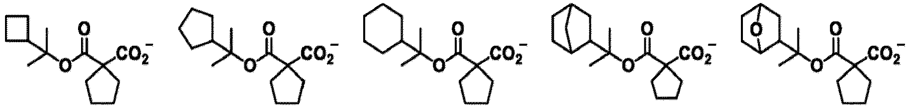

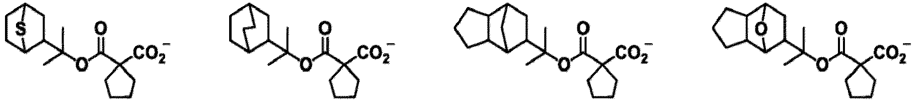

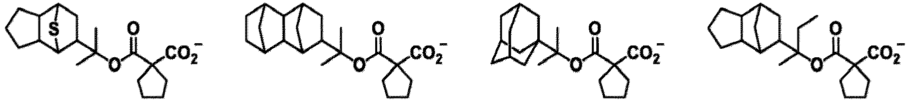

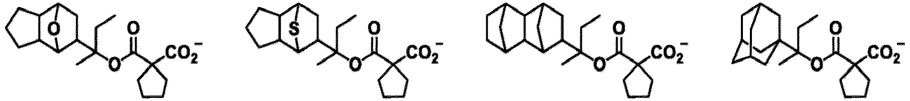

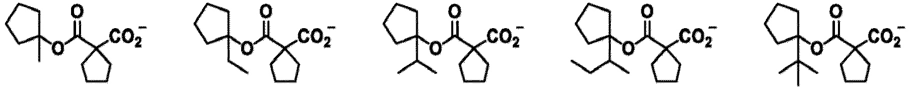

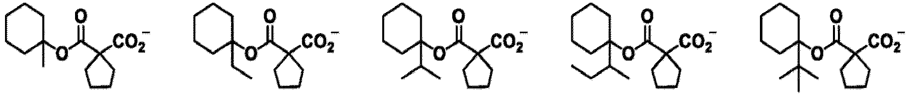

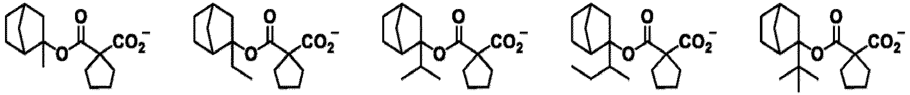

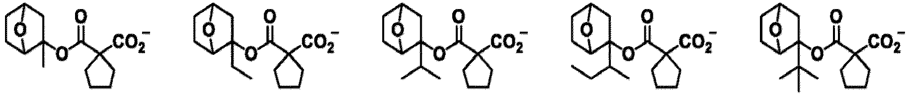

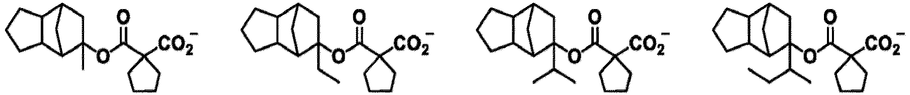

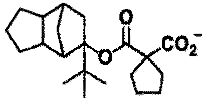

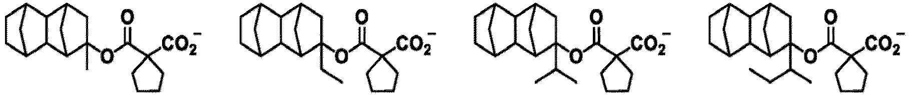

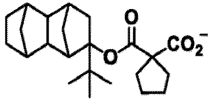

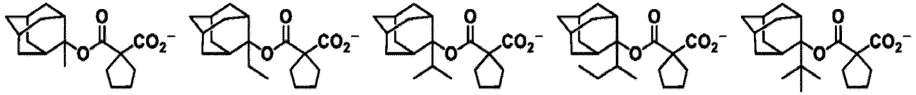

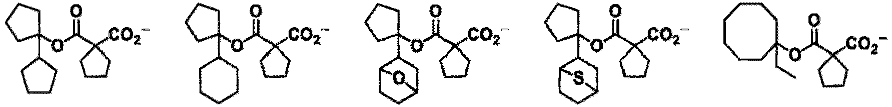

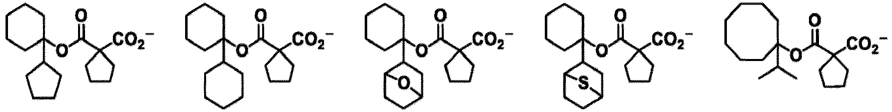

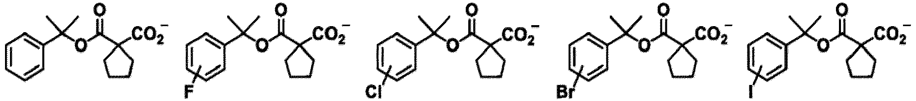

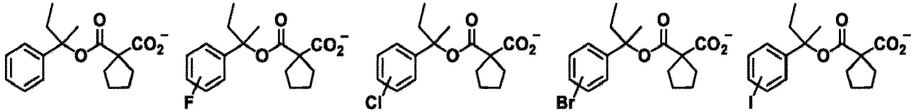

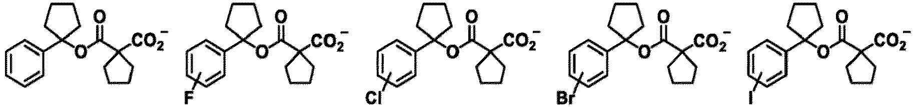

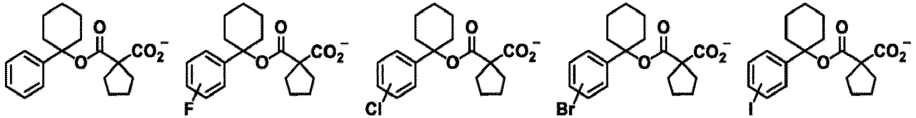

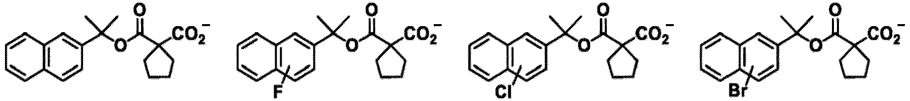

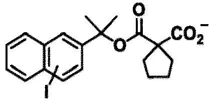

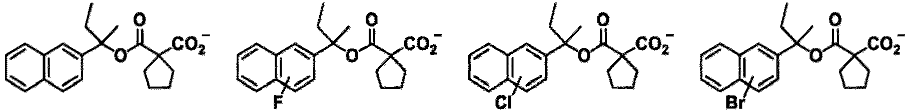

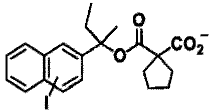

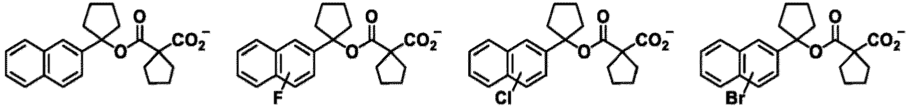

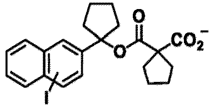

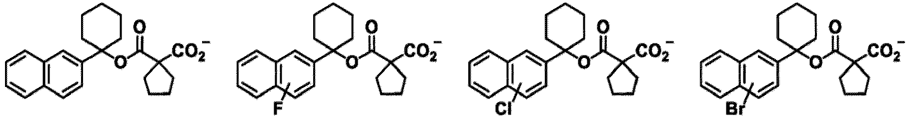

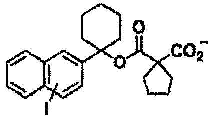

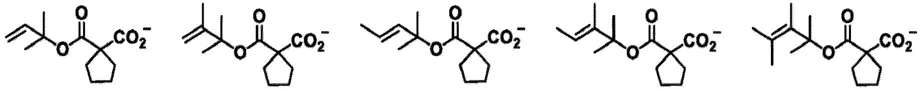

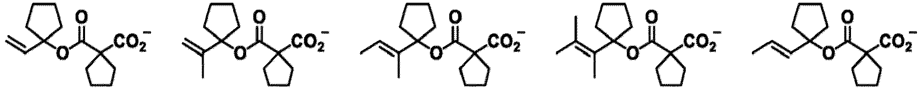

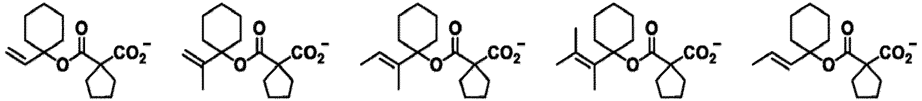

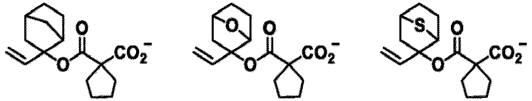

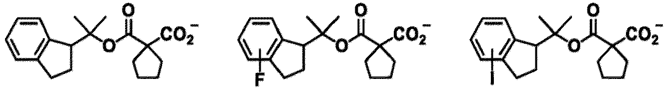

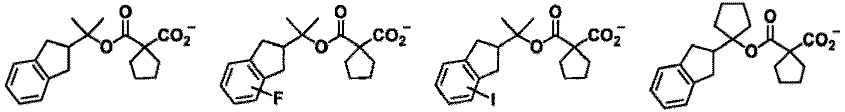

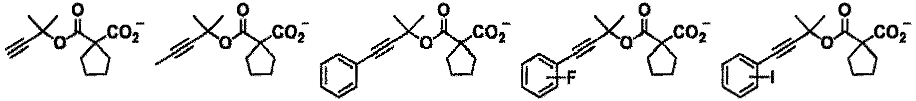

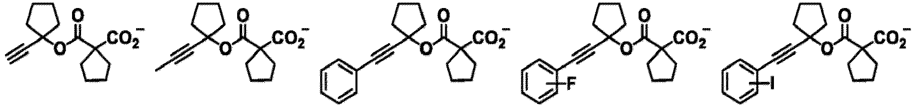

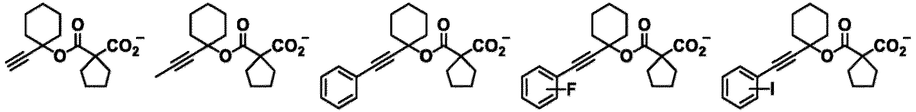

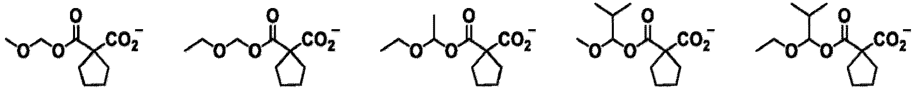

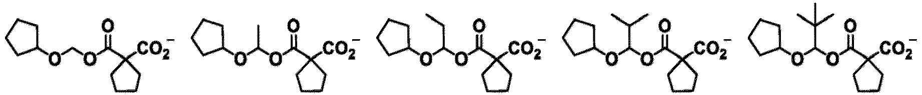

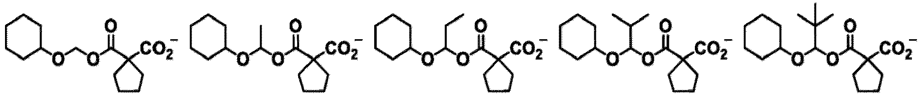

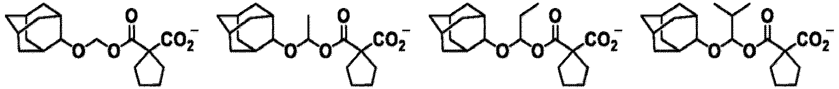

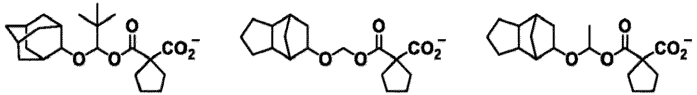

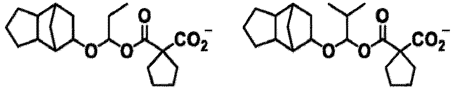

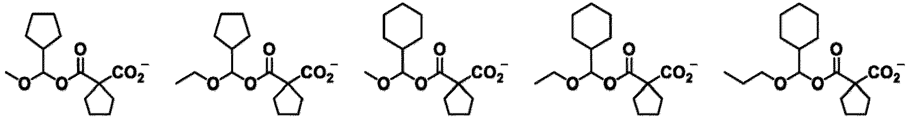

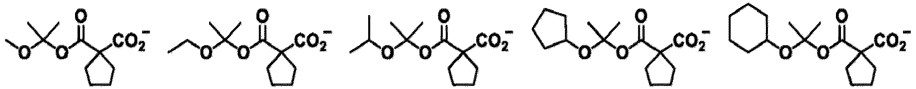

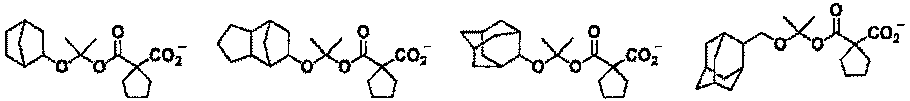

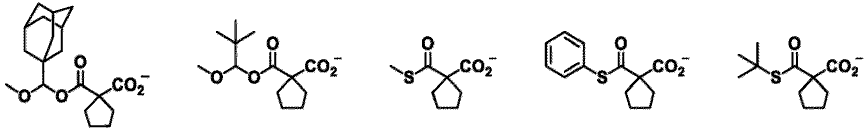

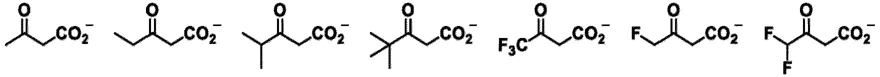

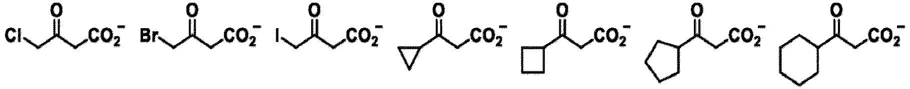

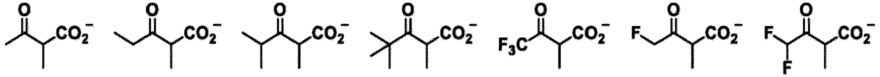

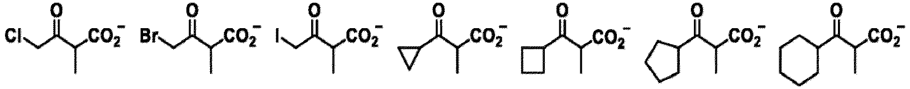

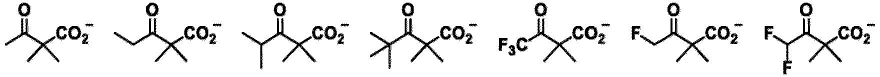

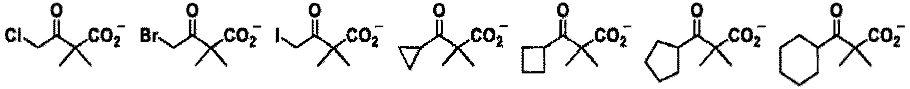

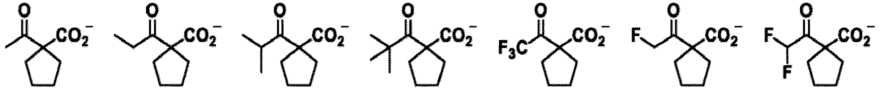

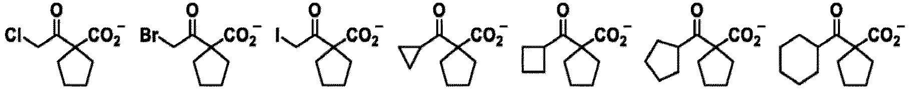

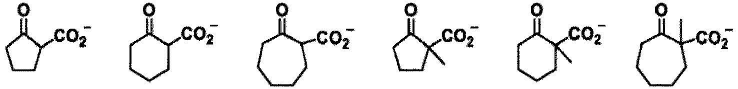

In formula (A1), Z⁺ is an onium cation, preferably a sulfonium cation having the formula (cation-1), an iodonium cation having the formula (cation-2) or an ammonium cation having the formula (cation-3).

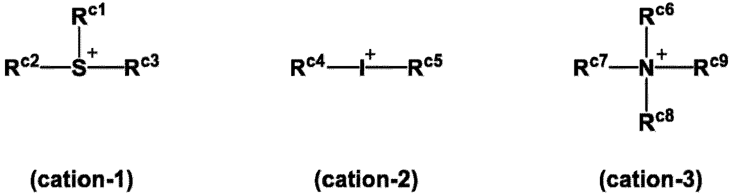

In formulae (cation-1) to (cation-3), R^{c1} to R^{c9} are each independently halogen or a C₁-C₃₀ hydrocarbyl group which may contain a heteroatom. Suitable halogen atoms include fluorine, chlorine, bromine, and iodine. The hydrocarbyl group may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl and thienyl; C₇-C₃₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen and some constituent -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonic ester bond, carbonate bond, lactone ring, sultone ring, carboxylic anhydride (-C(=O)-O-C(=O)-), or haloalkyl moiety.

Also, R^{c1} and R^{c2} may bond together to form a ring with the sulfur atom to which they are attached. Examples of the sulfonium cation having formula (cation-1) wherein R¹¹ and R¹² form a ring are shown below.

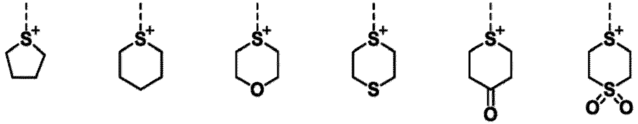

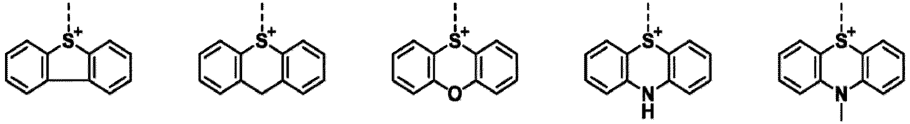

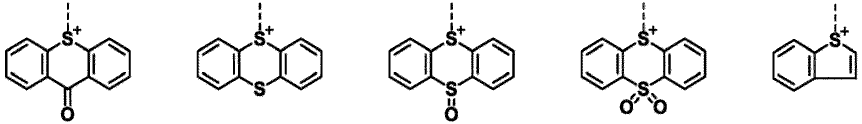

Herein the broken line designates a point of attachment to R^{c3}.

Examples of the sulfonium cation having formula (cation-1) are shown below, but not limited thereto.

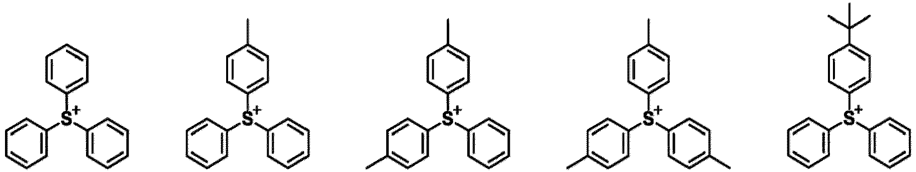

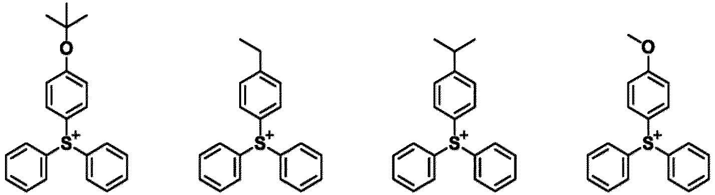

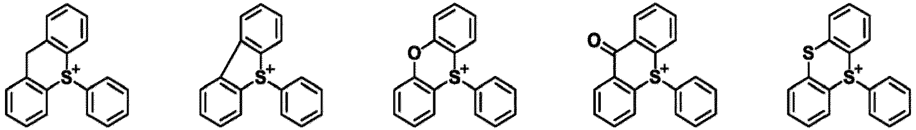

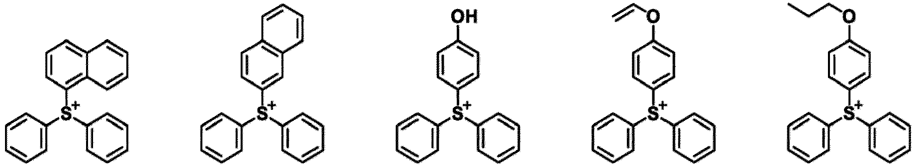

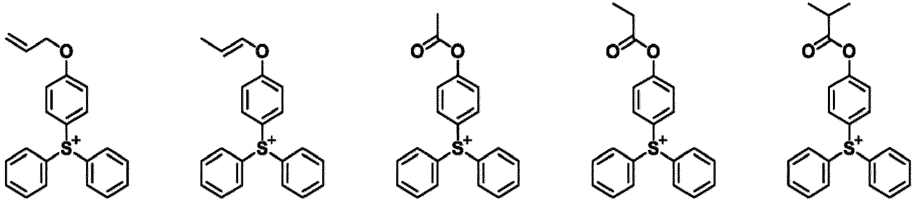

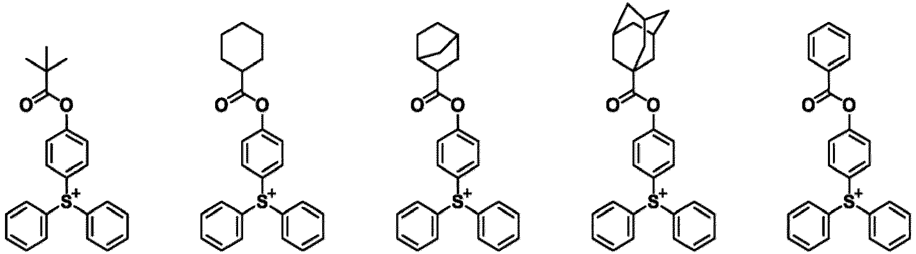

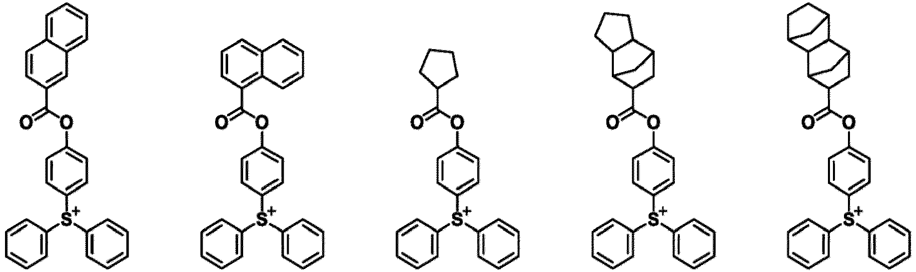

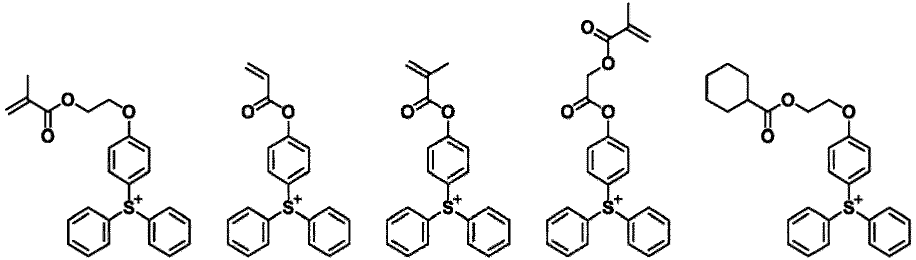

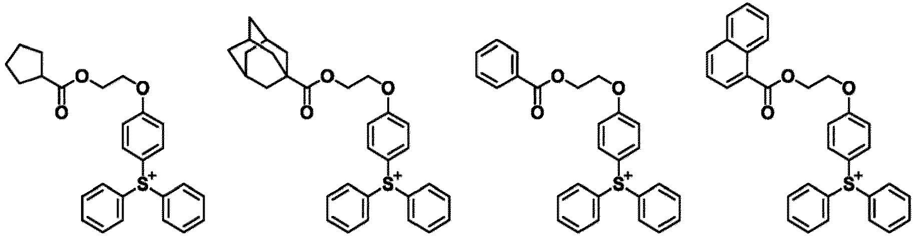

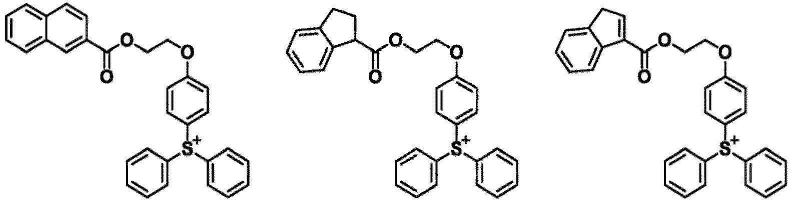

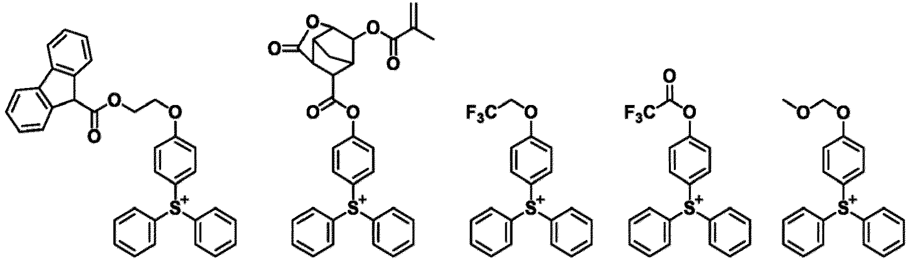

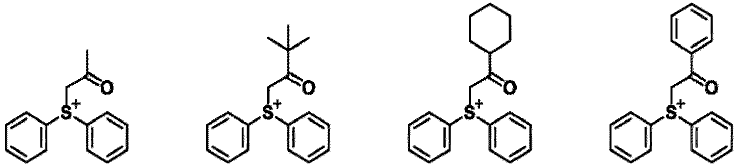

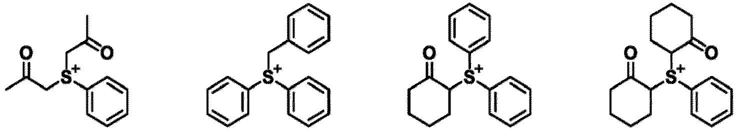

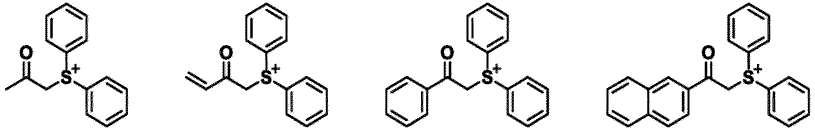

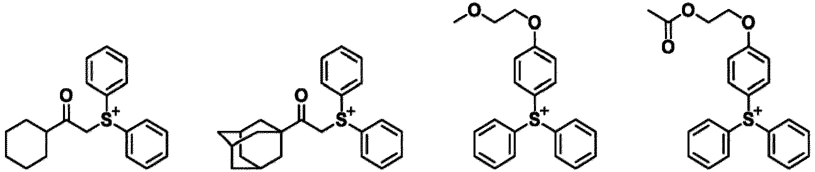

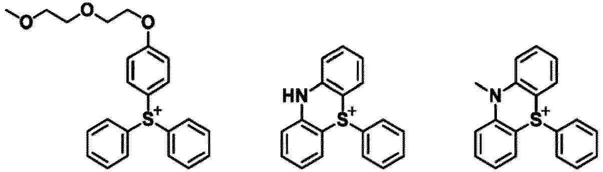

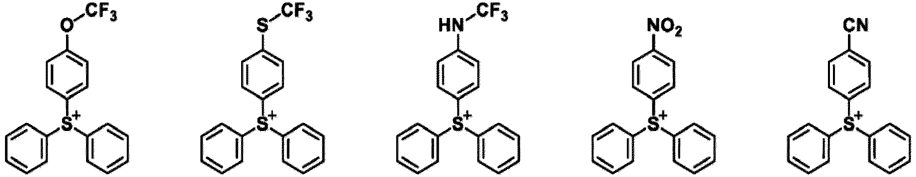

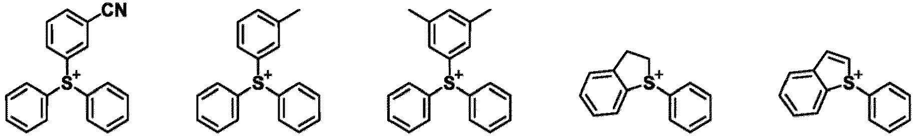

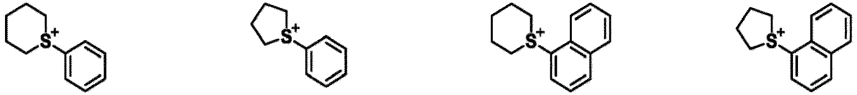

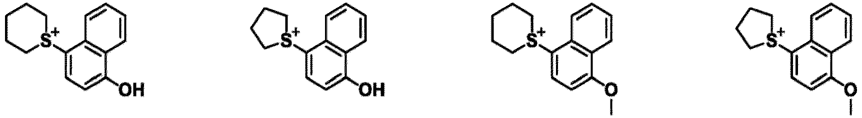

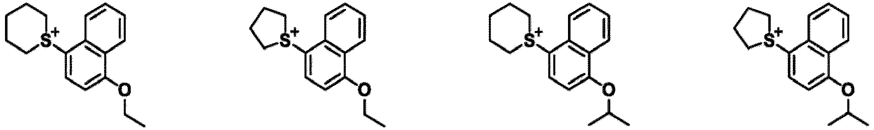

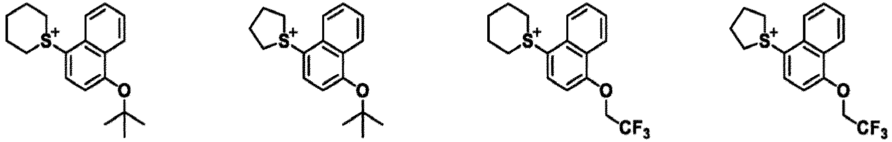

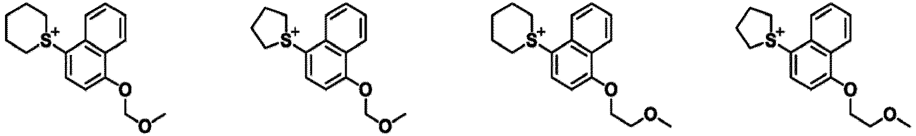

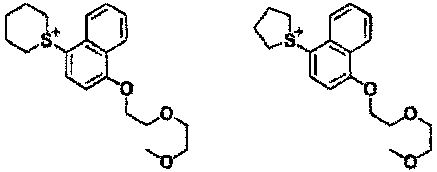

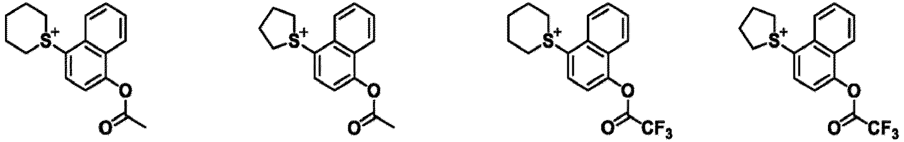

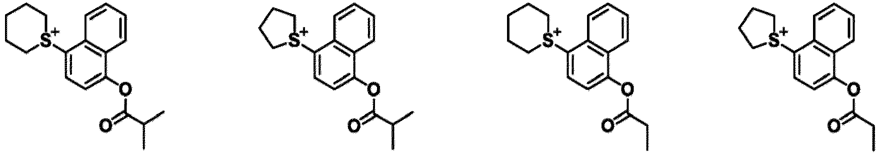

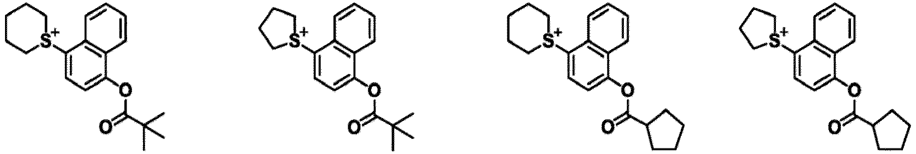

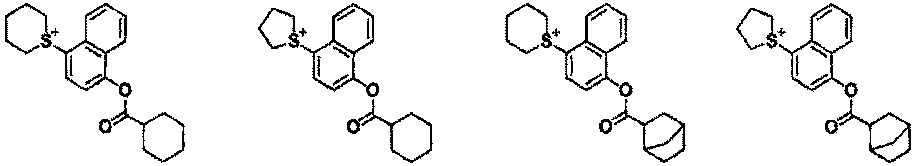

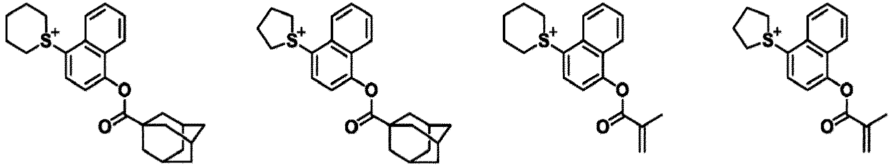

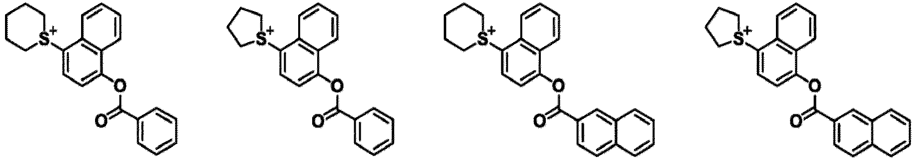

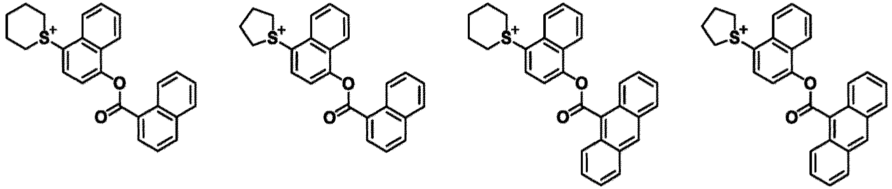

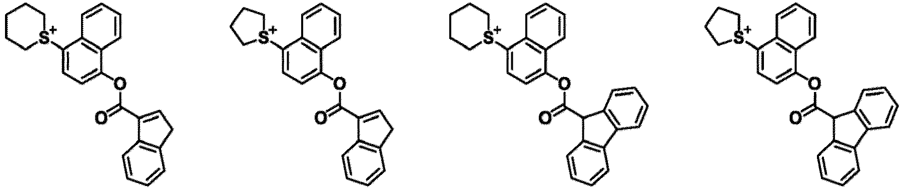

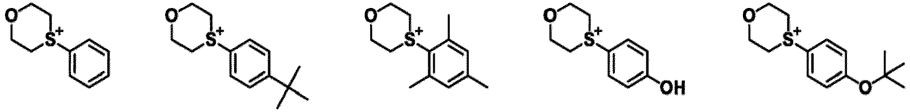

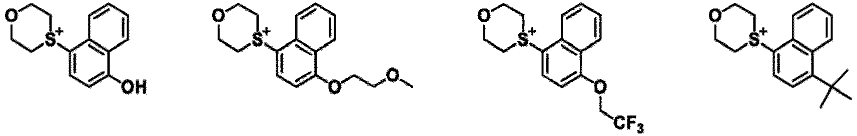

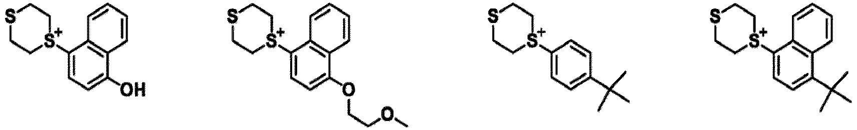

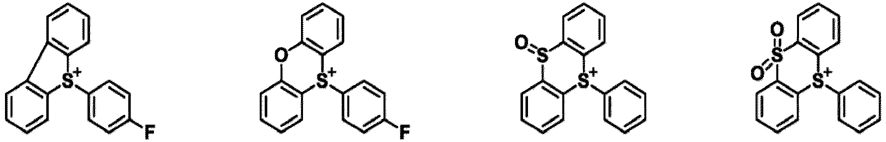

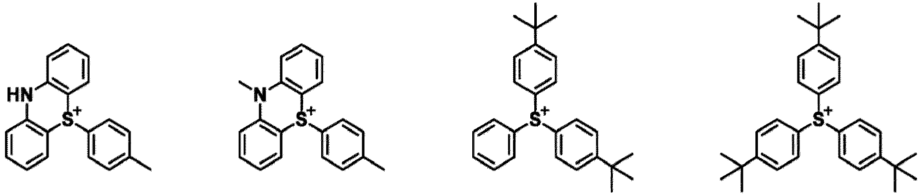

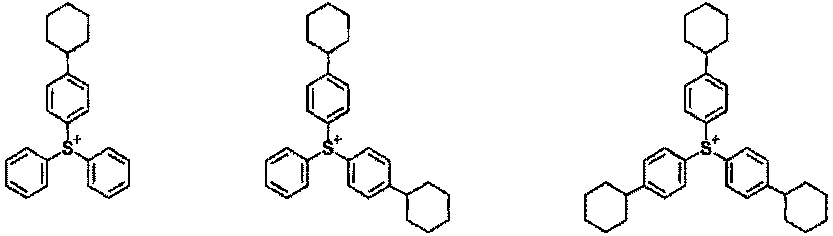

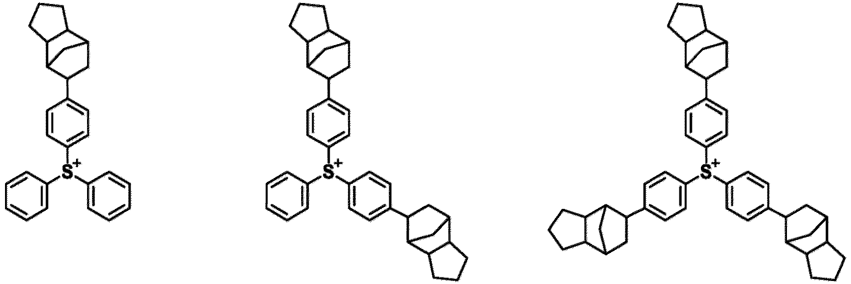

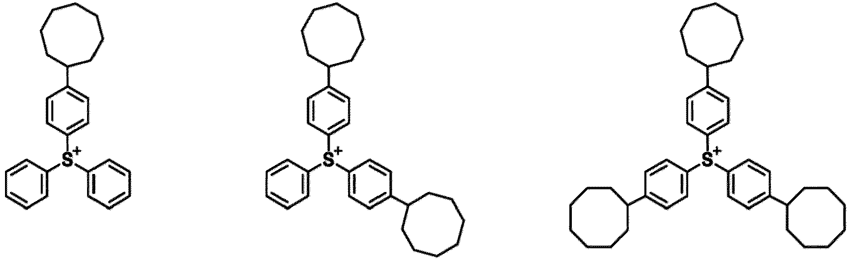

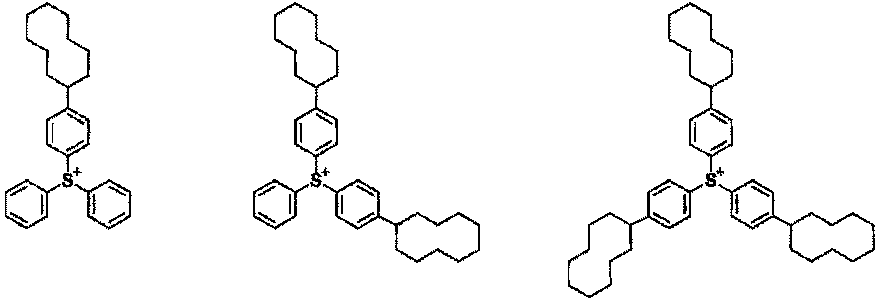

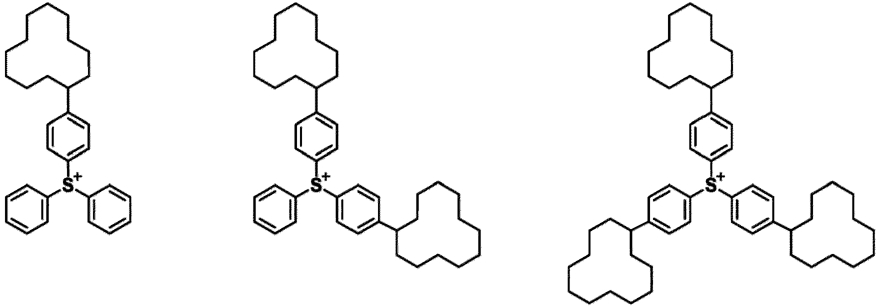

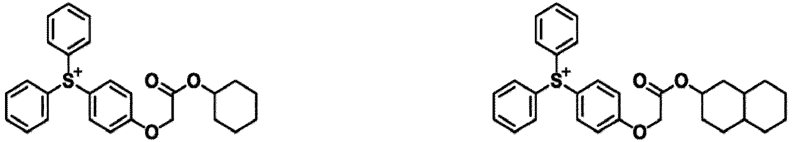

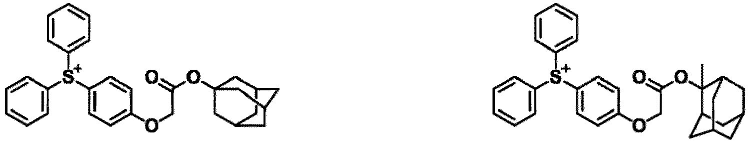

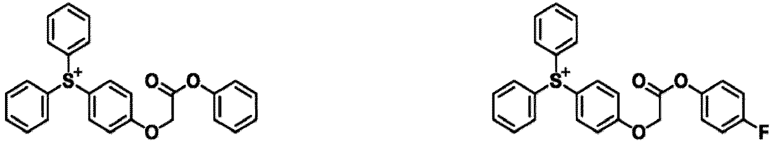

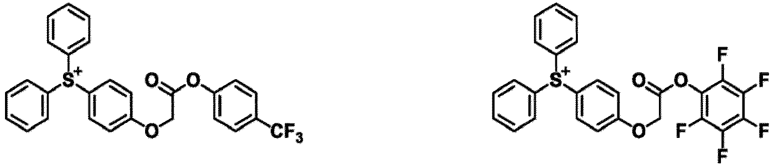

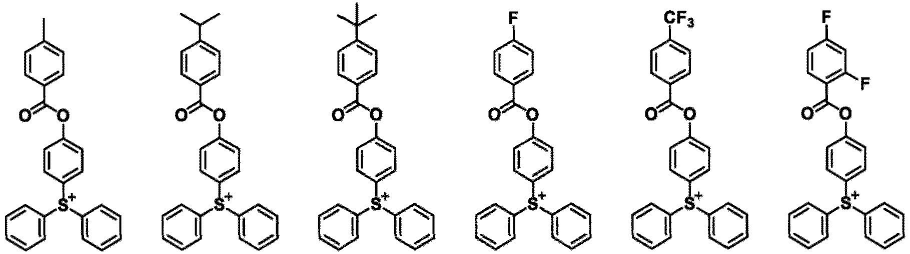

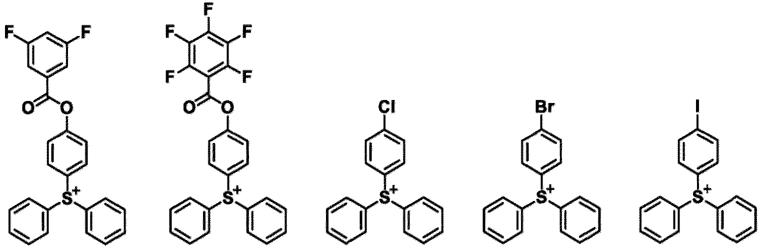

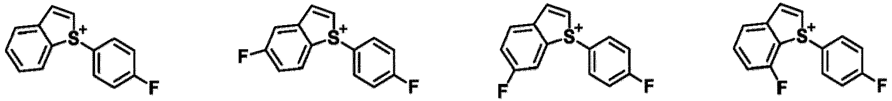

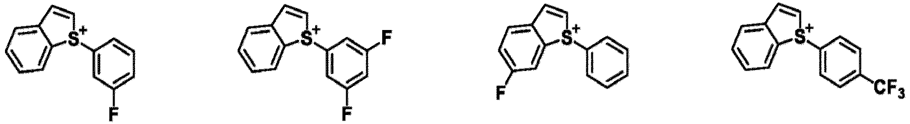

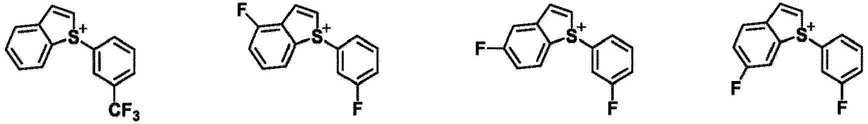

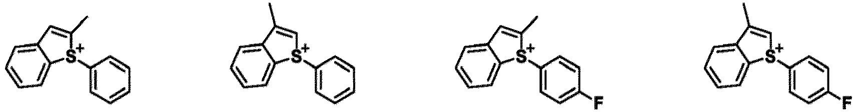

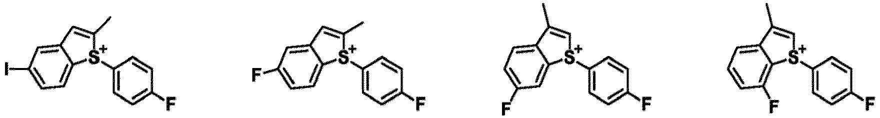

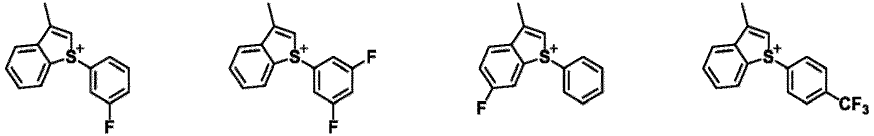

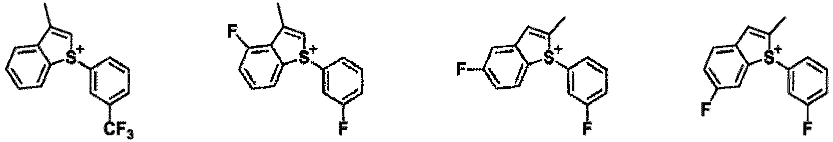

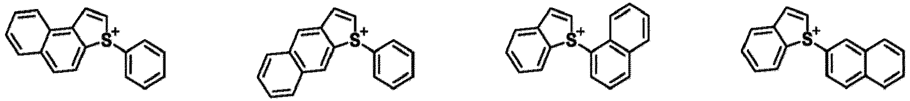

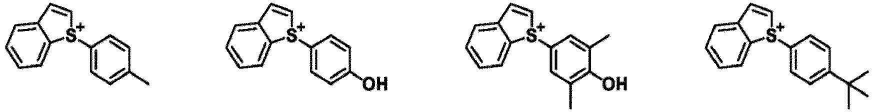

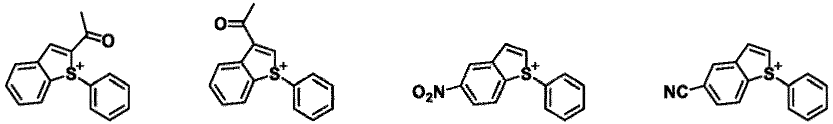

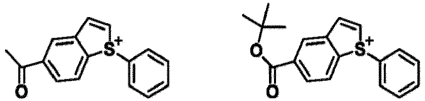

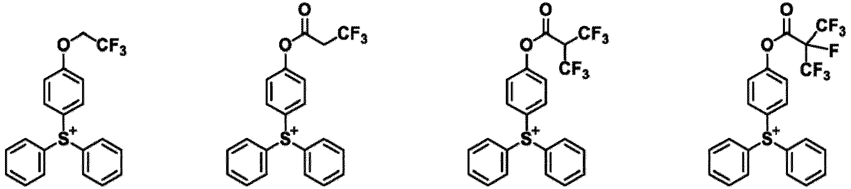

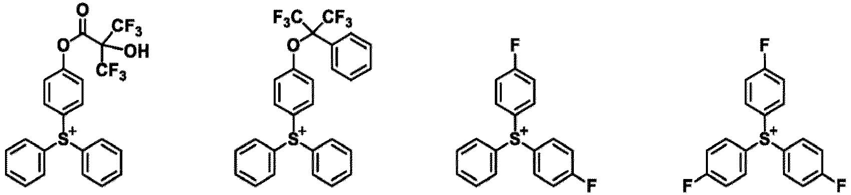

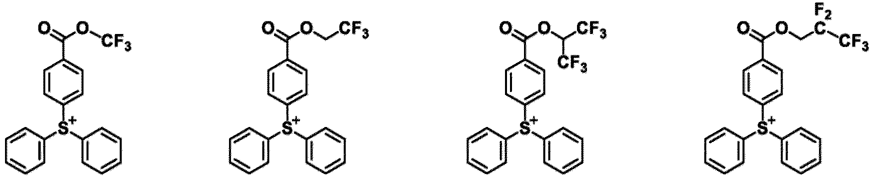

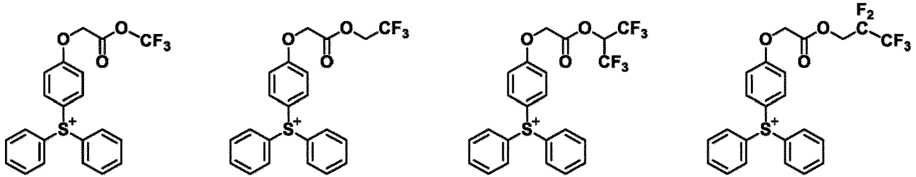

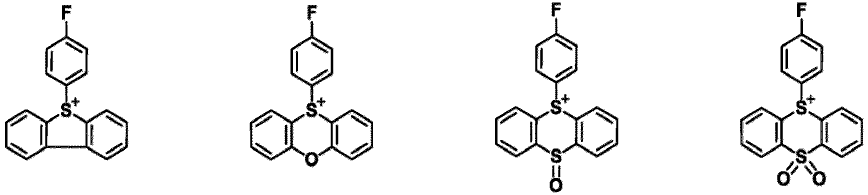

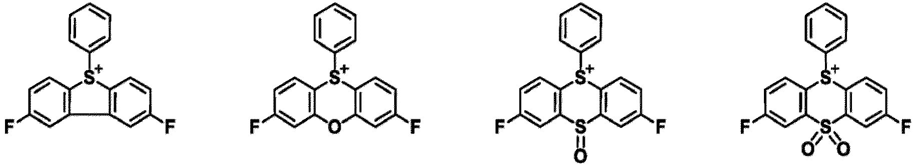

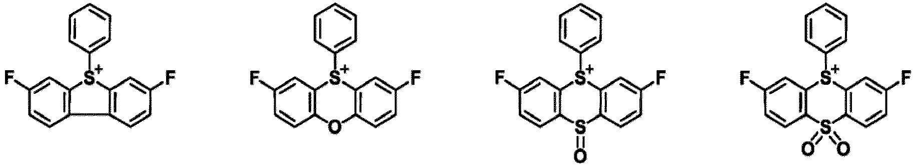

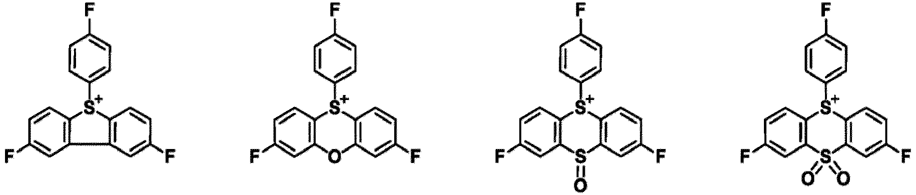

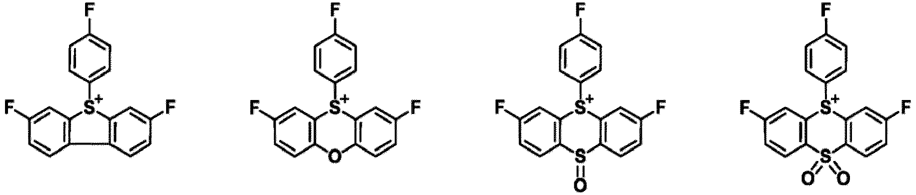

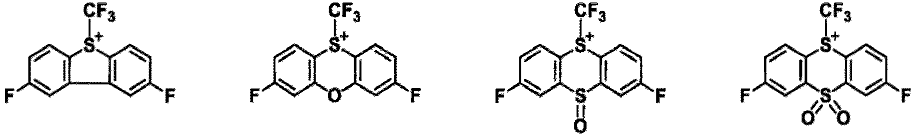

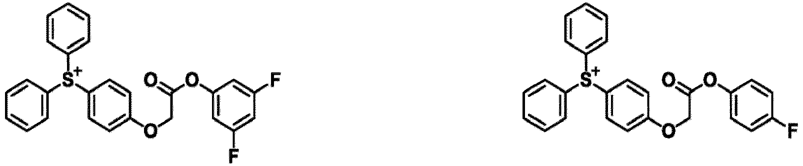

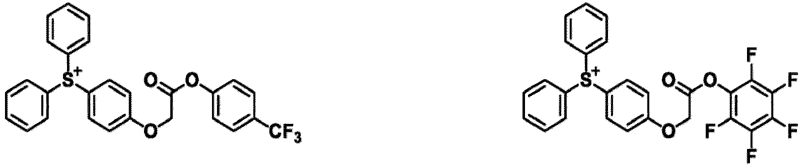

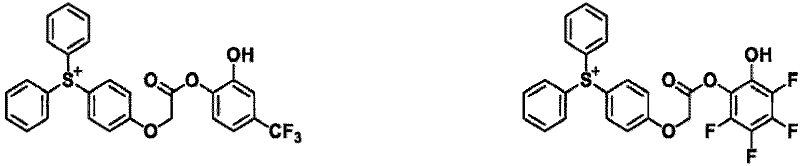

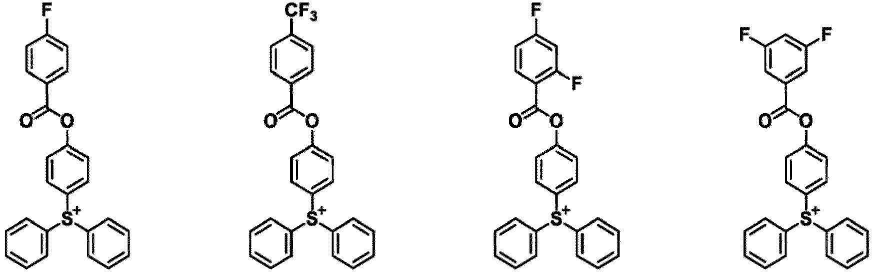

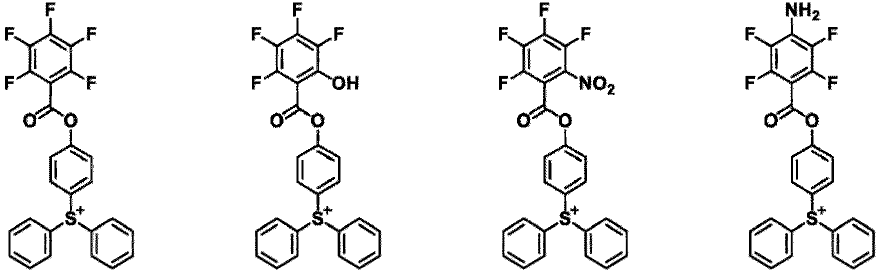

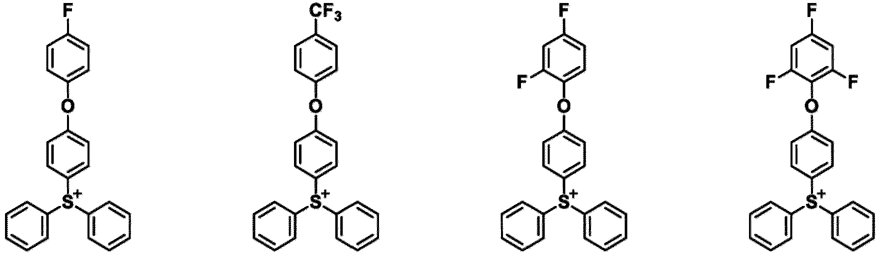

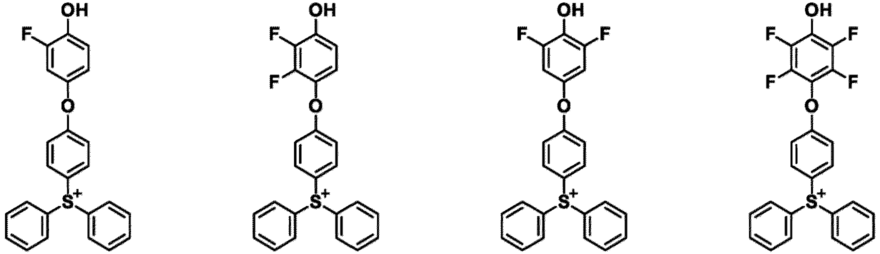

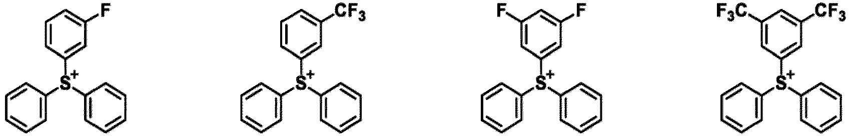

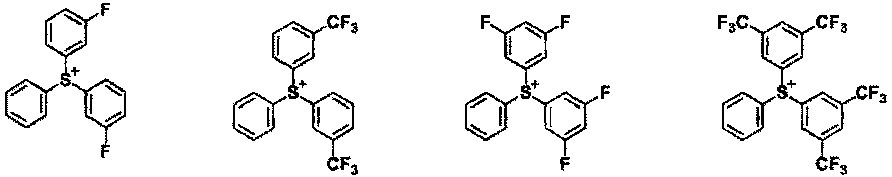

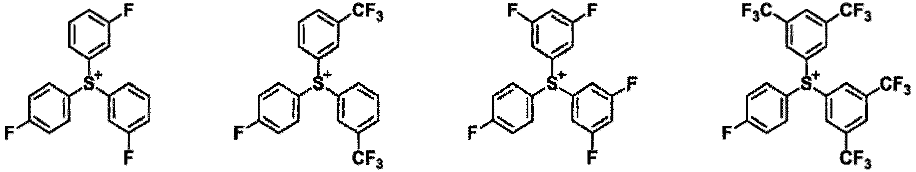

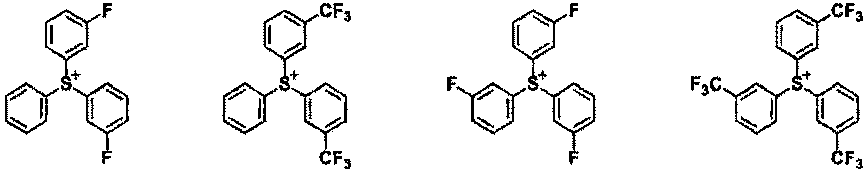

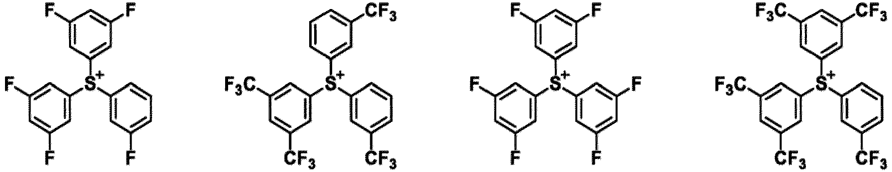

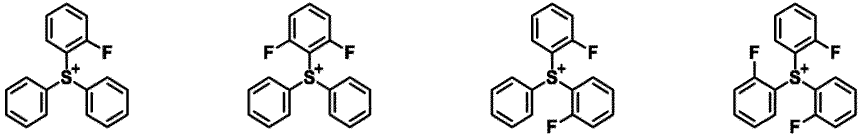

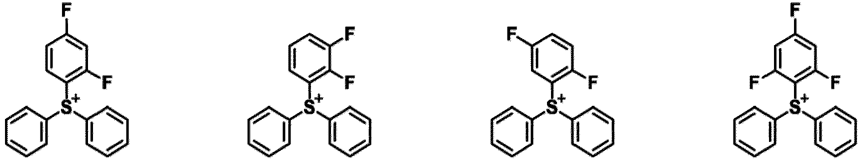

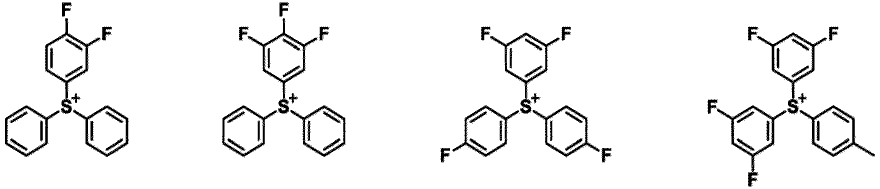

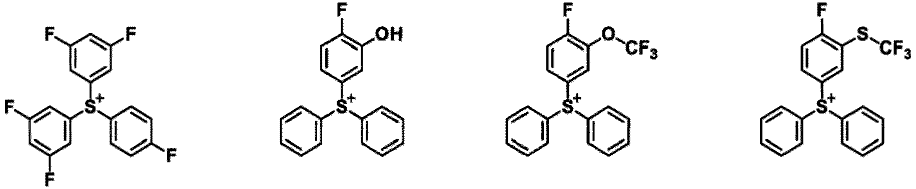

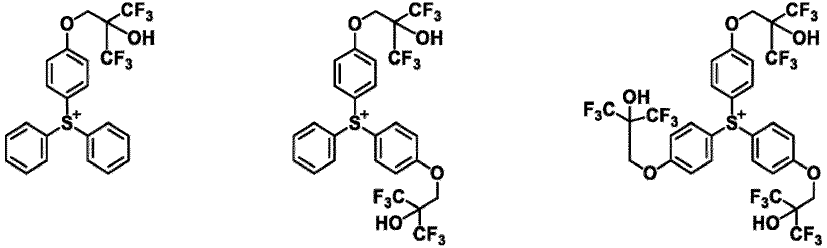

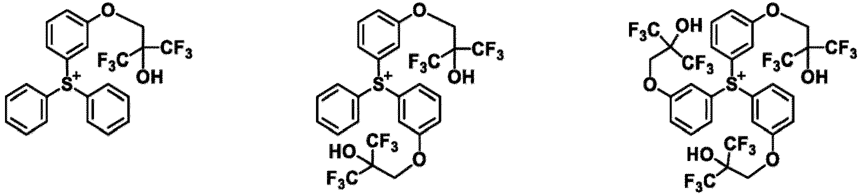

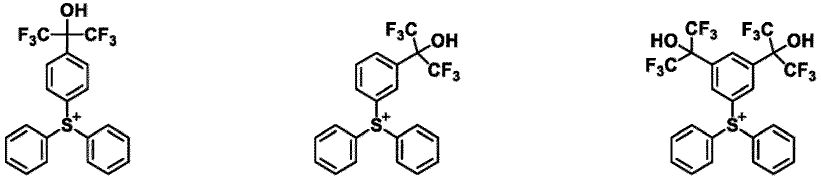

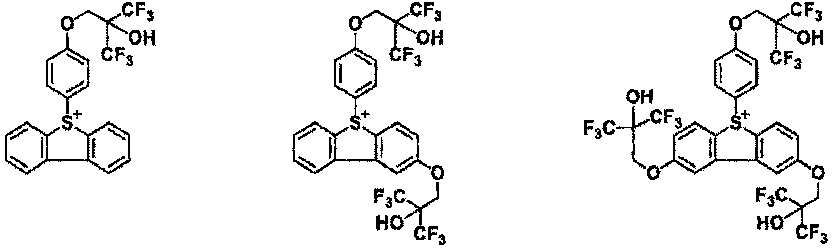

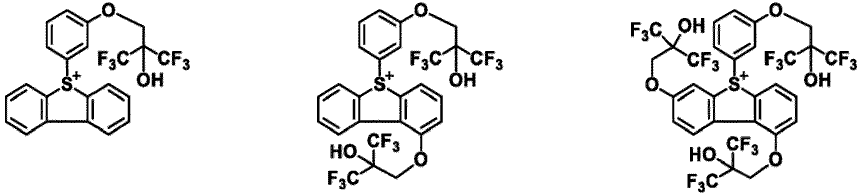

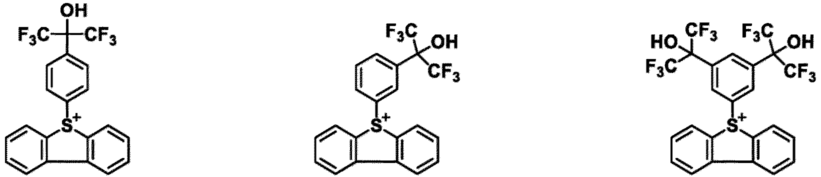

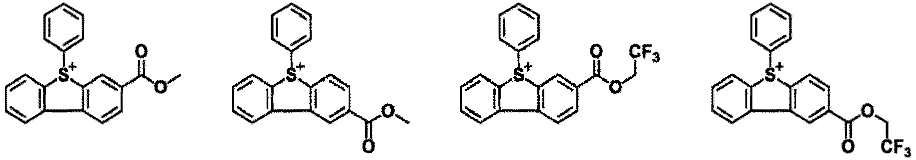

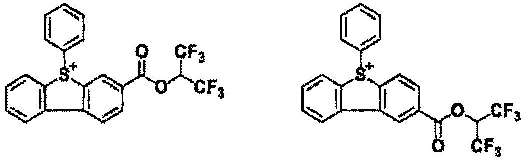

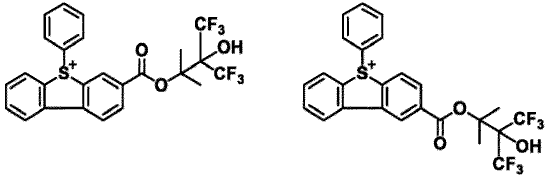

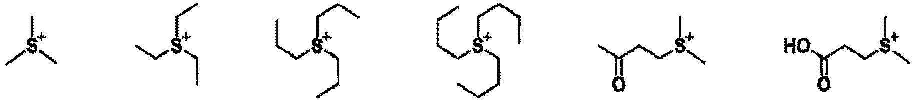

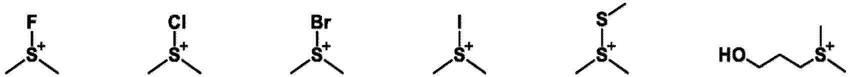

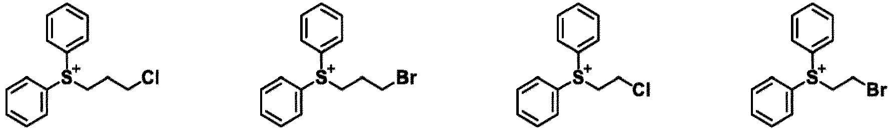

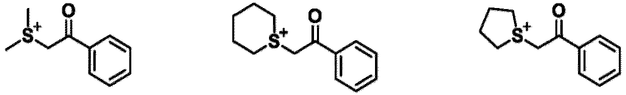

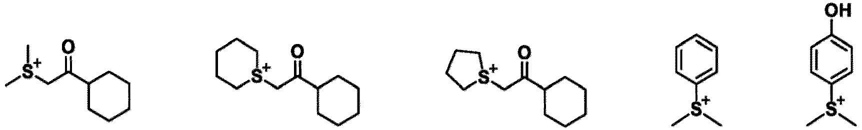

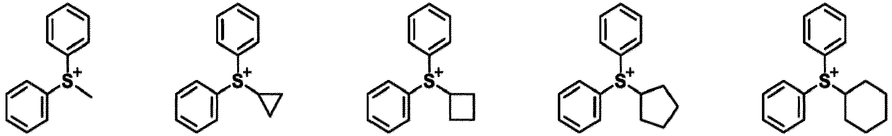

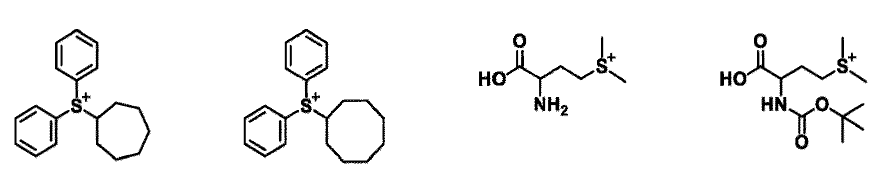

Examples of the iodonium cation having formula (cation-2) are shown below, but not limited thereto.

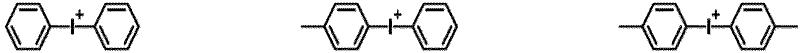

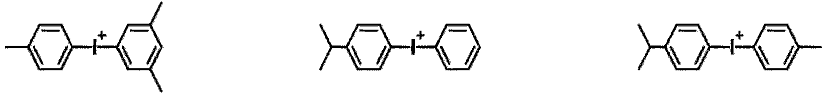

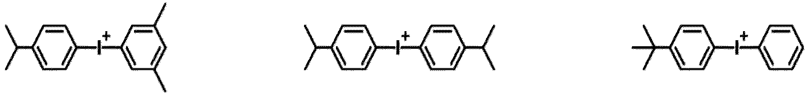

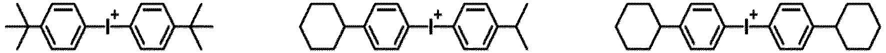

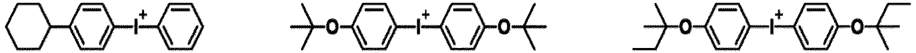

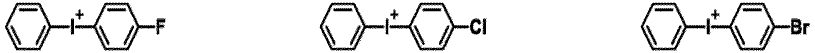

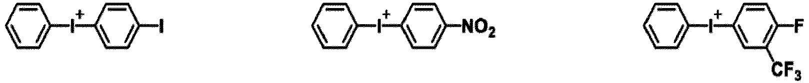

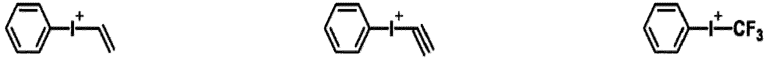

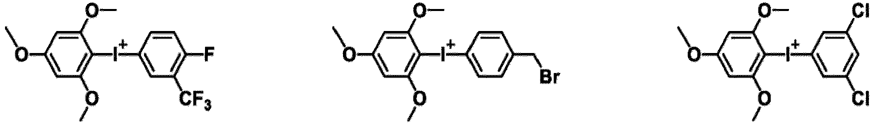

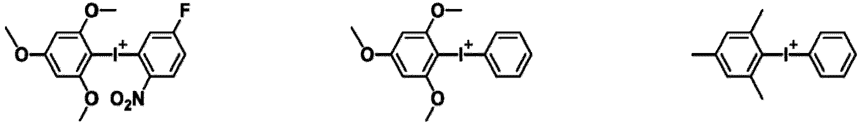

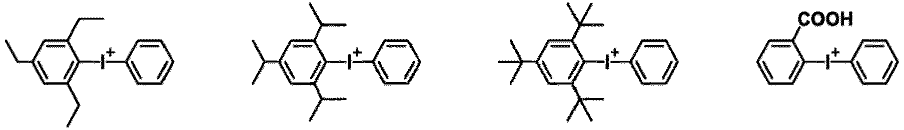

Examples of the ammonium cation having formula (cation-3) are shown below, but not limited thereto.

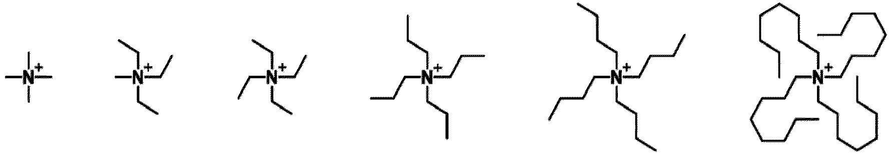

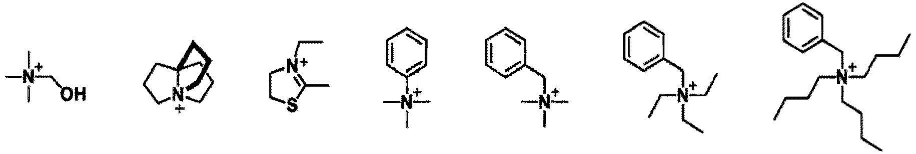

Specific structures of the inventive onium salt include arbitrary combinations of the anion with the cation, both as exemplified above.

The onium salt having formula (A1) may be synthesized, for example, according to the following scheme. Although reference is now made to the synthesis of onium salt (A1') wherein X is oxygen, the synthesis method is not limited thereto.

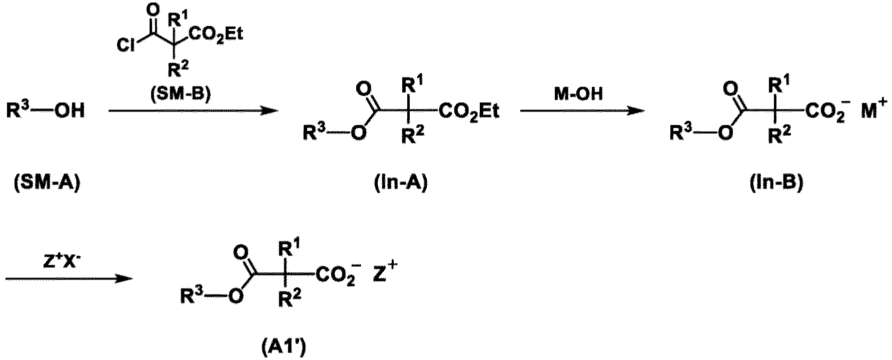

Herein, R¹ to R³ and Z⁺ are as defined above, Et stands for ethyl, M⁺ is a metal cation, and X⁻ is an anion.

First, a starting alcohol (SM-A) is esterified by reacting it with an acid chloride (SM-B). The starting alcohol (SM-A) is dissolved in a solvent such as tetrahydrofuran (THF) or acetonitrile, to which the acid chloride (SM-B) is added dropwise in the presence of a base such as pyridine or 2,6-lutidine. The reaction may be promoted by heating if necessary. While it is desirable in view of yield to monitor the reaction by gas chromatography (GC) or silica gel thin layer chromatography (TLC) until the reaction is complete, the reaction time is typically about 2 to 24 hours. The intermediate (In-A) may be collected from the reaction mixture by standard aqueous work-up. If necessary, the intermediate is purified by a standard technique such as distillation, chromatography or recrystallization.

Next, the intermediate (In-A) is subjected to alkaline hydrolysis using a metal hydroxide: M-OH, to synthesize an intermediate (In-B). The intermediate (In-A) is dissolved in a solvent such as THF or acetonitrile, to which an aqueous solution of metal hydroxide: M-OH is added dropwise for alkaline hydrolysis. Examples of the metal hydroxide used herein include sodium hydroxide, potassium hydroxide, and lithium hydroxide. The reaction may be promoted by heating if necessary. While it is desirable in view of yield to monitor the reaction by silica gel TLC until the reaction is complete, the reaction time is typically about 2 to 24 hours. The intermediate (In-B) may be collected from the reaction mixture by standard aqueous work-up. If necessary, the intermediate is purified by a standard technique such as chromatography or recrystallization.

The final step is a salt exchange between the intermediate (In-B) and an onium salt: Z⁺X⁻ to synthesize an onium salt (A1'). Preferably X⁻ is a hydrogencarbonate ion, chloride ion or bromide ion because the exchange reaction runs quantitatively.

In the above-illustrated scheme, the third step of ion exchange may be readily carried out by any well-known procedure, for example, with reference to JP-A 2007-145797.

It is noted that the preparation method according to the above scheme is merely exemplary and the method of preparing the inventive onium salt is not limited thereto.

Another exemplary method of synthesizing the onium salt having formula (A1) is an ion exchange between a carboxylic acid having the anion in formula (A1) and an onium salt of a weaker acid than the carboxylic acid. Typical of the weaker acid than the carboxylic acid is carbonic acid. An alternative route of synthesis is an ion exchange between a sodium salt of a carboxylic acid having the anion in formula (A1) and a sulfonium chloride.

The onium salt having formula (A1) functions as a quite effective quencher when applied to chemically amplified negative resist compositions.

The onium salt of the structure defined herein functions as a quencher through the mechanism that it effectively traps the strong acid generated by the acid generator and converts to a 1,3-dicarboxylic acid monoester or 1,3-keto carboxylic acid structure. In the onium salt of formula (A1) wherein R³ forms an acid labile group with the adjacent oxygen atom, the acid labile group is eliminated as a result of reaction with a strong acid whereby the resist film is improved in sensitivity, and a 1,3-dicarboxylic acid (e.g., malonic acid) structure forms. The 1,3-dicarboxylic acid monoester, 1,3-keto carboxylic acid and 1,3-dicarboxylic acid undergo thermal decarbonation reaction during the subsequent step of PEB whereby they are decomposed into carbon dioxide and a corresponding acetic acid derivative or ketone derivative, which volatilize off the resist film. In the subsequent development step in alkaline developer, the carboxylic acid having a high affinity to the alkaline developer has been eliminated. This prevents the resist film from being swollen. In the unexposed region, the onium salt remains intact and has a high affinity to the alkaline developer. As a result, the dissolution contrast is improved. Accordingly, the onium salt of formula (A1) is best suited for application in chemically amplified negative resist compositions.

In the resist composition, the quencher (A) in the form of the onium salt having formula (A1) is preferably used in an amount of 0.1 to 20 parts by weight, more preferably 1 to 15 parts by weight per 80 parts by weight of the base polymer (B) described below. An amount of the onium salt having formula (A1) in the range ensures a satisfactory quenching function, eliminating the risk of lowering sensitivity or leaving foreign particles due to shortage of solubility. The onium salt having formula (A1) may be used alone or in admixture of two or more.

### (B) Base polymer

The resist composition also comprises (B) a base polymer. The base polymer contains a polymer comprising repeat units having the formula (B1). The polymer and repeat unit are simply referred to as polymer B and repeat unit B1, respectively. The repeat units B1 provide for etching resistance, adhesion to the substrate, and solubility in alkaline developer.

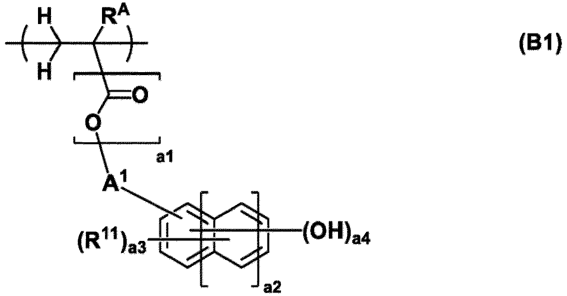

In formula (B1), a1 is 0 or 1. The subscript a2 is an integer of 0 to 2. The structure represents a benzene skeleton when a2=0, a naphthalene skeleton when a2=1, and an anthracene skeleton when a2=2. The subscript a3 is an integer satisfying 0 ≤ a3 ≤ 5+2(a2)-a4, and a4 is an integer of 1 to 3. In case of a2=0, preferably a3 is an integer of 0 to 3, and a4 is an integer of 1 to 3. In case of a2=1 or 2, preferably a3 is an integer of 0 to 4, and a4 is an integer of 1 to 3. In formula (B1), R^{A} is hydrogen, fluorine, methyl or trifluoromethyl.

In formula (B1), R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, n-propyl, isopropyl, butyl, pentyl, hexyl, and structural isomers thereof, cycloalkyl groups such as cyclopropyl, cyclobutyl, cyclopentyl and cyclohexyl, and combinations thereof. A carbon count within the upper limit ensures good solubility in alkaline developer. A plurality of R¹¹ may be identical or different when a3 is 2 or more.

In formula (B1), A¹ is a single bond or C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a1=1 in formula (B1), the ether bond may be incorporated at any position excluding the position between the α-carbon and β-carbon relative to the ester oxygen. In case of a1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the main chain of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. Repeat units having the formula (B1-1) are especially preferred.

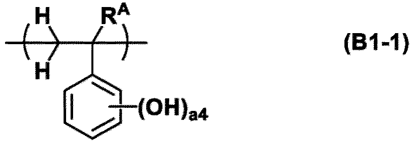

Herein R^{A} and a4 are as defined above.

Preferred examples of the repeat units B1 wherein a1=1, that is, having a linker: - C(=O)-O-A¹- are shown below, but not limited thereto. Herein R^{A} is as defined above.

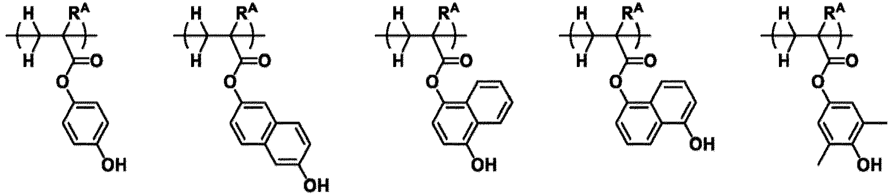

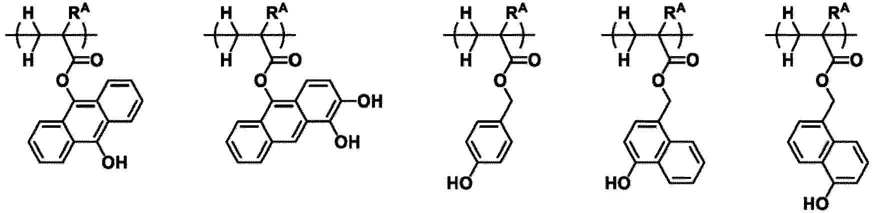

The repeat units B1 may be used alone or in admixture of two or more.

In a preferred embodiment, the polymer B further contains repeat units having the formula (B2), referred to as repeat units B2. The polymer B further containing repeat units B2 is referred to as polymer B', hereinafter.

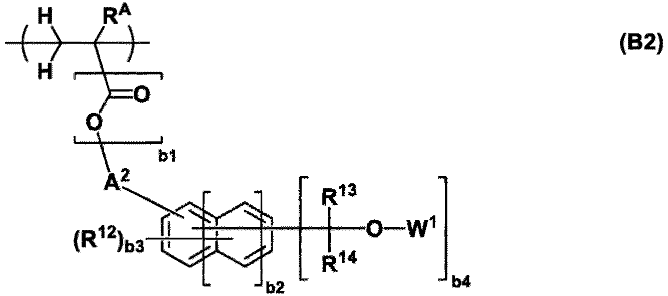

Upon exposure to high-energy radiation, repeat units B2 are such that -O-W¹ undergoes elimination reaction under the action of an acid generated from an acid generator, turning the polymer insoluble in alkaline developer and inducing crosslinking reaction between polymer chains. The repeat units B2 are effective for efficiently driving forward negative-turning reaction and improving resolution performance.

In formula (B2), b1 is 0 or 1, b2 is an integer of 0 to 2, b3 is an integer meeting 0 ≤ b3 <_ 5+2(b2)-b4, and b4 is an integer of 1 to 3.

In formula (B2), R^{A} is hydrogen, fluorine, methyl or trifluoromethyl.

In formula (B2), R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, n-propyl, isopropyl, butyl, pentyl, hexyl, and structural isomers thereof, cycloalkyl groups such as cyclopropyl, cyclobutyl, cyclopentyl and cyclohexyl, and combinations thereof. A plurality of R¹² may be identical or different when b3 is 2 or more.

In formula (B2), R¹³ and R¹⁴ are each independently hydrogen, a C₁-C₁₅ saturated hydrocarbyl group which may be substituted with a hydroxy or saturated hydrocarbyloxy moiety, or an optionally substituted aryl group. Notably, R¹³ and R¹⁴ are not hydrogen at the same time. R¹³ and R¹⁴ may bond together to form a ring with the carbon atom to which they are attached. Preferred examples of R¹³ and R¹⁴ include alkyl groups such as methyl, ethyl, propyl, butyl and structural isomers thereof, and substituted forms of the foregoing in which some hydrogen is substituted by hydroxy or saturated hydrocarbyloxy moiety.

In formula (B2), A² is a single bond or a C₁-C₁₀ saturated hydrocarbylene group in which some constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b1=1 in formula (B2), the ether bond may be incorporated at any position excluding the position between the α-carbon and β-carbon relative to the ester oxygen. In case of b1=0, the atom that bonds with the main chain becomes an ethereal oxygen, and a second ether bond may be incorporated at any position excluding the position between the α-carbon and β-carbon relative to that ethereal oxygen.

In formula (B2), W¹ is hydrogen, a C₁-C₁₀ aliphatic hydrocarbyl group or an optionally substituted aryl group. The aliphatic hydrocarbyl group may be straight, branched or cyclic and examples thereof include alkyl groups such as methyl, ethyl, propyl, and isopropyl, and cyclic aliphatic hydrocarbyl groups such as cyclopentyl, cyclohexyl and adamantyl. Typical of the aryl group is phenyl. In the aliphatic hydrocarbyl group, some constituent -CH₂- may be replaced by -O-, -C(=O)-, -O-C(=O)- or -C(=O)-O-. It is noted that -CH₂- in the hydrocarbyl group may bond to the oxygen atom in formula (B2). Typical of the substituted hydrocarbyl group is methylcarbonyl.

The preferred repeat units B2 include units having the formulae (B2-1) and (B2-2).

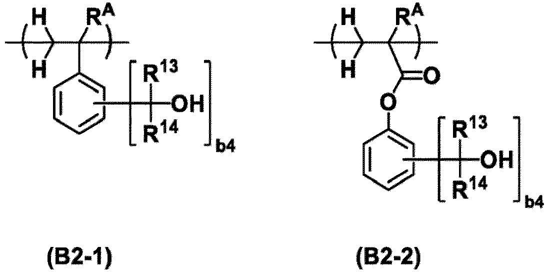

Herein, b4, R^{A}, R¹³ and R¹⁴ are as defined above.

Preferred examples of repeat unit B2 are shown below, but not limited thereto. R^{A} is as defined above.

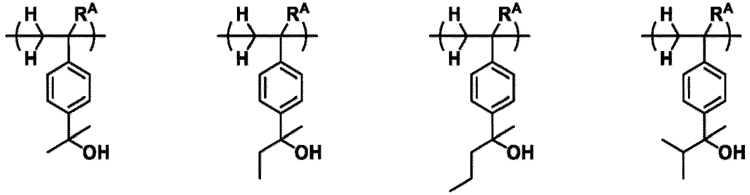

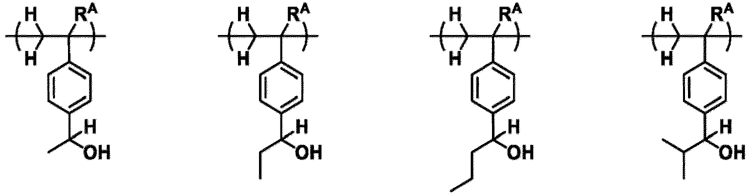

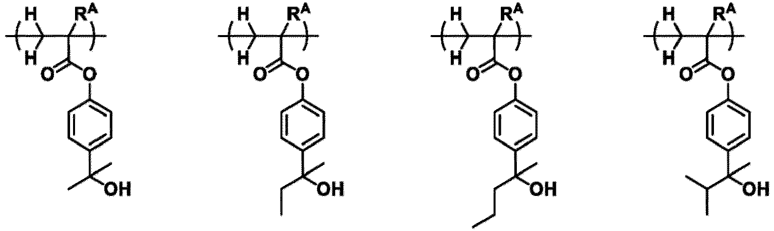

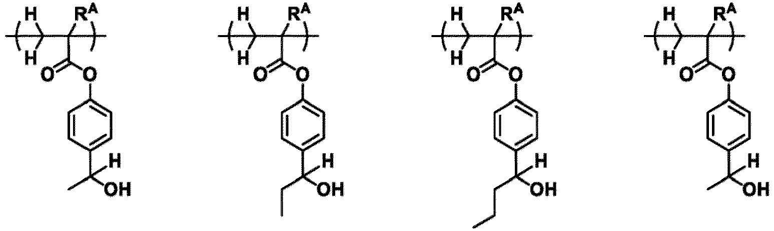

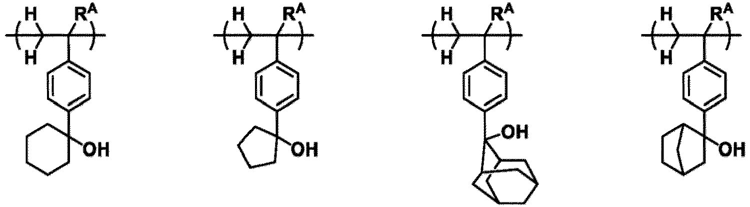

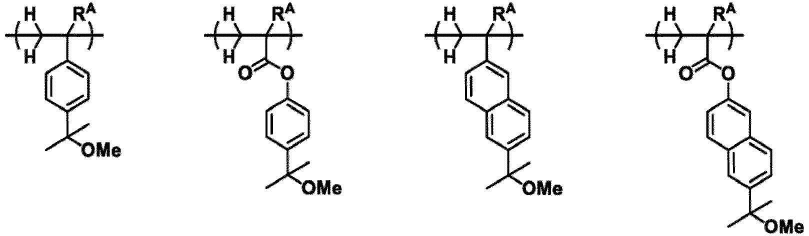

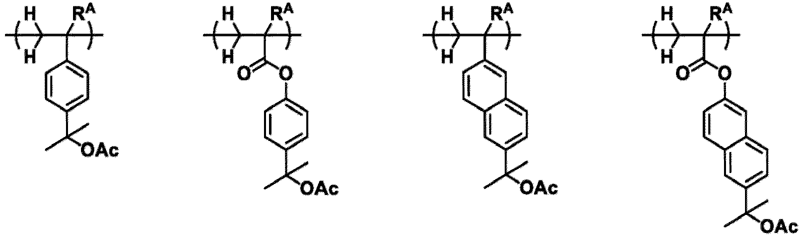

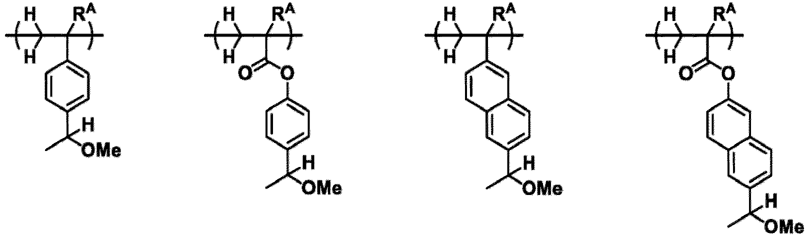

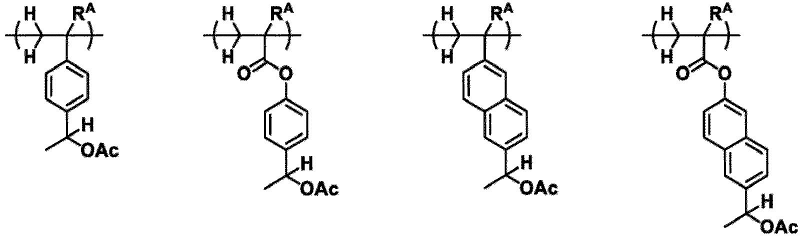

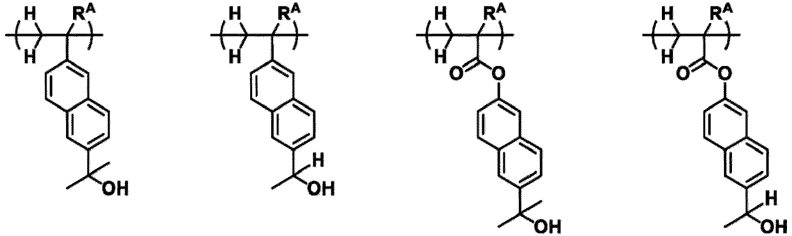

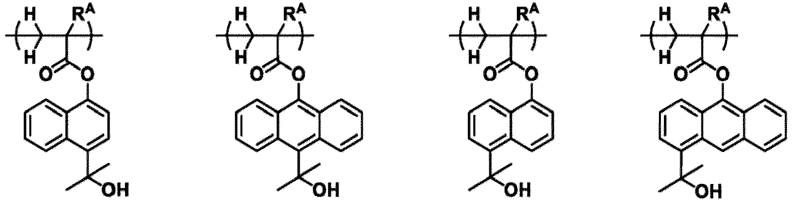

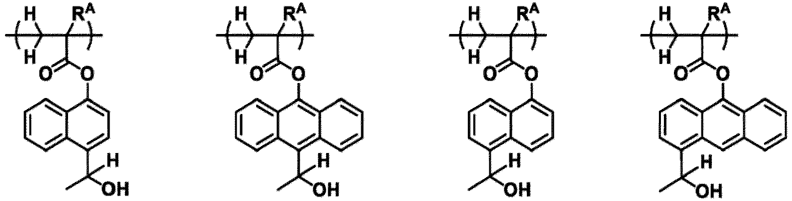

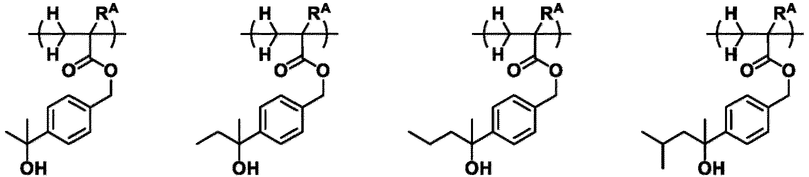

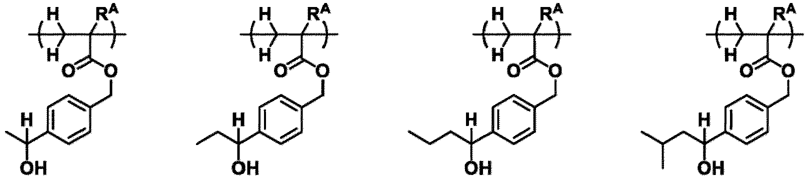

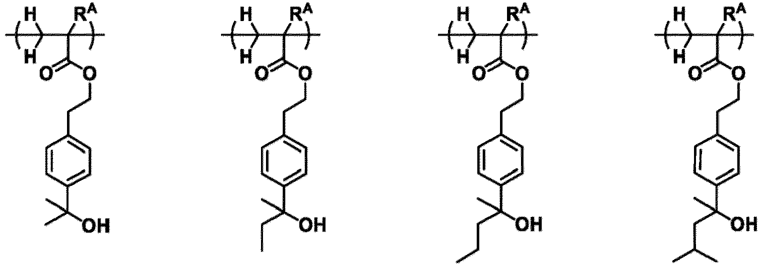

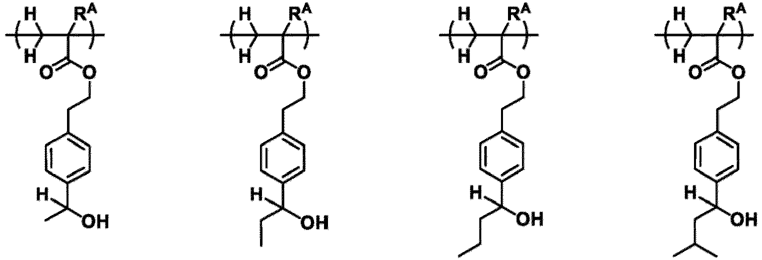

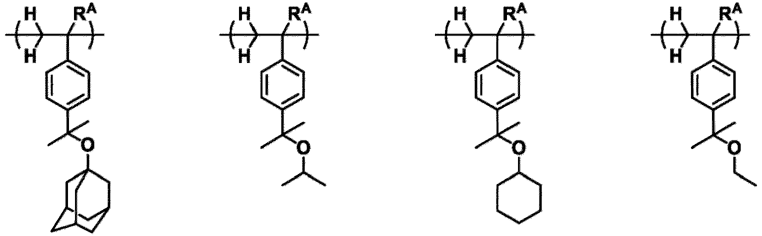

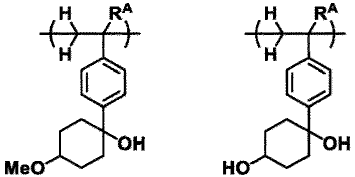

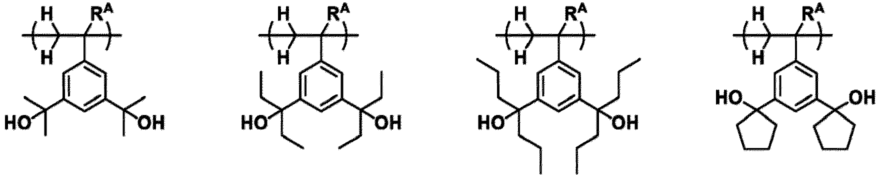

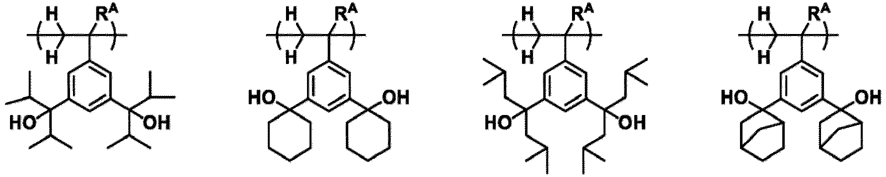

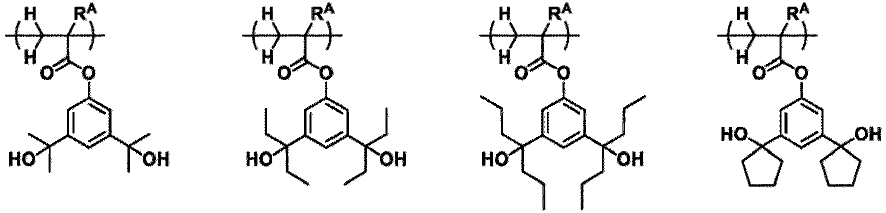

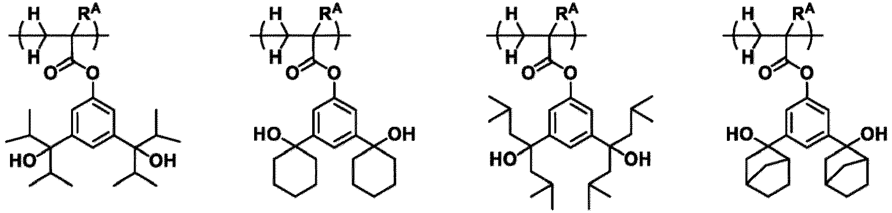

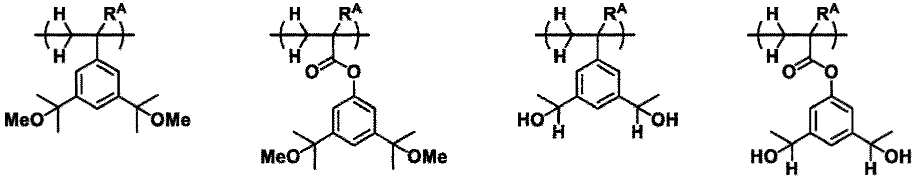

The repeat units B2 may be used alone or in admixture of two or more.

In a preferred embodiment, the polymer B or B' further comprises repeat units of at least one type selected from units having the formulae (B3), (B4) and (B5) for the purpose of enhancing etch resistance. These repeat units are simply referred to as repeat units B3, B4 and B5, respectively.

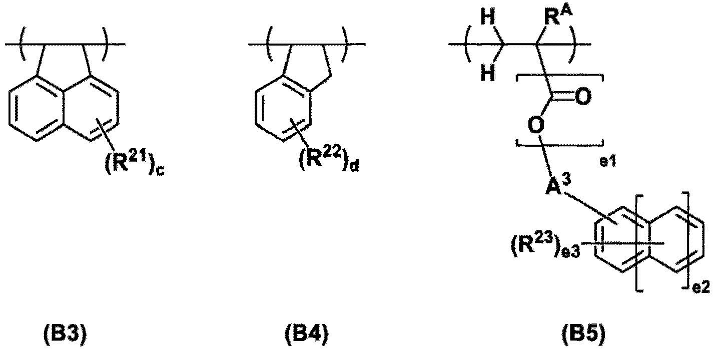

In formulae (B3) and (B4), c and d are each independently an integer of 0 to 4.

In formulae (B3) and (B4), R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group and saturated hydrocarbylcarbonyloxy group may be straight, branched or cyclic. When c is 2 or more, a plurality of groups R²¹ may be identical or different. When d is 2 or more, a plurality of groups R²² may be identical or different.

In formula (B5), e1 is 0 or 1. The subscript e2 is an integer of 0 to 2, and the corresponding structure represents a benzene skeleton when e2=0, a naphthalene skeleton when e2=1, and an anthracene skeleton when e2=2. The subscript e3 is an integer of 0 to 5. In case of e2=0, preferably e3 is an integer of 0 to 3. In case of e2=1 or 2, preferably e3 is an integer of 0 to 4.

In formula (B5), R^{A} is hydrogen, fluorine, methyl or trifluoromethyl.

In formula (B5), R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group and saturated hydrocarbylsulfonyl group may be straight, branched or cyclic. When e3 is 2 or more, a plurality of groups R²³ may be identical or different.

R²³ is preferably selected from halogen atoms such as chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are most useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B5), A⁴ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of e1=1 in formula (B5), the ether bond may be incorporated at any position excluding the position between the α- and β-carbons relative to the ester oxygen. In case of e1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B5 wherein e1 is 0 and A³ is a single bond (meaning that the aromatic ring is directly bonded to the main chain of the polymer), that is, repeat units free of the linker: -C(=O)-O-A³- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein e1 is 1, that is, having the linker: - C(=O)-O-A³- are shown below, but not limited thereto. R^{A} is as defined above.

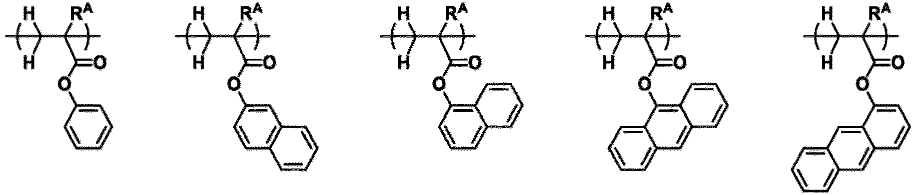

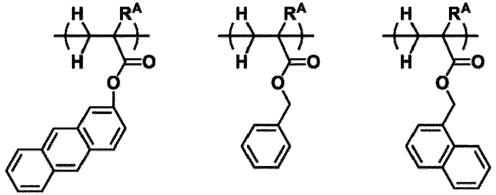

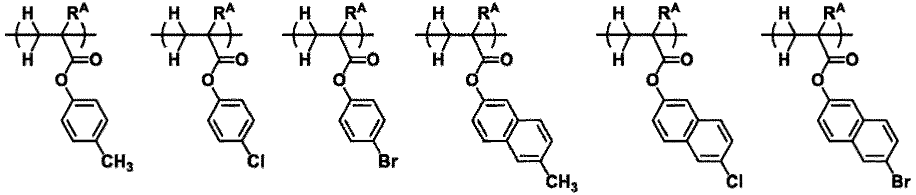

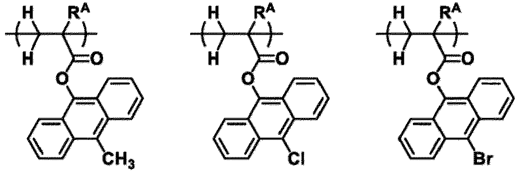

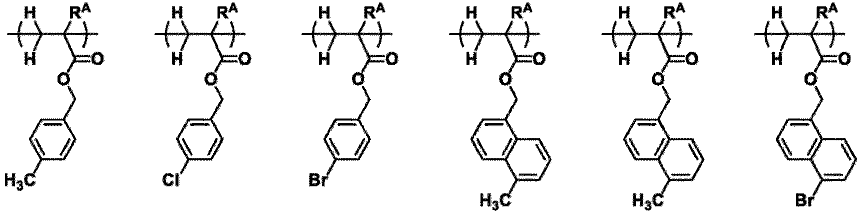

When repeat units of at least one type selected from repeat units B3 to B5 are incorporated, better performance is obtained because not only the aromatic ring possesses etch resistance, but the cyclic structure incorporated into the main chain also exerts the effect of improving etch resistance and resistance to EB irradiation during pattern inspection step.

The repeat units B3 to B5 may be used alone or in admixture of two or more.

In a preferred embodiment, the polymer B' further comprises repeat units of at least one type selected from repeat units having the formula (B6), repeat units having the formula (B7), repeat units having the formula (B8), repeat units having the formula (B9), repeat units having the formula (B10), repeat units having the formula (B11), repeat units having the formula (B12), and repeat units having the formula (B13), shown below. Notably these repeat units are also referred to as repeat units B6 to B13. The repeat units B6 to B13 are effective for suppressing acid diffusion and forming patterns with improved resolution and reduced LER.

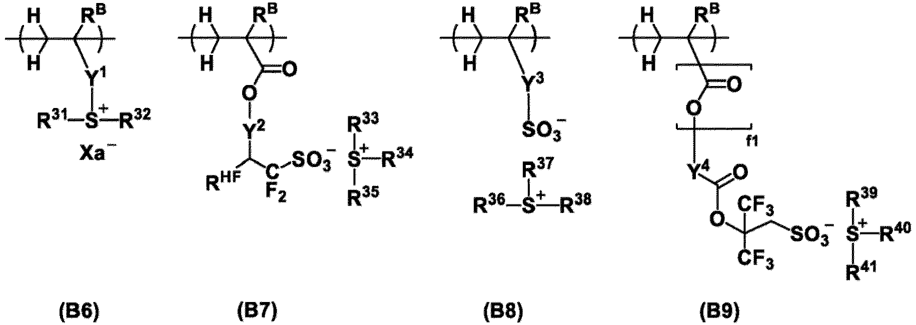

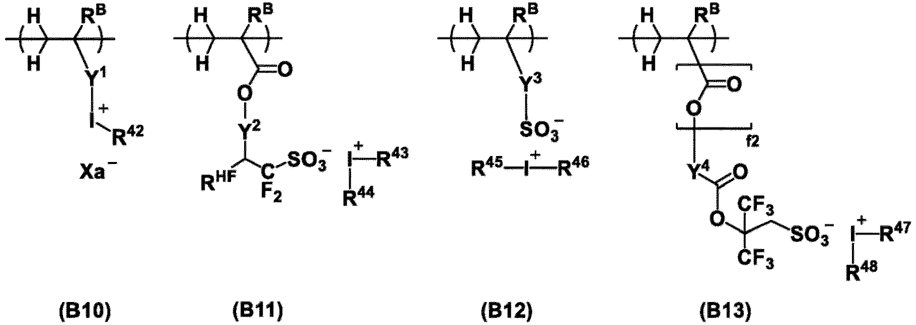

In formulae (B6) to (B13), R^{B} is each independently hydrogen or methyl. Y¹ is a single bond, a C₁-C₆ aliphatic hydrocarbylene group, phenylene group, naphthylene group, or C₇-C₁₈ group obtained by combining the foregoing, *-O-Y¹¹-, *-C(=O)-O-Y¹¹-, or *-C(=O)-NH-Y¹¹-, wherein Y¹¹ is a C₁-C₆ aliphatic hydrocarbylene group, phenylene group, naphthylene group, or C₇-C₁₈ group obtained by combining the foregoing, which may contain a carbonyl moiety, ester bond, ether bond or hydroxy moiety. Y² is a single bond or **-Y²¹-C(=O)-O-, wherein Y²¹ is a C₁-C₂₀ hydrocarbylene group which may contain a heteroatom. Y³ is a single bond, methylene, ethylene, phenylene, fluorinated phenylene, trifluoromethyl-substituted phenylene group, *-O-Y³¹-, *-C(=O)-O-Y³¹-, or *-C(=O)-NH-Y³¹-, wherein Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. The asterisk (*) is a point of attachment to the carbon atom in the backbone and the double asterisk (**) is a point of attachment to the oxygen atom in the formula. Y⁴ is a single bond or a C₁-C₃₀ hydrocarbylene group which may contain a heteroatom. The subscripts f1 and f2 are each independently 0 or 1. When Y⁴ is a single bond, f1 and f2 are 0.

In formulae (B6) and (B10), Xa⁻ is a non-nucleophilic counter ion, examples of which include those described in JP-A 2010-113209 and JP-A 2007-145797.

In formulae (B7) and (B11) wherein Y² is -Y²¹-C(=O)-O-, Y²¹ is a C₁-C₂₀ hydrocarbylene group which may contain a heteroatom, examples of which are shown below, but not limited thereto.

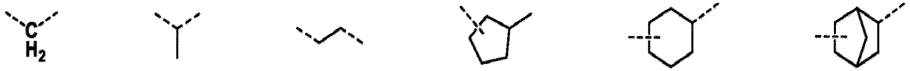

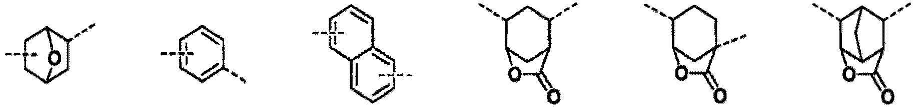

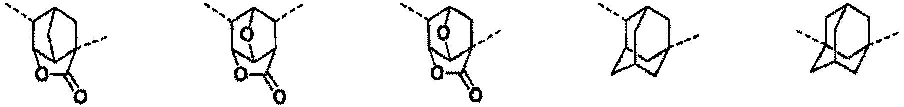

In formulae (B7) and (B11), R^{HF} is hydrogen or trifluoromethyl. Examples of the repeat units B7 and B11 wherein R^{HF} is hydrogen include those described in JP-A 2010-116550. Examples of the repeat units B7 and B11 wherein R^{HF} is trifluoromethyl include those described in JP-A 2010-077404. Examples of the repeat units B8 and B12 include those described in JP-A 2012-246265 and JP-A 2012-246426.

Preferred examples of the anion in the monomers from which repeat units B9 and B13 are derived are shown below, but not limited thereto.

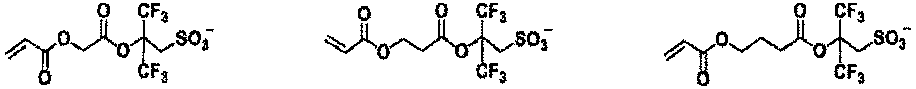

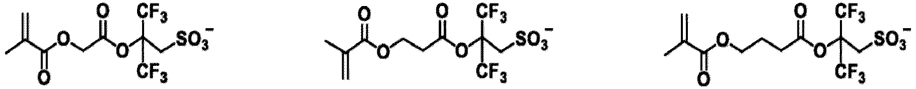

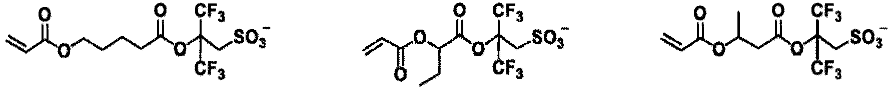

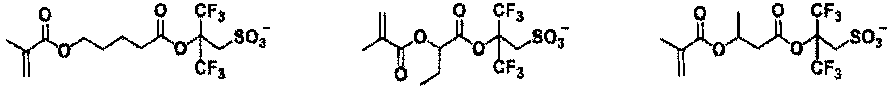

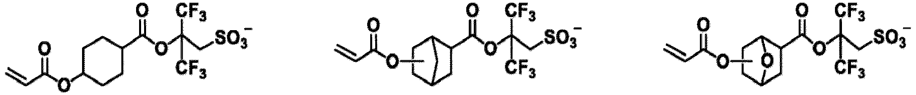

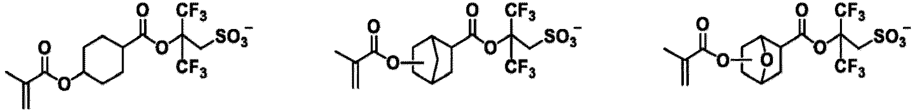

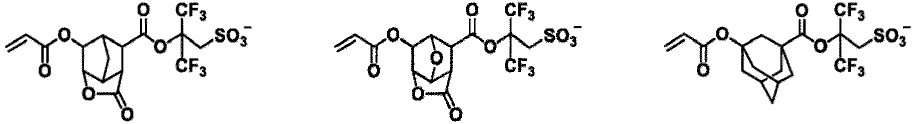

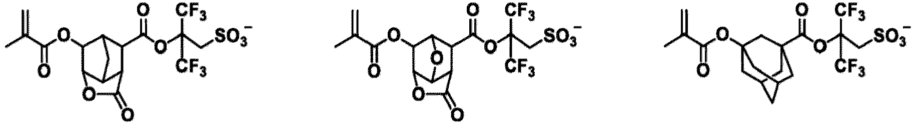

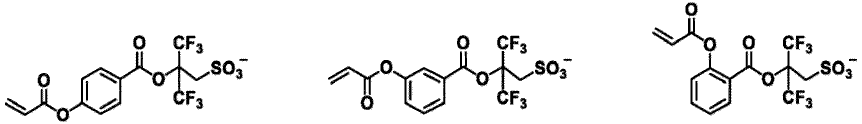

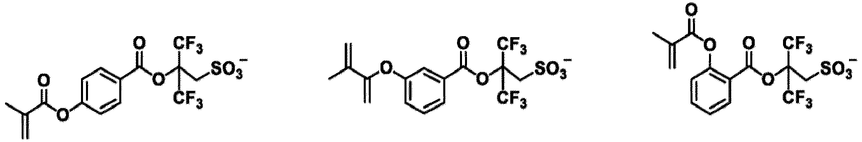

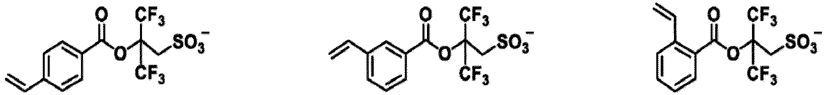

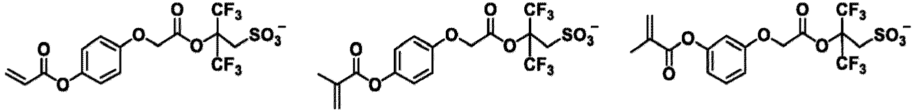

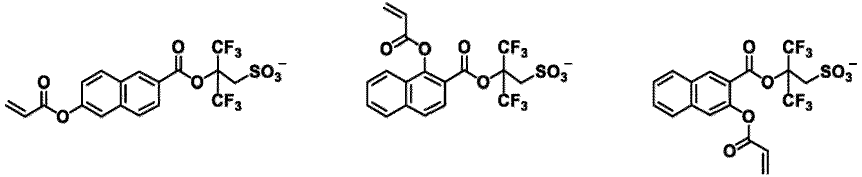

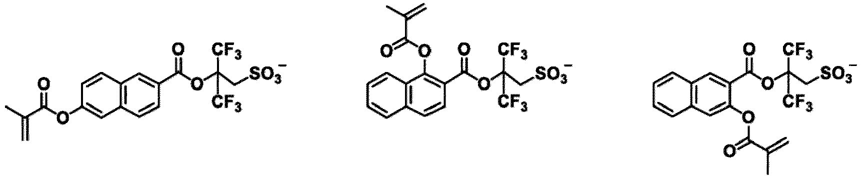

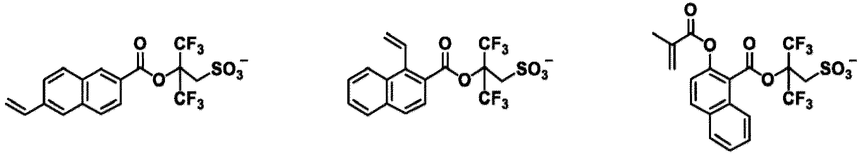

In formulae (B6) to (B13), R³¹ to R⁴⁸ are each independently halogen or a C₁-C₂₀ hydrocarbyl group which may contain a heteroatom. The hydrocarbyl group may be saturated or unsaturated and straight, branched or cyclic. Examples of the halogen and hydrocarbyl group are as exemplified above for the halogen and hydrocarbyl groups represented by R^{c1} to R^{c9} in formulae (cation-1) to (cation-3). In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonic ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. Also, R³³ and R³⁴, R³⁶ and R³⁷, or R³⁹ and R⁴⁰ may bond together to form a ring with the sulfur atom to which they are attached. Examples of the ring are as exemplified for the ring that R^{c1} and R^{c2} in formula (cation-1), taken together, form with the sulfur atom to which they are attached.

Examples of the sulfonium cation in repeat units B7 to B9 are as exemplified for the sulfonium cation having formula (cation-1). Examples of the iodonium cation in repeat units B11 to B13 are as exemplified for the iodonium cation having formula (cation-2).

The repeat units B6 to B13 are capable of generating an acid upon receipt of high-energy radiation. The binding of these units into a polymer enables appropriate control of acid diffusion and formation of a pattern with reduced LER. Since the acid-generating unit is bound to a polymer, the phenomenon that acid volatilizes from the exposed region and re-deposits on the unexposed region during bake in vacuum is suppressed. This is effective for reducing LER and for suppressing unwanted negative-turning reaction in the unexposed region for thereby reducing pattern defects.

Each of repeat units B6 to B13 may be of one type or a combination of plural types.

The polymer B or B' may further comprise (meth)acrylate or other repeat units having an adhesive group such as lactone structure or hydroxy group other than phenolic hydroxy. These repeat units are effective for fine adjustment of properties of a resist film.

Examples of the (meth)acrylate unit having an adhesive group include repeat units having the following formulae (B14) to (B16), which are also referred to as repeat units B14 to B16. While these units do not exhibit acidity, they may be used as auxiliary units for providing adhesion to substrates or adjusting solubility.

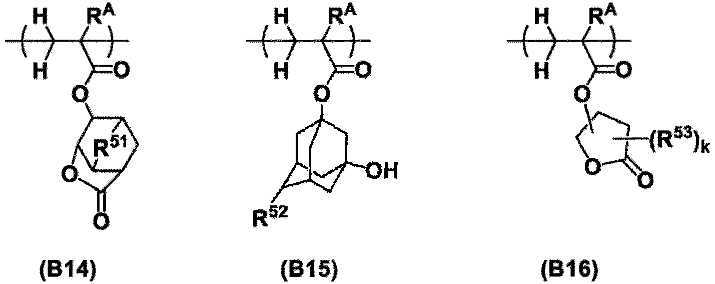

In formulae (B14) to (B16), R^{A} is each independently hydrogen, fluorine, methyl or trifluoromethyl. R⁵¹ is -O- or methylene. R⁵² is hydrogen or hydroxy. R⁵³ is a C₁-C₄ saturated hydrocarbyl group, and k is an integer of 0 to 3.

The content of repeat units B1 is preferably 30 to 95 mol%, more preferably 50 to 85 mol% of the overall repeat units of polymer B for providing a high contrast between a negative-turning region which is exposed to high-energy radiation and a non-negative-turning region which is not exposed to high-energy radiation, for achieving a high resolution. The content of repeat units B2 is preferably 5 to 70 mol%, more preferably 10 to 60 mol% based on the overall repeat units of polymer B for achieving the effect of accelerating negative-turning reaction. The content of repeat units B3 to B5 is preferably 0 to 30 mol%, more preferably 3 to 20 mol% based on the overall repeat units of polymer B for achieving the effect of enhancing etch resistance. The polymer B may contain 0 to 30 mol%, preferably 0 to 20 mol% of other repeat units.

In the embodiment wherein polymer B' does not contain repeat units B6 to B13, the content of repeat units B1 is preferably 25 to 95 mol%, more preferably 40 to 85 mol%, the content of repeat units B3 to B5 is preferably 0 to 30 mol%, more preferably 3 to 20 mol%, and the content of repeat units B5 is preferably 5 to 70 mol%, more preferably 10 to 60 mol%, based on the overall repeat units of polymer B'. Other repeat units may be incorporated in a content of 0 to 30 mol%, preferably 0 to 20 mol%.

In the other embodiment wherein polymer B' contains repeat units B6 to B13, the content of repeat units B1 is preferably 25 to 94.5 mol%, more preferably 36 to 85 mol%, the content of repeat units B3 to B5 is preferably 0 to 30 mol%, more preferably 3 to 20 mol%, the content of repeat units B5 is preferably 5 to 70 mol%, more preferably 10 to 60 mol%, the total content of repeat units B 1 to B5 is preferably 60 to 99.5 mol%, and the content of repeat units B6 to B13 is preferably 0.5 to 20 mol%, more preferably 1 to 10 mol%, based on the overall repeat units of polymer B'. Other repeat units may be incorporated in a content of 0 to 30 mol%, preferably 0 to 20 mol%.

The repeat units B1 to B5 preferably account for at least 60 mol%, more preferably at least 70 mol%, even more preferably at least 80 mol% based on the overall repeat units of the polymer. This ensures that the chemically amplified negative resist composition has satisfactory properties.

Preferably, polymer B' comprises repeat units having the formula (B1-1), repeat units having the formula (B2-1) or (B2-2), and repeat units having the formula (B7).

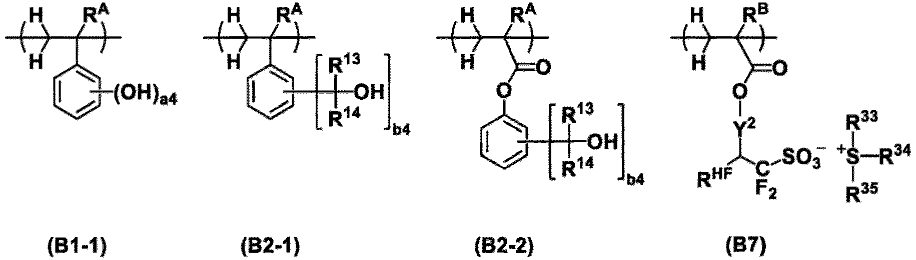

Herein, a4, b4, R^{A}, R^{B}, Y², R¹³, R¹⁴, R³³, R³⁴, R³⁵, and R^{HF} are as defined above.

In the embodiment wherein polymer B' is used as base polymer (B), it may be a mixture of a polymer containing repeat units B6 to B 13 and a polymer free of repeat units B6 to B 13. In the chemically amplified negative resist composition, the amount of the polymer free of repeat units B6 to B13 is preferably 2 to 5,000 parts by weight, more preferably 10 to 1,000 parts by weight per 100 parts by weight of the polymer containing repeat units B6 to B13.

One example wherein the chemically amplified negative resist composition is used in the fabrication of masks is now considered. The lithography of advanced generation implies a coating thickness of up to 150 nm, preferably up to 100 nm. The base polymer on which the chemically amplified negative resist composition is based should preferably have a dissolution rate in alkaline developer (typically 2.38 wt% aqueous solution of tetramethylammonium hydroxide (TMAH)) of up to 80 nm/sec, more preferably up to 50 nm/sec for forming small-size patterns because a strong development process is often employed in order to minimize defects resulting from resist residues. In an example where LSI chips are manufactured from a wafer using the chemically amplified negative resist composition in combination with the EUV lithography, the coating thickness is often up to 100 nm as viewed from the need to form a pattern with a line width of up to 50 nm. Since a thin film has a risk that the pattern can be degraded by development, the polymer should preferably have a dissolution rate of up to 80 nm/sec, more preferably up to 50 nm/sec.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to WO 2006/121096, JP-A 2008-102383, JP-A 2008-304590, and JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER increases when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Crosslinker

When the base polymer (B) does not contain polymer B', the negative resist composition preferably comprises a crosslinker as component (C). When the base polymer (B) contains polymer B', a crosslinker need not be added.

Suitable crosslinkers which can be used herein include epoxy compounds, melamine compounds, guanamine compounds, glycoluril compounds and urea compounds having substituted thereon at least one group selected from among methylol, alkoxymethyl and acyloxymethyl groups, isocyanate compounds, azide compounds, and compounds having a double bond such as an alkenyloxy group. These compounds may be used as an additive or introduced into a polymer side chain as a pendant. Hydroxy-containing compounds may also be used as the crosslinker.

Of the foregoing crosslinkers, examples of suitable epoxy compounds include tris(2,3-epoxypropyl) isocyanurate, trimethylolmethane triglycidyl ether, trimethylolpropane triglycidyl ether, and triethylolethane triglycidyl ether.

Examples of the melamine compound include hexamethylol melamine, hexamethoxymethyl melamine, hexamethylol melamine compounds having 1 to 6 methylol groups methoxymethylated and mixtures thereof, hexamethoxyethyl melamine, hexaacyloxymethyl melamine, hexamethylol melamine compounds having 1 to 6 methylol groups acyloxymethylated and mixtures thereof.

Examples of the guanamine compound include tetramethylol guanamine, tetramethoxymethyl guanamine, tetramethylol guanamine compounds having 1 to 4 methylol groups methoxymethylated and mixtures thereof, tetramethoxyethyl guanamine, tetraacyloxyguanamine, tetramethylol guanamine compounds having 1 to 4 methylol groups acyloxymethylated and mixtures thereof.

Examples of the glycoluril compound include tetramethylol glycoluril, tetramethoxyglycoluril, tetramethoxymethyl glycoluril, tetramethylol glycoluril compounds having 1 to 4 methylol groups methoxymethylated and mixtures thereof, tetramethylol glycoluril compounds having 1 to 4 methylol groups acyloxymethylated and mixtures thereof.

Examples of the urea compound include tetramethylol urea, tetramethoxymethyl urea, tetramethylol urea compounds having 1 to 4 methylol groups methoxymethylated and mixtures thereof, and tetramethoxyethyl urea.

Suitable isocyanate compounds include tolylene diisocyanate, diphenylmethane diisocyanate, hexamethylene diisocyanate and cyclohexane diisocyanate.

Suitable azide compounds include 1,1'-biphenyl-4,4'-bisazide, 4,4'-methylidenebisazide, and 4,4'-oxybisazide.

Examples of the alkenyloxy-containing compound include ethylene glycol divinyl ether, triethylene glycol divinyl ether, 1,2-propanediol divinyl ether, 1,4-butanediol divinyl ether, tetramethylene glycol divinyl ether, neopentyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, and trimethylol propane trivinyl ether.

An appropriate amount of the crosslinker (C) used is 0.1 to 50 parts, and more preferably 1 to 30 parts by weight per 80 parts by weight of the base polymer (B). As long as the amount of the crosslinker is in the range, the risk of resolution being reduced by forming bridges between pattern features is mitigated. The crosslinkers may be used alone or in admixture.

### (D) Fluorinated polymer

The negative resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from redepositing onto the substrate during the development step and is thus effective for preventing development defects.

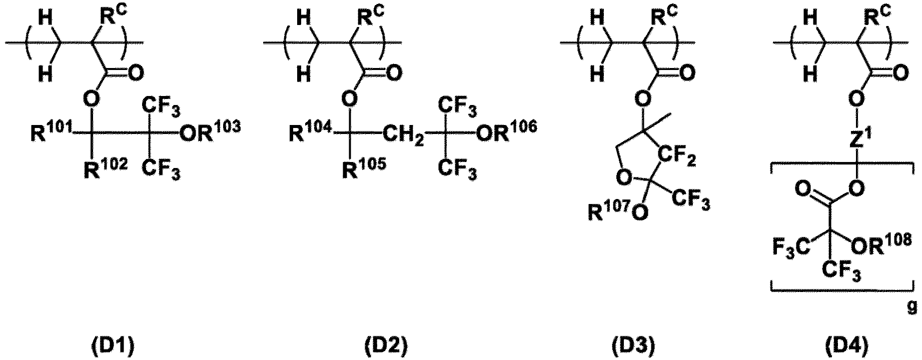

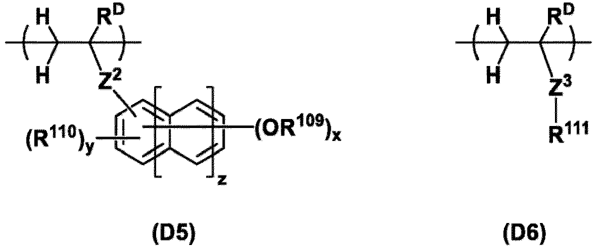

In formulae (D1) to (D6), x is an integer of 1 to 3, y is an integer satisfying: 0 ≤ y < 5+2z-x, z is 0 or 1, and g is an integer of 1 to 3. R^{C} is each independently hydrogen, fluorine, methyl or trifluoromethyl. R^{D} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. Z¹ is a C₁-C₂₀ (g+1)-valent hydrocarbon group or C₁-C₂₀ (g+1)-valent fluorinated hydrocarbon group. Z² is a single bond, *-C(=O)-O- or *-C(=O)-NH- wherein the asterisk (*) designates a point of attachment to the carbon atom in the backbone. Z³ is a single bond, -O-, *-C(=O)-O-Z³¹-Z³²- or *-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and the asterisk (*) designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), examples of the C₁-C₁₅ hydrocarbyl group represented by R¹⁰³, R¹⁰⁶, R¹⁰⁷ and R¹⁰⁸ include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (g+1)-valent hydrocarbon group Z¹ include the foregoing C₁-C₂₀ alkyl groups and C₃-C₂₀ cyclic saturated hydrocarbyl groups, with g number of hydrogen atoms being eliminated. Examples of the C₁-C₂₀ (g+1)-valent fluorinated hydrocarbon group Z¹ include the foregoing (g+1)-valent hydrocarbon groups in which at least one hydrogen atom is substituted by fluorine.

Examples of the repeat units D1 to D4 are given below, but not limited thereto. Herein R^{C} is as defined above.

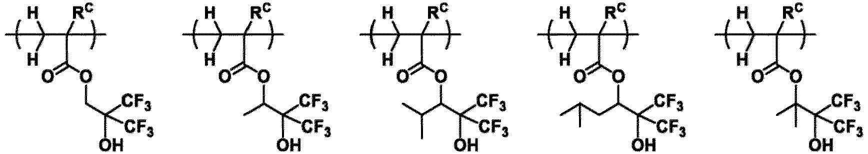

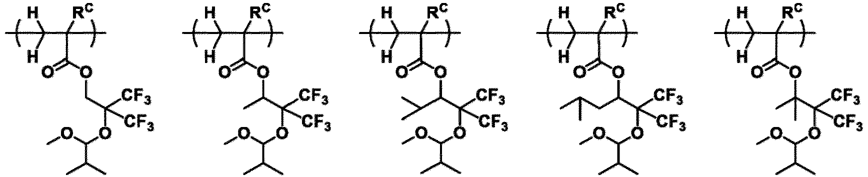

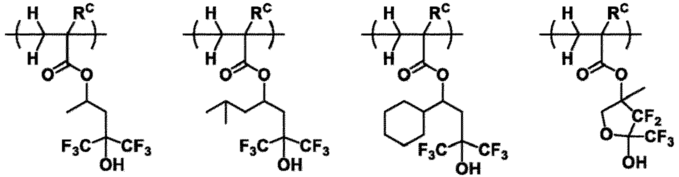

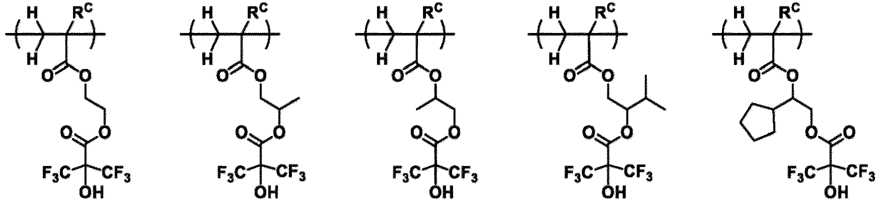

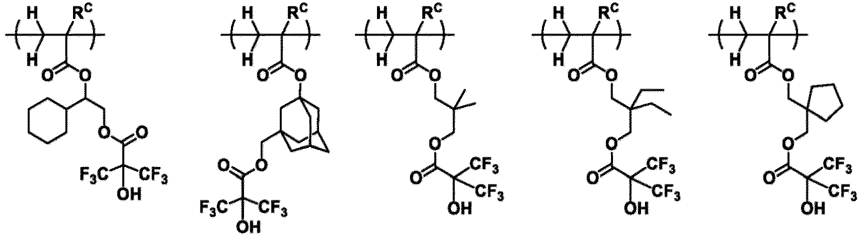

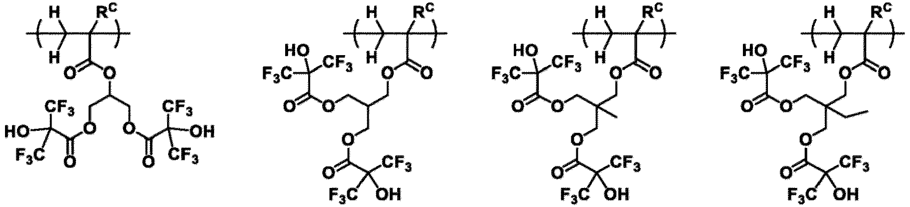

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{D} is methyl. The inclusion of carbonyl in Z² enhances the ability to trap the acid originating from the anti-charging film. A polymer wherein R^{D} is methyl is a robust polymer having a high Tg which is effective for suppressing acid diffusion. As a result, the resist film is improved in stability with time, and neither resolution nor pattern profile is degraded.

Examples of the repeat unit D5 are given below, but not limited thereto. Herein R^{D} is as defined above.

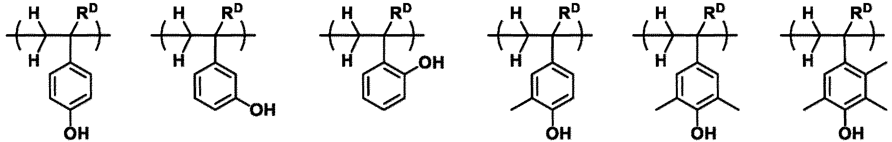

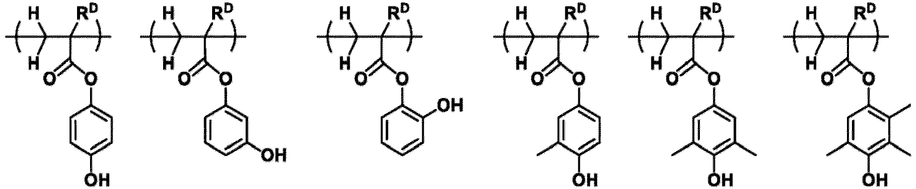

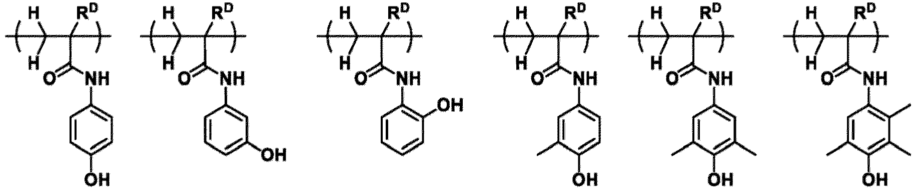

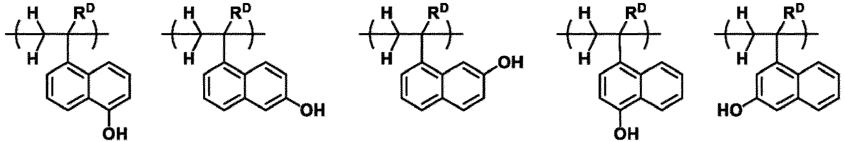

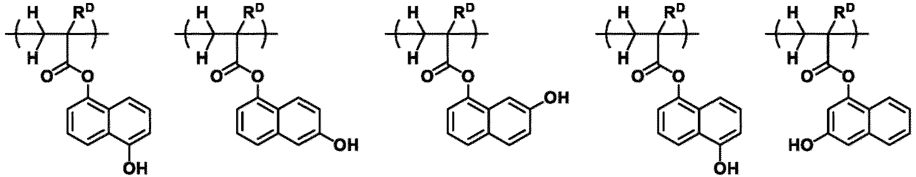

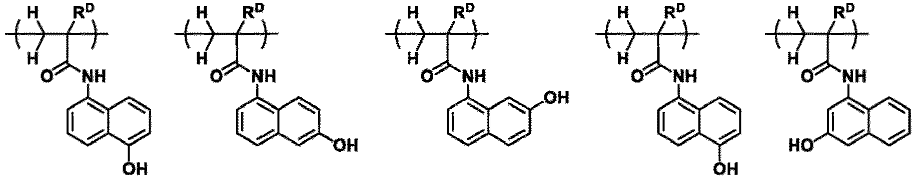

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{D} is as defined above.

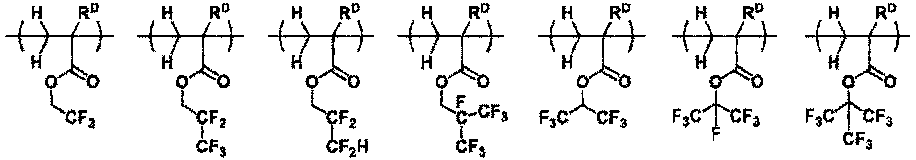

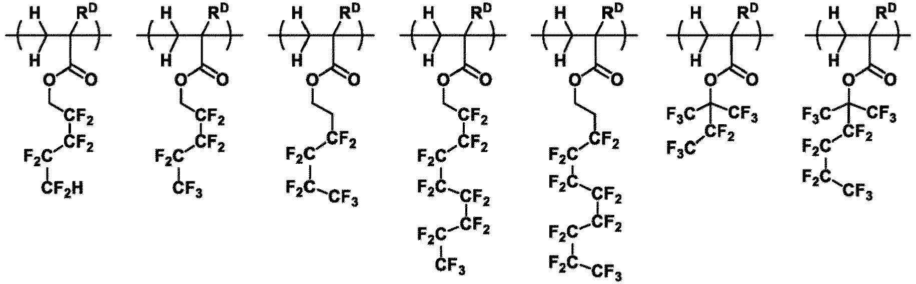

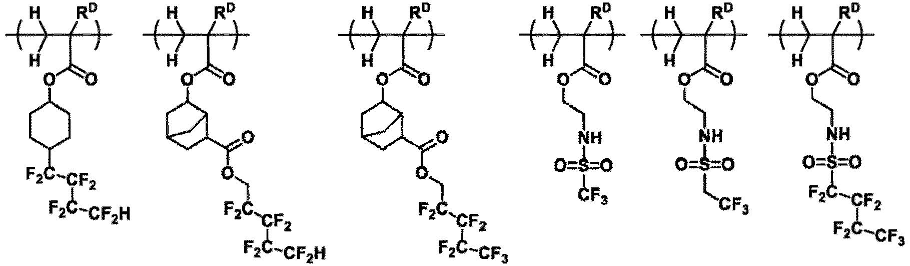

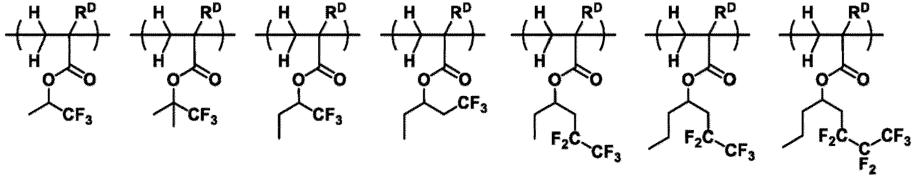

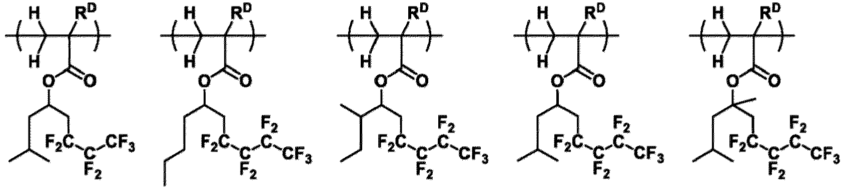

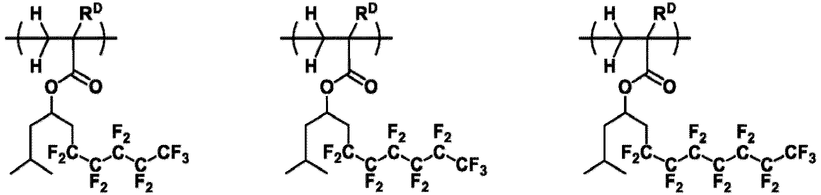

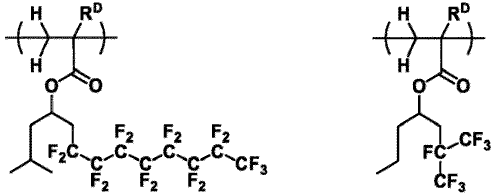

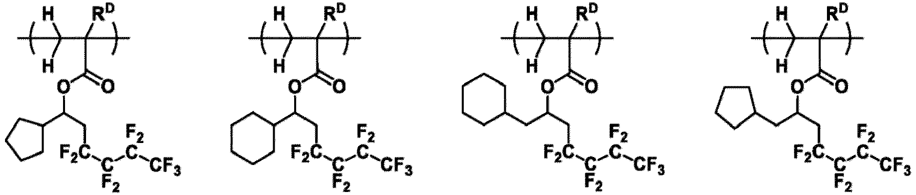

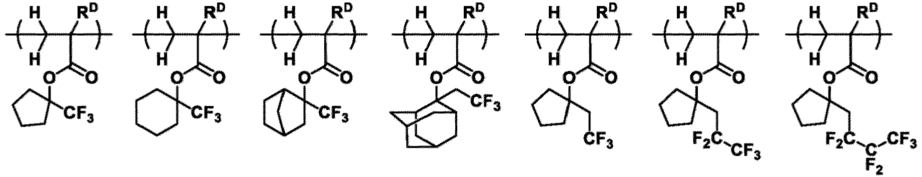

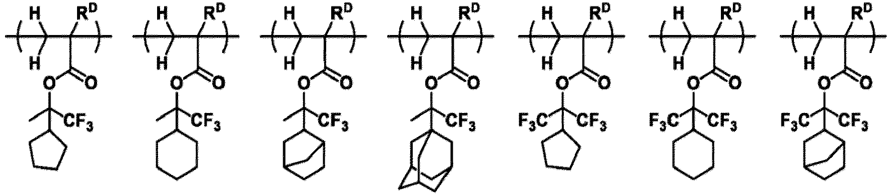

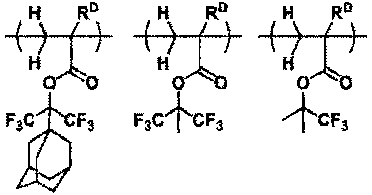

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the negative resist composition, the fluorinated polymer (D) is preferably used in an amount of 0.01 to 30 parts, more preferably 0.1 to 20 parts, even more preferably 0.5 to 10 parts by weight per 80 parts by weight of the base polymer (B). The fluorinated polymer may be used alone or in admixture.

### (E) Acid generator

The negative resist composition may further comprise an acid generator as component (E). The acid generator used herein may be any compound (PAG) capable of generating an acid in response to actinic ray or radiation. The PAG used herein is not particularly limited as long as it can generate an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to promote the reaction of crosslinker (C) with base polymer (B).

In order that the effect of improving LER is exerted by combining the PAG with the quencher (A), the PAG preferably generates an acid having a pKa value of -3.0 or larger, more preferably in the range of -3.0 to 2.0, even more preferably in the range of -2.0 to 1.5.

A salt compound having an anion of the structure shown below is preferred as the PAG.

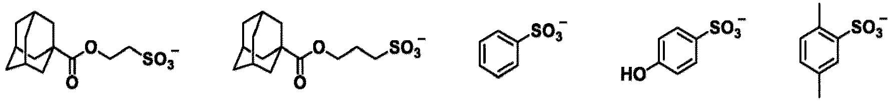

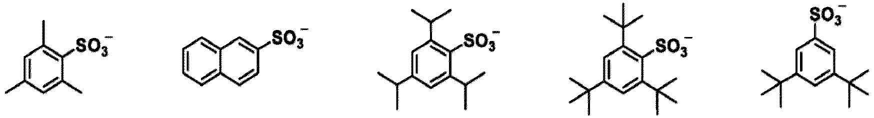

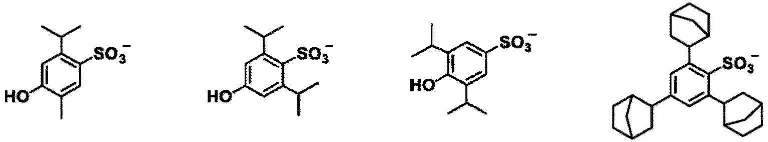

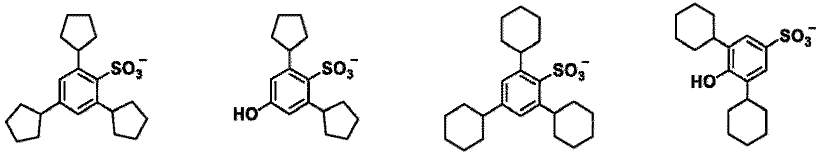

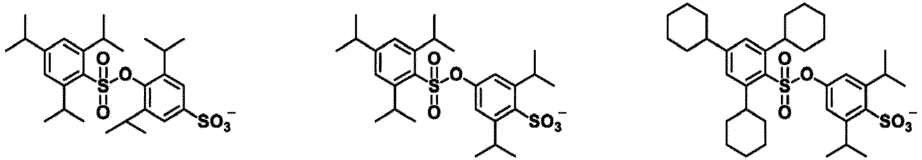

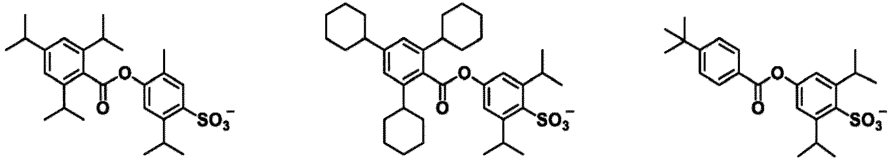

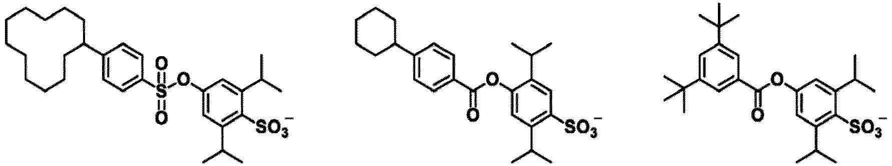

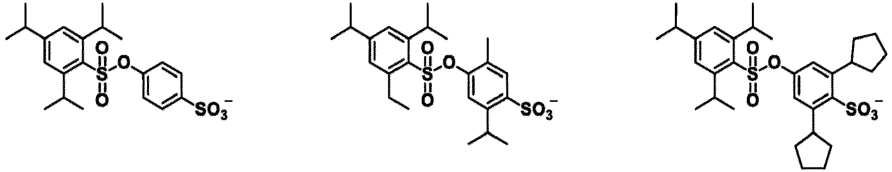

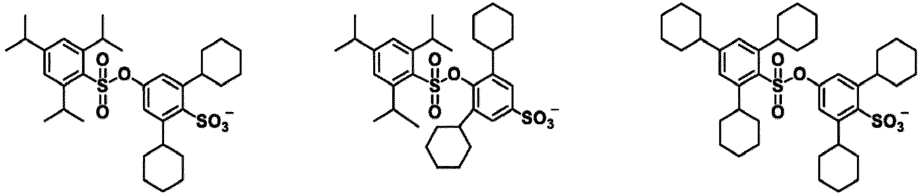

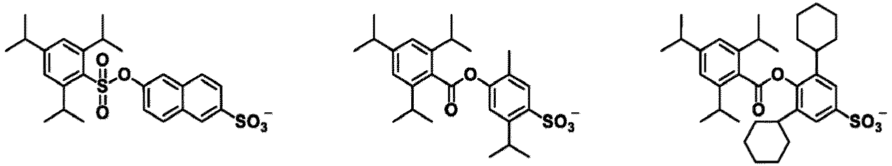

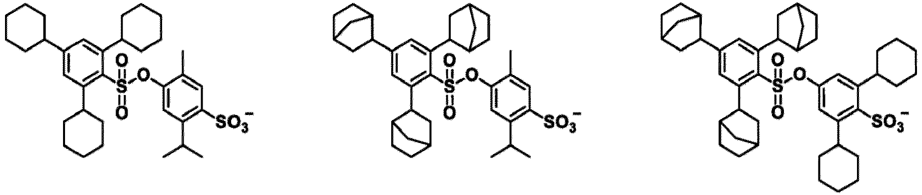

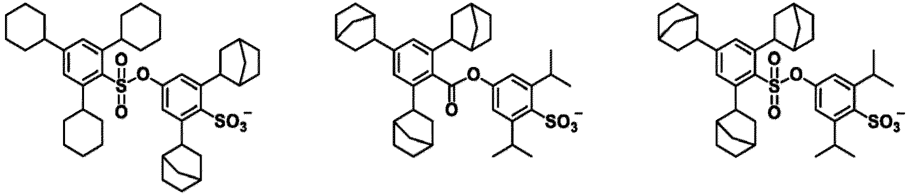

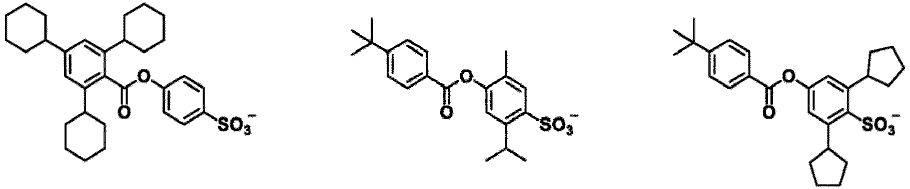

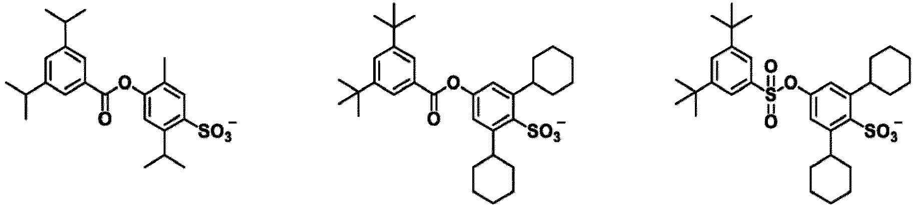

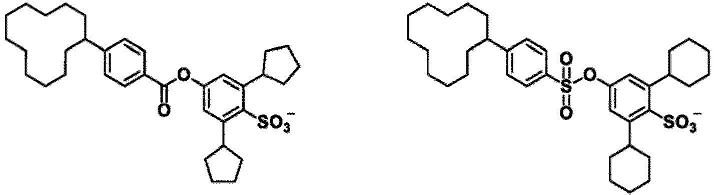

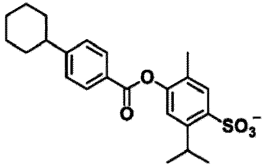

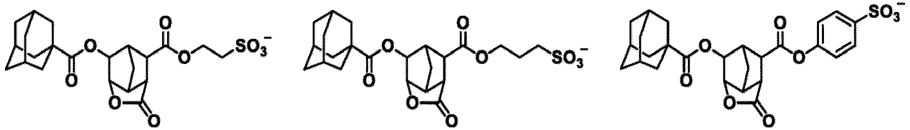

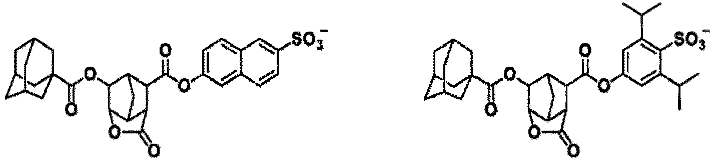

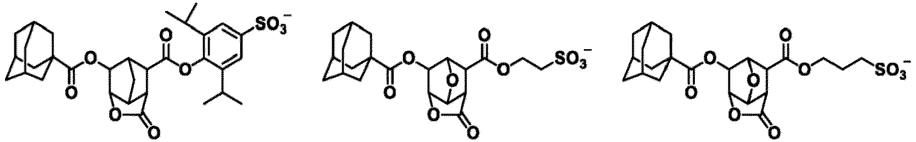

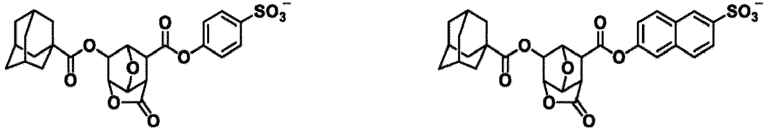

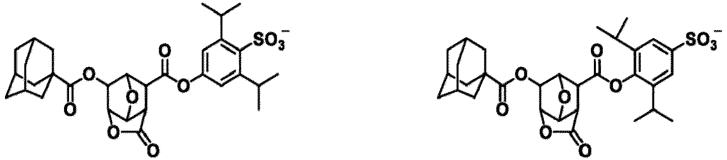

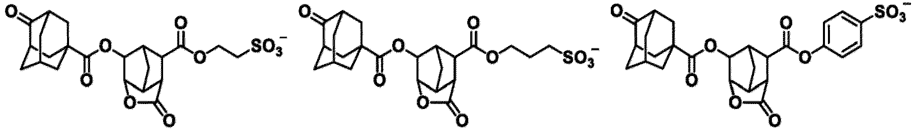

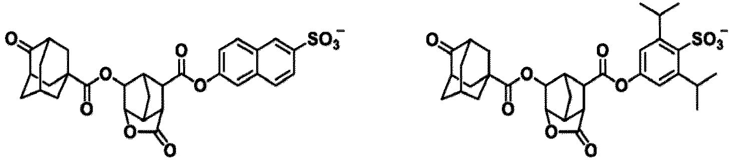

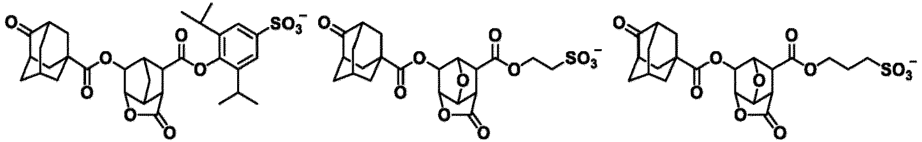

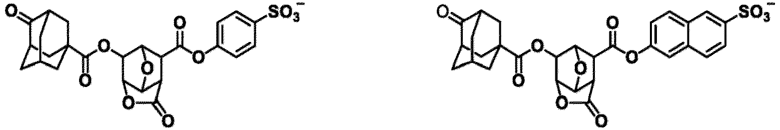

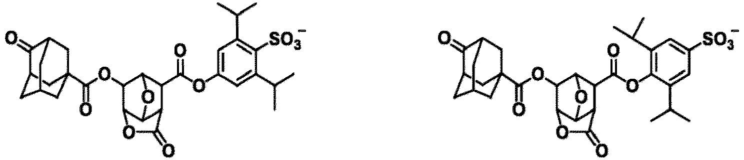

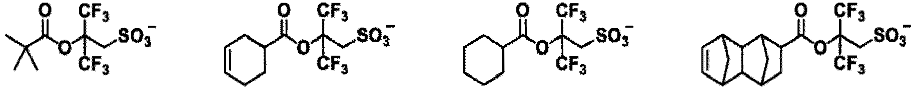

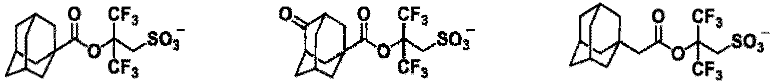

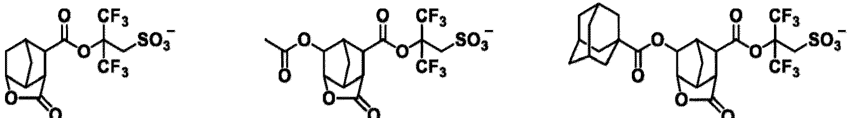

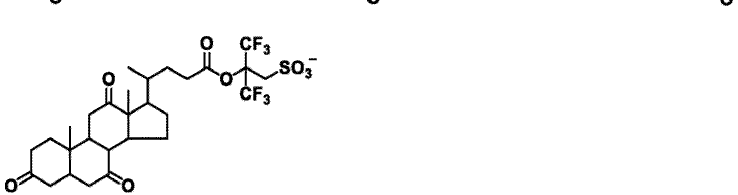

Examples of the pairing cation include the above-illustrated examples of the sulfonium cation having formula (cation-1) and the above-illustrated examples of the iodonium cation having formula (cation-2).

When the resist composition contains the acid generator (E), an appropriate amount of the acid generator used is 1 to 30 parts, more preferably 2 to 20 parts by weight per 80 parts by weight of the base polymer. In the embodiment wherein the base polymer contains repeat units B6 to B13, that is, in the case of polymer-bound acid generator, the addition of acid generator (E) may be omitted. The acid generator may be used alone or in admixture.

In the embodiment wherein the chemically amplified negative resist composition contains the quencher (A) and the acid generator (E), the acid generator (E) and the quencher (A) are preferably present in a weight ratio (E/A) of less than 6/1, more preferably less than 5/1, even more preferably less than 4/1. As long as the ratio of acid generator (E) to quencher (A) is in the range, it is possible to fully suppress acid diffusion, leading to improved resolution and dimensional uniformity.

### (F) Organic solvent

The chemically amplified negative resist composition may further comprise an organic solvent as component (F). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof.

Of the above organic solvents, it is recommended to use 1-ethoxy-2-propanol, PGMEA, PGME, cyclohexanone, EL, GBL, and mixtures thereof.

In the negative resist composition, the organic solvent (F) is preferably used in an amount of 200 to 10,000 parts, more preferably 400 to 6,000 parts by weight per 80 parts by weight of the base polymer (B). The organic solvent may be used alone or in admixture.

### (G) Basic compound

In the negative resist composition, (G) a basic compound may be added as the quencher other than component (A) for the purpose of correcting a pattern profile or the like. The basic compound is effective for controlling acid diffusion. Even when the resist film is applied to a substrate having an outermost surface layer made of a chromium-containing material, the basic compound is effective for minimizing the influence of the acid generated in the resist film on the chromium-containing material.

Numerous basic compounds are known useful including primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, carbamate derivatives, and ammonium salts. Examples are described in Patent Document 9, for example, and any such compounds are useful. Of the foregoing basic compounds, preferred are tris[2-(methoxymethoxy)ethyl]amine, tris[2-(methoxymethoxy)ethyl]amine-N-oxide, dibutylaminobenzoic acid, morpholine derivatives and imidazole derivatives.

In the negative resist composition, the basic compound (G) is preferably added in an amount of 0 to 20 parts, and more preferably 0 to 10 parts by weight per 80 parts by weight of the base polymer (B). The basic compounds may be used alone or in admixture.

### (H) Surfactant

The negative resist composition may contain any conventional surfactants for facilitating to coat the composition to the substrate. Exemplary surfactants include PF-636 (Omnova Solutions Inc.) and FC-4430 (3M) as well as a number of known surfactants as described in JP-A 2004-115630. Any suitable one may be chosen therefrom. The amount of the surfactant (H) added is preferably 0 to 5 parts by weight per 80 parts by weight of the base polymer (B). The surfactant may be used alone or in admixture.

### Process

Another embodiment of the invention is a resist pattern forming process comprising the steps of applying the negative resist composition defined above onto a substrate to form a resist film thereon, exposing the resist film patternwise to high-energy radiation, and developing the resist film in an alkaline developer to form a resist pattern.

Pattern formation using the negative resist composition of the invention may be performed by well-known lithography processes. In general, the resist composition is first applied onto a substrate for IC fabrication (e.g., Si, SiO, SiO₂, SiN, SiON, TiN, WSi, BPSG, SOG, organic antireflective coating, etc.) or a substrate for mask circuit fabrication (e.g., Cr, CrO, CrON, MoSi₂, Si, SiO, SiO₂, SiON, SiONC, CoTa, NiTa, TaBN, SnO₂, etc.) by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray or synchrotron radiation or EB. The resist composition of the invention is especially effective in the KrF excimer laser, EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm².

The exposure may be performed by conventional lithography whereas the immersion lithography of holding a liquid, typically water between the mask and the resist film may be employed if desired. In the case of immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the negative resist composition, a pattern with a high resolution and minimal LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum, molybdenum, cobalt, nickel, tungsten or tin compound. The substrate to which the negative resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a very high resolution, reduced LER, fidelity, and dose margin even on a substrate (typically mask blank of transmission or reflection type) whose outermost surface is made of a material tending to affect resist pattern profile such as a chromium or silicon-containing material.

### EXAMPLES

Examples of the invention are given below by way of illustration and not by way of limitation. The abbreviation "pbw" is parts by weight.

Polymers P-1 to P-30 used in resist compositions had the structure shown in Table 1. Mw is determined by GPC versus polystyrene standards using THF or DMF solvent.

**Table 1**

| | Unit 1 | Incorporation ratio (mol%) | Unit 2 | Incorporation ratio (mol%) | Unit 3 | Incorporation ratio (mol%) | Unit 4 | Incorporation ratio (mol%) | Unit 5 | Incorporation ratio (mol%) | Mw | Mw/Mn |
|---|---|---|---|---|---|---|---|---|---|---|---|---|
| P-1 | A-1 | 80.0 | B-1 | 10.0 | B-5 | 10.0 | - | - | - | - | 4,500 | 1.65 |
| P-2 | A-1 | 80.0 | B-2 | 8.0 | B-4 | 12.0 | - | - | - | - | 4,400 | 1.64 |
| P-3 | A-1 | 60.0 | B-2 | 10.0 | C-1 | 30.0 | - | - | - | - | 3,700 | 1.62 |
| P-4 | A-1 | 70.0 | B-2 | 7.0 | C-2 | 23.0 | - | - | - | - | 3,600 | 1.63 |
| P-5 | A-1 | 70.0 | B-2 | 10.0 | C-3 | 20.0 | - | - | - | - | 3,900 | 1.65 |
| P-6 | A-1 | 30.0 | B-2 | 10.0 | C-4 | 60.0 | - | - | - | - | 3,900 | 1.62 |
| P-7 | A-1 | 45.0 | B-2 | 10.0 | C-5 | 45.0 | - | - | - | - | 4,100 | 1.63 |
| P-8 | A-1 | 55.0 | B-4 | 10.0 | C-1 | 35.0 | - | - | - | - | 4,000 | 1.63 |
| P-9 | A-1 | 66.0 | B-2 | 9.0 | C-1 | 21.5 | E-1 | 3.5 | - | - | 13,000 | 1.62 |
| P-10 | A-1 | 60.0 | B-2 | 4.0 | C-1 | 24.0 | E-1 | 12.0 | - | - | 15,000 | 1.65 |
| P-11 | A-1 | 67.0 | B-2 | 10.0 | C-1 | 18.5 | E-2 | 4.5 | - | - | 14,000 | 1.63 |
| P-12 | A-1 | 67.0 | B-2 | 9.3 | C-1 | 20.0 | E-3 | 3.7 | - | - | 13,500 | 1.63 |
| P-13 | A-1 | 67.3 | B-2 | 10.0 | C-1 | 17.5 | E-4 | 5.2 | - | - | 13,200 | 1.64 |
| P-14 | A-1 | 64.1 | B-2 | 9.5 | C-1 | 22.0 | E-5 | 4.4 | - | - | 12,800 | 1.62 |
| P-15 | A-1 | 64.0 | B-2 | 10.0 | C-1 | 22.8 | E-6 | 3.2 | - | - | 13,500 | 1.63 |
| P-16 | A-1 | 62.0 | B-3 | 10.0 | C-1 | 24.3 | E-1 | 3.7 | - | - | 12,400 | 1.66 |
| P-17 | A-2 | 60.5 | B-4 | 10.0 | C-1 | 24.4 | E-2 | 5.1 | - | - | 12,300 | 1.65 |
| P-18 | A-1 | 70.0 | C-1 | 30.0 | - | - | - | - | - | - | 4,200 | 1.69 |
| P-19 | A-1 | 80.0 | B-2 | 5.0 | C-1 | 15.0 | - | - | - | - | 4,300 | 1.67 |
| P-20 | A-1 | 80.0 | B-2 | 2.5 | C-1 | 15.0 | E-1 | 2.5 | - | - | 12,100 | 1.69 |
| P-21 | A-2 | 50.0 | C-1 | 30.0 | D-1 | 20.0 | - | - | - | - | 4,600 | 1.67 |
| P-22 | A-2 | 50.0 | B-2 | 2.5 | C-1 | 30.0 | D-1 | 15.0 | E-1 | 2.5 | 12,700 | 1.73 |
| P-23 | A-2 | 50.0 | C-1 | 30.0 | D-2 | 20.0 | - | - | - | - | 5,400 | 1.72 |
| P-24 | A-2 | 50.0 | C-1 | 30.0 | D-3 | 20.0 | - | - | - | - | 6,100 | 1.73 |
| P-25 | A-2 | 50.0 | C-1 | 30.0 | D-4 | 20.0 | - | - | - | - | 7,000 | 1.76 |
| P-26 | A-1 | 67.5 | B-2 | 2.5 | C-1 | 30.0 | - | - | - | - | 4,100 | 1.65 |
| P-27 | A-1 | 57.5 | B-2 | 2.5 | C-1 | 30.0 | E-5 | 10 | - | - | 11,000 | 1.65 |
| P-28 | A-1 | 65.0 | C-1 | 25.0 | E -7 | 10.0 | - | - | - | - | 13,000 | 1.80 |
| P-29 | A-1 | 65.0 | C-1 | 25.0 | E -8 | 10.0 | - | - | - | - | 12,500 | 1.80 |
| P-30 | A-3 | 76.0 | B-2 | 6.0 | C-1 | 18.0 | - | - | - | - | 4,500 | 1.68 |

Each of the units in Table 1 is shown below.

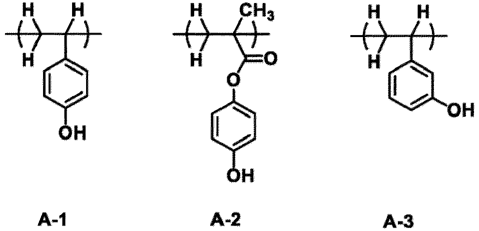

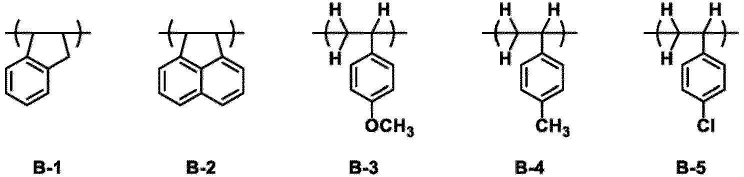

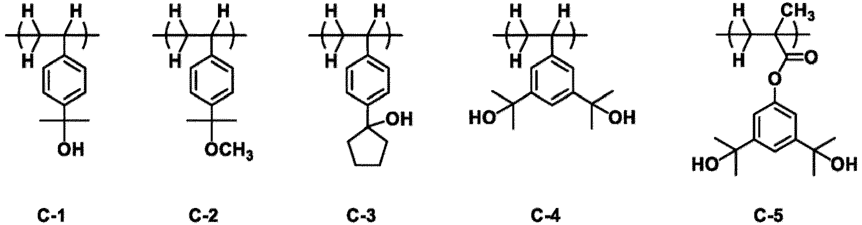

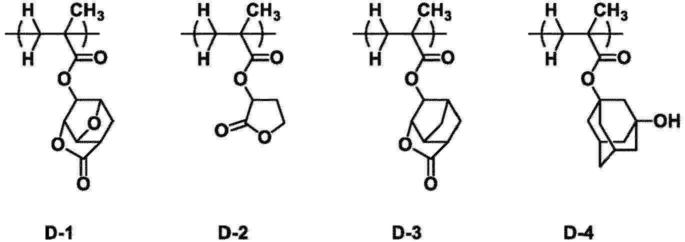

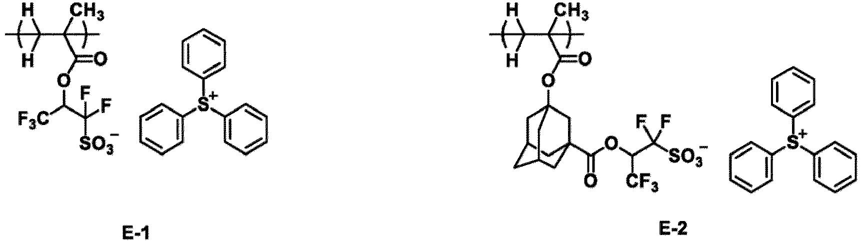

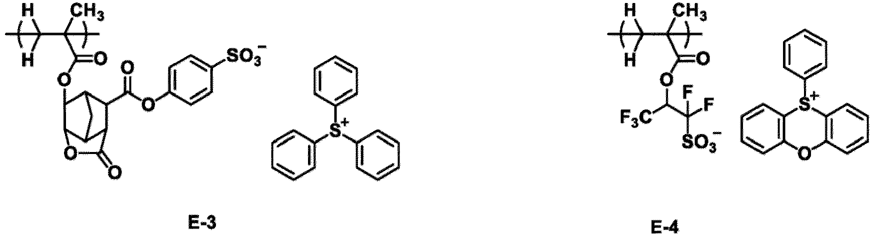

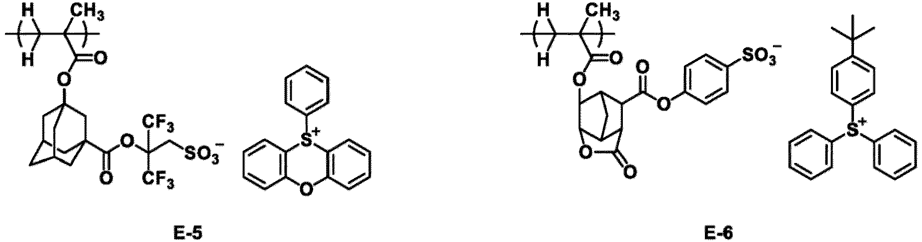

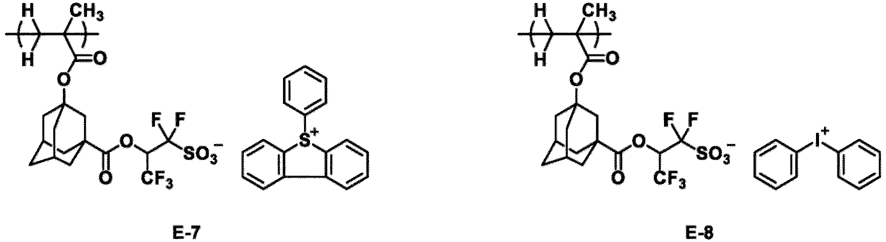

### [1] Preparation of chemically amplified negative resist compositions

### Examples 1-1 to 1-52 and Comparative Examples 1-1 to 1-4

Chemically amplified negative resist compositions (R-1 to R-52, CR-1 to CR-4) were prepared by dissolving selected components in an organic solvent in accordance with the formulation shown in Tables 2 to 4, and filtering the solution through a UPE filter and/or nylon filter with a pore size of 10 nm, 5 nm, 3 nm or 1 nm. The organic solvent was a mixture of 790 pbw of PGMEA, 1,580 pbw of EL, and 1,580 pbw of PGME. To some resist compositions, a fluorinated polymer (polymer FP-1 to FP-5) as an additive, tetramethoxymethyl glycoluril (TMGU) as a crosslinker, and PF-636 (Omnova Solutions) as a surfactant were added.

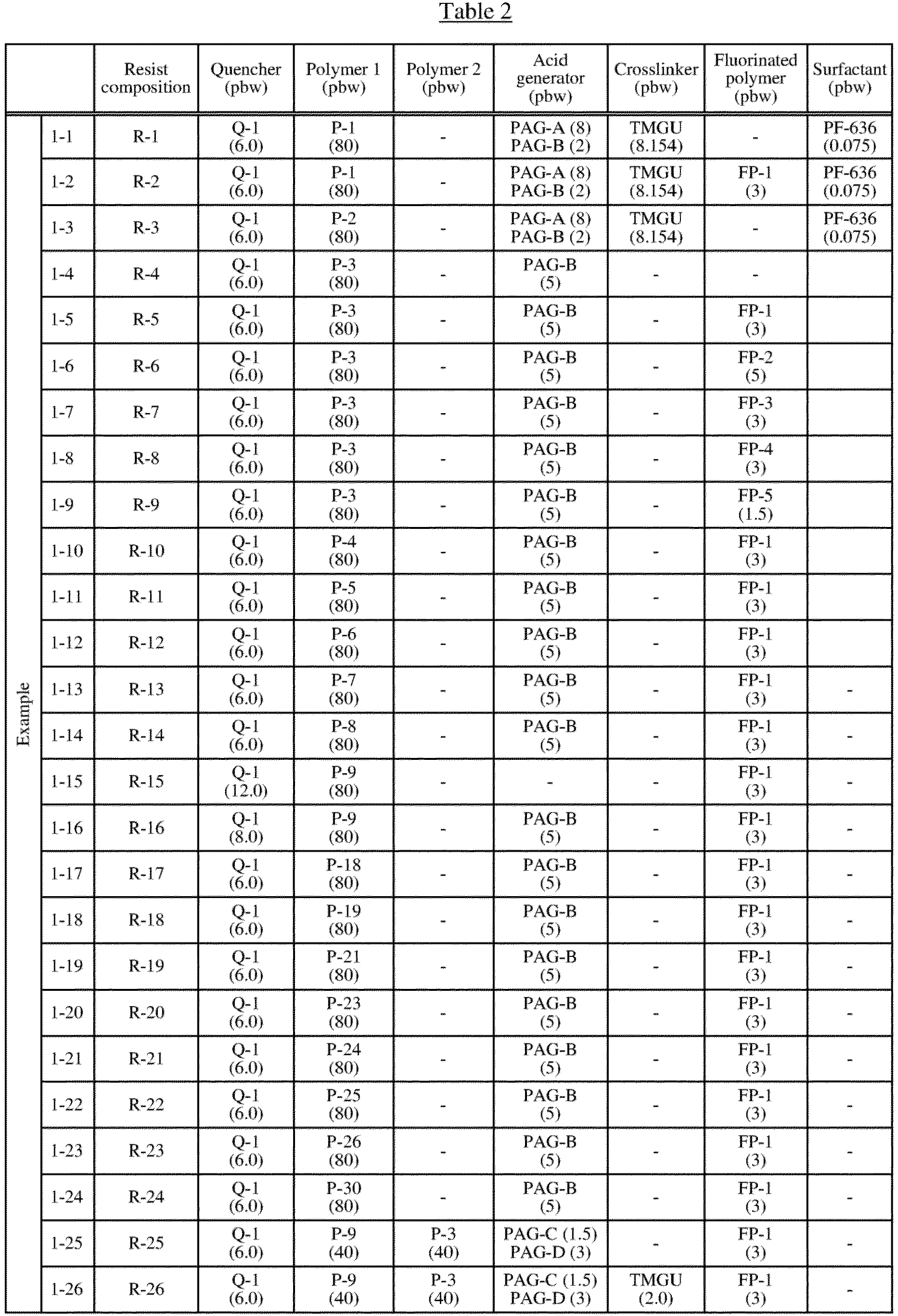

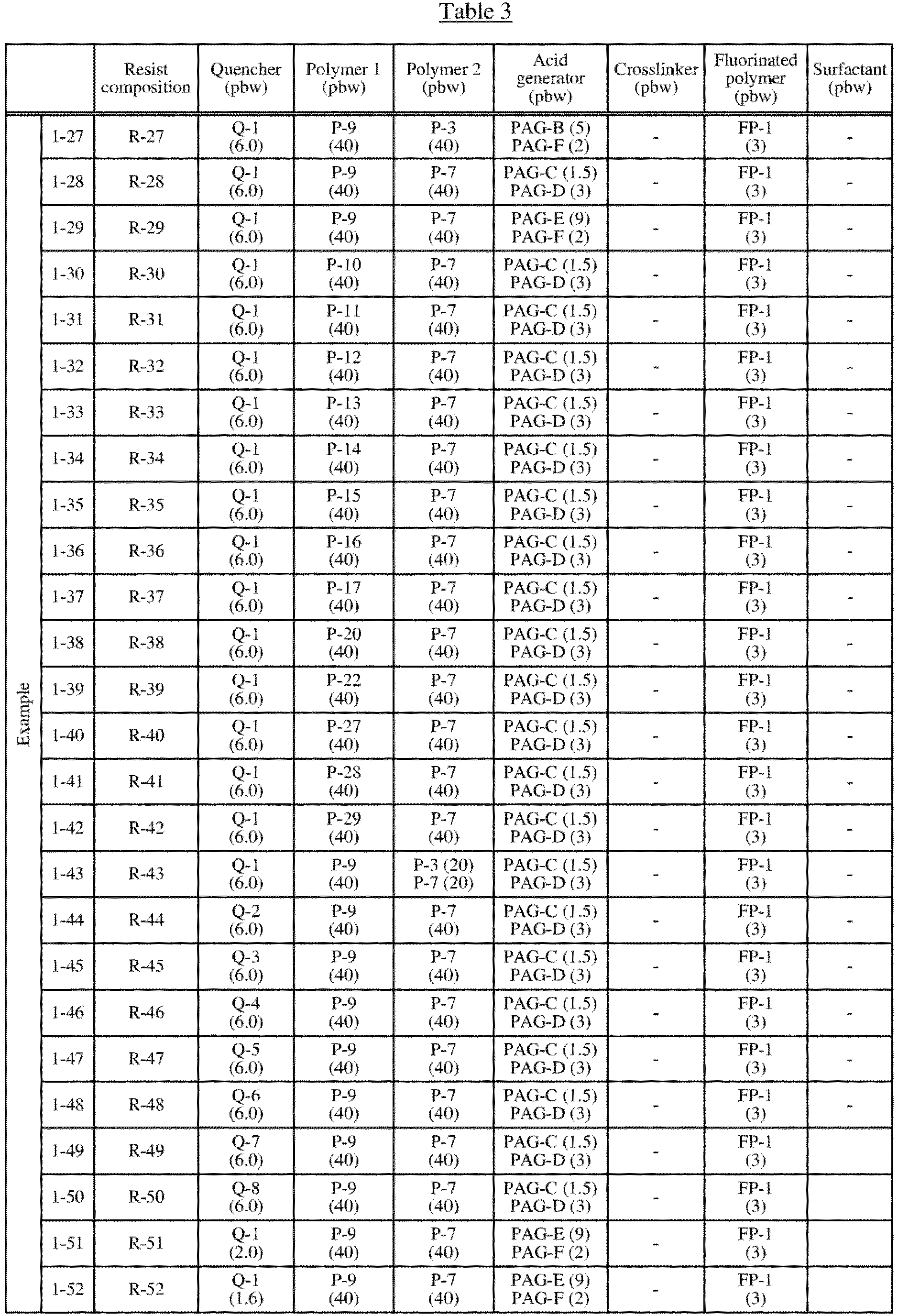

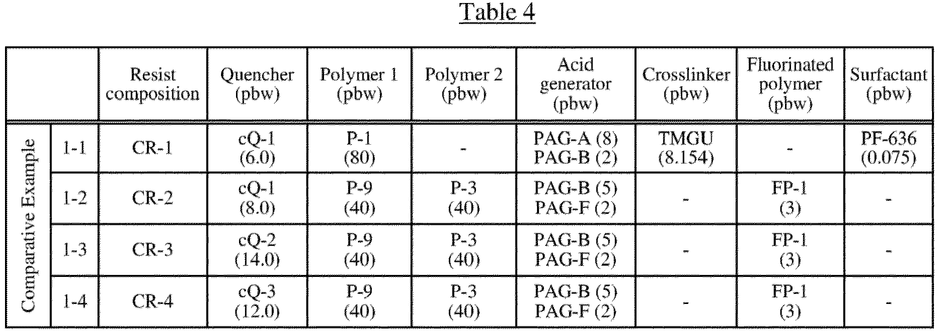

In Tables 2 to 4, quenchers Q-1 to Q-8, comparative quenchers cQ-1 to cQ-3, photoacid generators PAG-A to PAG-F, and fluorinated polymers FP-1 to FP-5 are identified below.

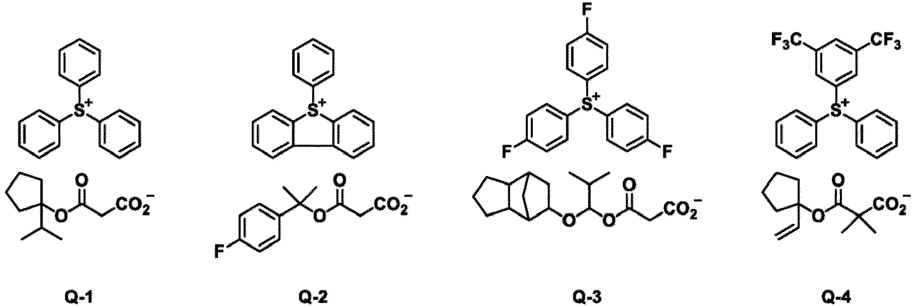

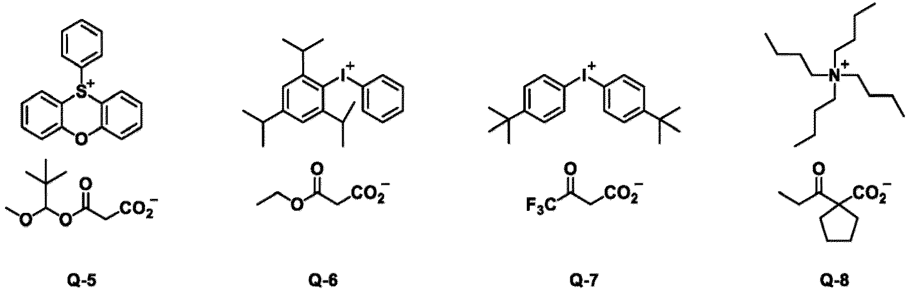

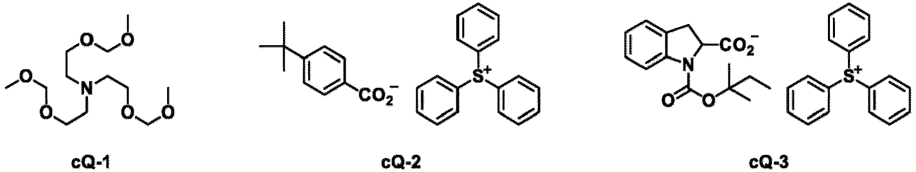

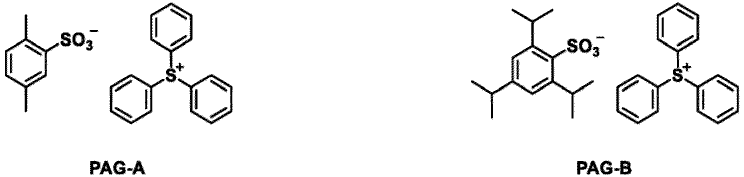

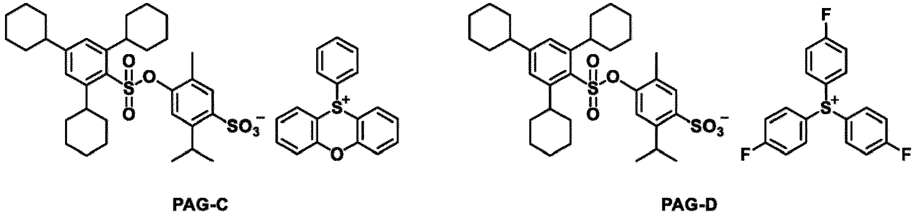

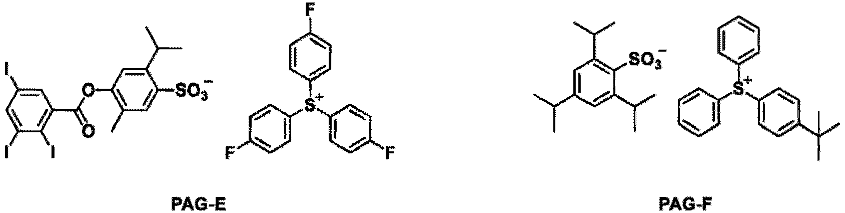

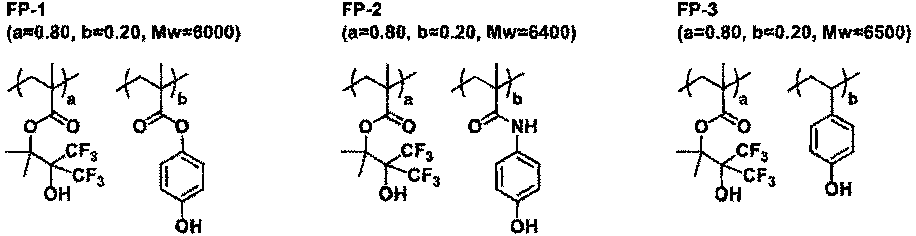

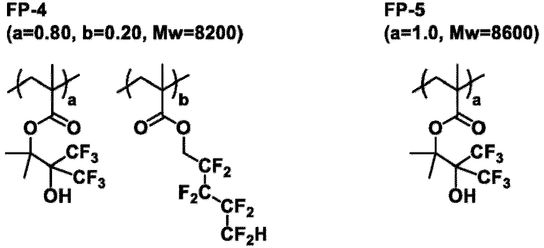

### [2] EB lithography test

### Examples 2-1 to 2-52 and Comparative Examples 2-1 to 2-4

Using a coater/developer system ACT-M (Tokyo Electron Ltd.), each of the negative resist compositions (R-1 to R-52 and CR-1 to CR-4) was spin coated onto a mask blank of 152 mm squares having the outermost surface in the form of a silicon oxide film, which had been vapor primed with hexamethyldisilazane (HMDS), and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 120°C for 600 seconds, and developed in a 2.38 wt% TMAH aqueous solution, thereby yielding a negative pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose. The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). A change of CD per µC relative to the exposure dose providing 1:1 resolution was determined from the dose curve. The results are shown in Tables 5 to 7.

**Table 5**

| | | Resist composition | Eop (µC/cm²) | Maximum resolution (nm) | LER (nm) | CD change (nm) |
|---|---|---|---|---|---|---|
| Example | 2-1 | R-1 | 110 | 36 | 4.3 | 0.6 |
| | 2-2 | R-2 | 110 | 40 | 4.5 | 0.6 |
| | 2-3 | R-3 | 110 | 38 | 4.2 | 0.6 |
| | 2-4 | R-4 | 120 | 40 | 4.4 | 0.6 |
| | 2-5 | R-5 | 110 | 38 | 4.6 | 0.6 |
| | 2-6 | R-6 | 130 | 40 | 4.6 | 0.6 |
| | 2-7 | R-7 | 110 | 40 | 4.5 | 0.6 |
| | 2-8 | R-8 | 120 | 38 | 4.3 | 0.6 |
| | 2-9 | R-9 | 110 | 40 | 4.6 | 0.6 |
| | 2-10 | R-10 | 100 | 40 | 4.3 | 0.6 |
| | 2-11 | R-11 | 110 | 40 | 4.4 | 0.6 |
| | 2-12 | R-12 | 120 | 40 | 4.5 | 0.6 |
| | 2-13 | R-13 | 110 | 40 | 4.4 | 0.6 |
| | 2-14 | R-14 | 130 | 40 | 4.6 | 0.6 |
| | 2-15 | R-15 | 110 | 38 | 4.5 | 0.6 |
| | 2-16 | R-16 | 110 | 40 | 4.6 | 0.6 |
| | 2-17 | R-17 | 140 | 40 | 4.5 | 0.6 |
| | 2-18 | R-18 | 110 | 40 | 4.4 | 0.6 |
| | 2-19 | R-19 | 110 | 38 | 4.3 | 0.6 |
| | 2-20 | R-20 | 130 | 40 | 4.5 | 0.6 |
| | 2-21 | R-21 | 110 | 40 | 4.6 | 0.6 |
| | 2-22 | R-22 | 120 | 40 | 4.5 | 0.6 |
| | 2-23 | R-23 | 110 | 38 | 4.6 | 0.6 |
| | 2-24 | R-24 | 100 | 40 | 4.7 | 0.6 |
| | 2-25 | R-25 | 110 | 40 | 4.4 | 0.6 |
| | 2-26 | R-26 | 130 | 40 | 4.3 | 0.6 |

**Table 6**

| | | Resist composition | Eop (µC/cm²) | Maximum resolution (nm) | LER (nm) | CD change (nm) |
|---|---|---|---|---|---|---|
| Example | 2-27 | R-27 | 110 | 38 | 4.4 | 0.6 |
| | 2-28 | R-28 | 120 | 40 | 4.5 | 0.6 |
| | 2-29 | R-29 | 110 | 40 | 4.5 | 0.6 |
| | 2-30 | R-30 | 110 | 40 | 4.4 | 0.6 |
| | 2-31 | R-31 | 120 | 38 | 4.6 | 0.6 |
| | 2-32 | R-32 | 110 | 40 | 4.3 | 0.6 |
| | 2-33 | R-33 | 120 | 40 | 4.4 | 0.6 |
| | 2-34 | R-34 | 130 | 40 | 4.5 | 0.6 |
| | 2-35 | R-35 | 110 | 40 | 4.5 | 0.6 |
| | 2-36 | R-36 | 140 | 38 | 4.5 | 0.6 |
| | 2-37 | R-37 | 110 | 40 | 4.6 | 0.6 |
| | 2-38 | R-38 | 130 | 38 | 4.4 | 0.6 |
| | 2-39 | R-39 | 110 | 40 | 4.6 | 0.6 |
| | 2-40 | R-40 | 130 | 40 | 4.4 | 0.6 |
| | 2-41 | R-41 | 120 | 42 | 4.5 | 0.6 |
| | 2-42 | R-42 | 110 | 38 | 4.4 | 0.6 |
| | 2-43 | R-43 | 130 | 42 | 4.6 | 0.6 |
| | 2-44 | R-44 | 110 | 38 | 4.4 | 0.6 |
| | 2-45 | R-45 | 140 | 40 | 4.5 | 0.6 |
| | 2-46 | R-46 | 110 | 42 | 4.4 | 0.6 |
| | 2-47 | R-47 | 130 | 38 | 4.3 | 0.6 |
| | 2-48 | R-48 | 120 | 40 | 4.4 | 0.6 |
| | 2-49 | R-49 | 130 | 42 | 4.5 | 0.6 |
| | 2-50 | R-50 | 110 | 38 | 4.6 | 0.6 |
| | 2-51 | R-51 | 60 | 44 | 4.7 | 0.6 |
| | 2-52 | R-52 | 40 | 46 | 5.0 | 0.8 |

**Table 7**

| | | Resist composition | Eop (µC/cm²) | Maximum resolution (nm) | LER (nm) | CD change (nm) |
|---|---|---|---|---|---|---|
| Comparative Example | 2-1 | CR-1 | 120 | 60 | 5.8 | 1.2 |
| | 2-2 | CR-2 | 110 | 54 | 5.2 | 1.2 |
| | 2-3 | CR-3 | 120 | 52 | 5.3 | 1.2 |
| | 2-4 | CR-4 | 120 | 52 | 5.6 | 1.2 |

All the chemically amplified negative resist compositions (R-1 to R-52) within the scope of the invention show satisfactory resolution and acceptable values of LER and dose margin because the onium salt having formula (A1) exerts an acid diffusion-suppressing effect, as compared with the comparative resist compositions (CR-1 to CR-8). A comparison of R-51 with R-52 reveals that the benefits of the invention are obtained when the optimum dose is 50 µC or more.

Using the chemically amplified negative resist composition within the scope of the invention, a resist pattern having a very high resolution, reduced LER and improved dose margin can be formed. The resist pattern forming process using the negative resist composition is useful in photolithography for the fabrication of semiconductor devices and the processing of photomask blanks of transmission or reflection type.

## Claims

1. A chemically amplified negative resist composition comprising (A) a quencher in the form of an onium salt having the formula (A1) and (B) a base polymer containing a polymer comprising repeat units having the formula (B1), 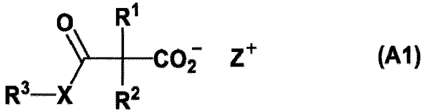 wherein X is a single bond, -O- or -S-,
R¹ and R² are each independently hydrogen or a C₁-C₁₀ hydrocarbyl group in which some constituent -CH₂- may be replaced by -O- or -C(=O)-, R¹ and R² may bond together to form a ring with the carbon atom to which they are attached,
R³ is hydrogen or a C₁-C₁₀ hydrocarbyl group when X is a single bond or -S-, and hydrogen, a C₁-C₁₀ hydrocarbyl group other than an acid labile group, or an acid labile group when X is -O-, some or all of the hydrogen atoms in the hydrocarbyl group may be substituted by halogen, some constituent -CH₂- in the hydrocarbyl group may be replaced by -O- or - C(=O)-, R¹ and R³ may bond together to form a ring with the atoms to which they are attached and intervenient atoms, with the proviso that the number of carbon atoms in R¹ to R³ is up to 10 when R³ is other than the acid labile group, and
Z⁺ is an onium cation, 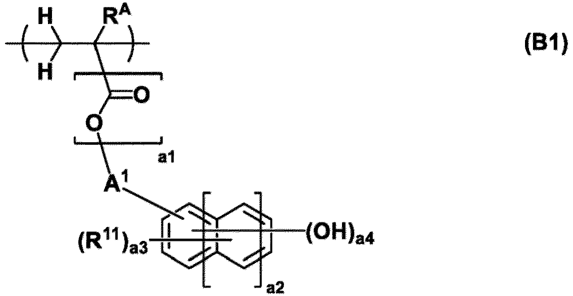
wherein a1 is 0 or 1, a2 is an integer of 0 to 2, a3 is an integer satisfying 0 ≤ a3 ≤ 5+2(a2)-a4, a4 is an integer of 1 to 3,
R^{A} is hydrogen, fluorine, methyl or trifluoromethyl,
R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
A¹ is a single bond or C₁-C₁₀ saturated hydrocarbylene group in which some constituent - CH₂- may be replaced by -O-.

2. The negative resist composition of claim 1 wherein X is -O-.

3. The negative resist composition of claim 2 wherein R³ is an acid labile group having the formula (AL-1) or (AL-2): 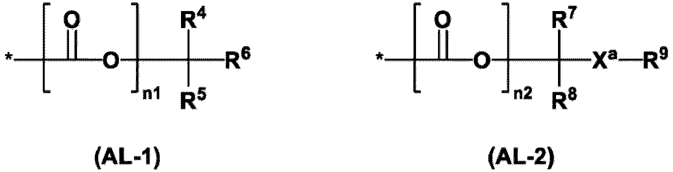 wherein X^{a} is -O- or -S-,
R⁴, R⁵ and R⁶ are each independently a C₁-C₁₂ hydrocarbyl group in which some constituent -CH₂- may be replaced by -O- or -S-, and when the hydrocarbyl group contains an aromatic ring, some or all of the hydrogen atoms in the aromatic ring may be substituted by halogen, cyano, nitro, optionally halogenated C₁-C₄ alkyl group or optionally halogenated C₁-C₄ alkoxy group, any two of R⁴, R⁵ and R⁶ may bond together to form a ring, some constituent - CH₂- in the ring may be replaced by -O- or -S-,
R⁷ and R⁸ are each independently hydrogen or a C₁-C₁₀ hydrocarbyl group, R⁹ is a C₁-C₂₀ hydrocarbyl group, some constituent -CH₂- in the hydrocarbyl group may be replaced by -O- or - S-, R⁸ and R⁹ may bond together to form a C₃-C₂₀ heterocyclic group with the carbon atom and X^{a} to which they are attached, some constituent -CH₂- in the heterocyclic group may be replaced by -O- or -S-,
n1 and n2 are each independently 0 or 1,
* designates a point of attachment to the adjacent -O-.

4. The negative resist composition of any one of claims 1 to 3 wherein Z⁺ is an onium cation having the formula (cation-1), (cation-2) or (cation-3): 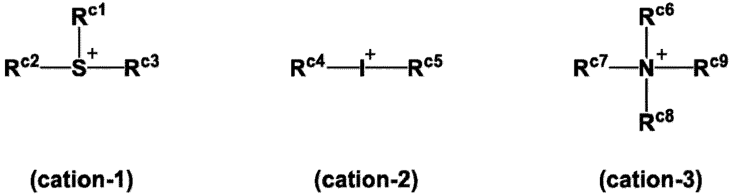 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.

5. The negative resist composition of any one of claims 1 to 4 wherein the polymer further comprises repeat units having the formula (B2): 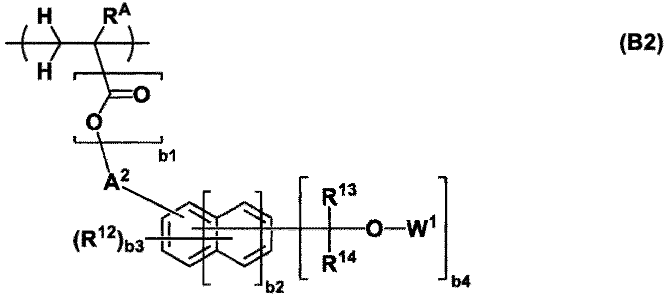 wherein b1 is 0 or 1, b2 is an integer of 0 to 2, b3 is an integer satisfying 0 ≤ b3 ≤ 5+2(b2)-b4, b4 is an integer of 1 to 3,
R^{A} is hydrogen, fluorine, methyl or trifluoromethyl,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently hydrogen, a C₁-C₁₅ saturated hydrocarbyl group which may be substituted with a hydroxy or saturated hydrocarbyloxy moiety, or an optionally substituted aryl group, R¹³ and R¹⁴ are not hydrogen at the same time, R¹³ and R¹⁴ may bond together to form a ring with the carbon atom to which they are attached,
A² is a single bond or C₁-C₁₀ saturated hydrocarbylene group in which any constituent - CH₂- may be replaced by -O-,
W¹ is hydrogen, a C₁-C₁₀ aliphatic hydrocarbyl group or an optionally substituted aryl group.

6. The negative resist composition of any one of claims 1 to 5 wherein the polymer further comprises repeat units of at least one type selected from repeat units having the formula (B3), repeat units having the formula (B4), and repeat units having the formula (B5): 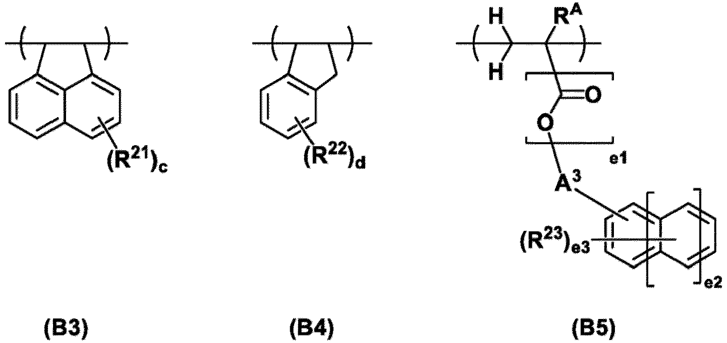 wherein c and d are each independently an integer of 0 to 4, e1 is 0 or 1, e2 is an integer of 0 to 5, and e3 is an integer of 0 to 2,
R^{A} is hydrogen, fluorine, methyl or trifluoromethyl,
R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group, cyano group, C₁-C₂₀ saturated hydrocarbylsulfinyl group, or C₁-C₂₀ saturated hydrocarbylsulfonyl group, and
A⁴ is a single bond or C₁-C₁₀ saturated hydrocarbylene group in which any constituent - CH₂- may be replaced by -O-.

7. The negative resist composition of claim 5 wherein the polymer further comprises repeat units of at least one type selected from repeat units having the formulae (B6) to (B13): 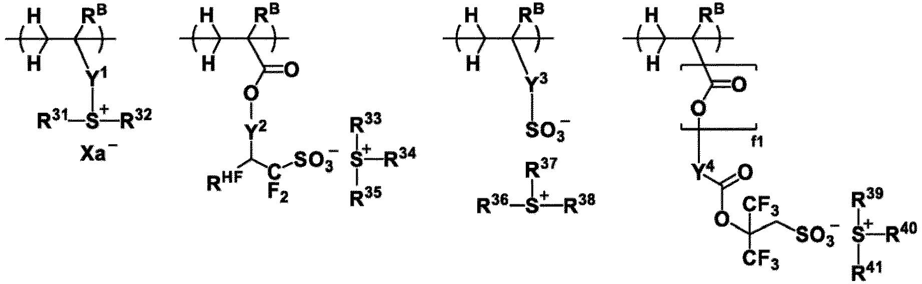 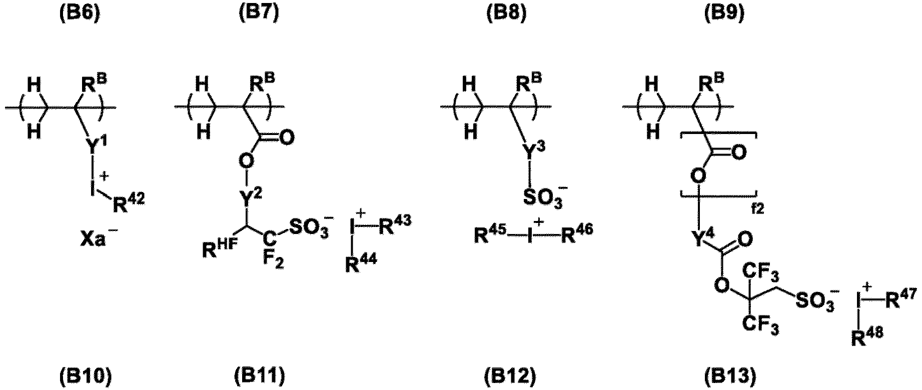 wherein R^{B} is each independently hydrogen or methyl,
Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or **-Y²¹-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
Y⁴ is a single bond or C₁-C₃₀ hydrocarbylene group which may contain a heteroatom,
f1 and f2 are each independently 0 or 1, f1 and f2 are 0 when Y⁴ is a single bond,
R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

8. The negative resist composition of claim 7wherein the base polymer (B) further contains a polymer comprising repeat units having formula (B1) and repeat units having formula (B2), but not repeat units having formulae (B6) to (B13).

9. The negative resist composition of any one of claims 1 to 8, further comprising (C) a crosslinker.

10. The negative resist composition of claim 5 which is free of a crosslinker.

11. The negative resist composition of any one of claims 1 to 10, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 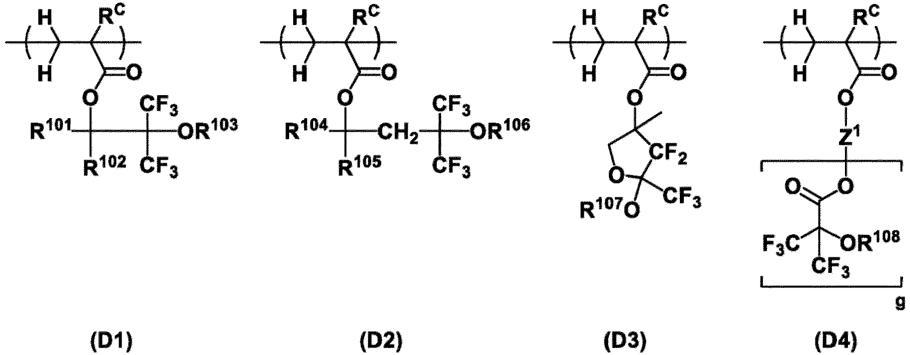 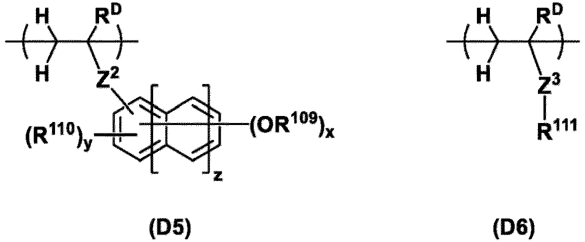 wherein x is an integer of 1 to 3, y is an integer satisfying 0 ≤ y ≤ 5+2z-x, z is 0 or 1, g is an integer of 1 to 3,
R^{C} is each independently hydrogen, fluorine, methyl or trifluoromethyl,
R^{D} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
Z¹ is a C₁-C₂₀ (h+1)-valent hydrocarbon group or C₁-C₂₀ (h+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

12. The negative resist composition of any one of claims 1 to 11, further comprising (E) an acid generator.

13. The negative resist composition of any one of claims 1 to 12, further comprising (E) an organic solvent.

14. A resist pattern forming process comprising the steps of:
applying the chemically amplified negative resist composition of any one of claims 1 to 13. onto a substrate to form a resist film thereon,
exposing the resist film patternwise to high-energy radiation, and
developing the exposed resist film in an alkaline developer.

15. A mask blank of transmission or reflection type which is coated with the chemically amplified negative resist composition of any one of claims 1 to 13.
